(19) Europäisches Patentamt
European Patent Office
Office européen des brevets

(11) EP 3 348 562 B1

(12) EUROPEAN PATENT SPECIFICATION

(45) Date of publication and mention of the grant of the patent:
**23.12.2020 Bulletin 2020/52**

(51) Int Cl.:
***C07F 15/00*** (2006.01) ***C09K 11/06*** (2006.01)
***H01L 51/50*** (2006.01) ***H05B 33/14*** (2006.01)

(21) Application number: **18151036.3**

(22) Date of filing: **10.01.2018**

(54) **ORGANOMETALLIC COMPOUND, COMPOSITION CONTAINING THE ORGANOMETALLIC COMPOUND, AND ORGANIC LIGHT-EMITTING DEVICE**

ORGANOMETALLISCHE VERBINDUNG, ZUSAMMENSETZUNG MIT DER ORGANOMETALLISCHEN VERBINDUNG UND ORGANISCHE LICHTEMITTIERENDE VORRICHTUNG

COMPOSÉ ORGANOMÉTALLIQUE, COMPOSITION CONTENANT LE COMPOSÉ ORGANOMÉTALLIQUE ET DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.01.2017 KR 20170004165**

(43) Date of publication of application:
**18.07.2018 Bulletin 2018/29**

(73) Proprietors:
- **Samsung Electronics Co., Ltd.**
  **Gyeonggi-do 16677 (KR)**
- **Samsung SDI Co., Ltd.**
  **Gyeonggi-do (KR)**

(72) Inventors:
- **NOH, Changho**
  **16678 Gyeonggi-do, (KR)**
- **KIM, Sunghan**
  **16678 Gyeonggi-do, (KR)**
- **KIM, Wook**
  **Gyeonggi-do (KR)**
- **KIM, Taerae**
  **16678 Gyeonggi-do, (KR)**
- **PARK, Sangho**
  **16678 Gyeonggi-do, (KR)**
- **SON, Wonjoon**
  **16678 Gyeonggi-do, (KR)**
- **SON, Jhunmo**
  **16678 Gyeonggi-do, (KR)**
- **HUH, Dalho**
  **Gyeonggi-do (KR)**
- **RAI, Virendra Kumar**
  **16678 Gyeonggi-do, (KR)**
- **ISHIBE, Satoko**
  **16678 Gyeonggi-do, (KR)**
- **CHANG, Jaejun**
  **16678 Gyeonggi-do, (KR)**

(74) Representative: **Elkington and Fife LLP**
**Prospect House**
**8 Pembroke Road**
**Sevenoaks, Kent TN13 1XR (GB)**

(56) References cited:
**EP-A1- 3 432 381** **EP-A1- 3 444 259**
**JP-A- 2014 111 549**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 348 562 B1

## Description

FIELD OF THE INVENTION

One or more embodiments relate to an organometallic compound, a composition containing the organometallic compound, and an organic light-emitting device.

BACKGROUND OF THE INVENTION

Organic light-emitting devices (OLEDs) are self-emission devices, which produce full-color images, and which have wide viewing angles, high contrast ratios, short response times, and excellent characteristics in terms of brightness, driving voltage, and response speed, compared to the devices in the art.

In an example, an organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Various types of organic light emitting devices are known. However, there still remains a need in OLEDs having low driving voltage, high efficiency, high brightness, and long lifespan.

JP 2014 111549 discloses an iridium complex and an organic electroluminescent element which uses the iridium complex as an organic electroluminescent element material.

SUMMARY OF THE INVENTION

One or more embodiments include a novel organometallic compound, a composition containing the organometallic compound, and an organic light-emitting device.

Additional aspects will be set forth in part in the description which follows and, in part, will be apparent from the description, or may be learned by practice of the presented embodiments.

According to one or more embodiments, an organometallic compound is provided in accordance with claim 1.

According to one or more embodiments, a composition containing the organometallic compound is provided in accordance with claim 10.

According to one or more embodiments, an organic light-emitting device is provided in accordance with claim 13. The organometallic compound may act as a dopant in the organic layer.

BRIEF DESCRIPTION OF THE DRAWINGS

These and/or other aspects will become apparent and more readily appreciated from the following description of the embodiments, taken in conjunction with the accompanying drawings in which:

FIG. 1 is a view for describing a process of evaluating Areafree in Equation 1;
FIG. 2 is a view for describing a process of evaluating $Area_{screened}$ in Equation 1;
FIG. 3 is a view of a sphere tessellation used to derive a plane B used to evaluate $Area_{screened}$ in Equation 1; and
FIG. 4 is a schematic view of an organic light-emitting device according to an embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In an embodiment, an organometallic compound is provided. The organometallic compound according to an embodiment is represented by Formula 1 below:

Formula 1

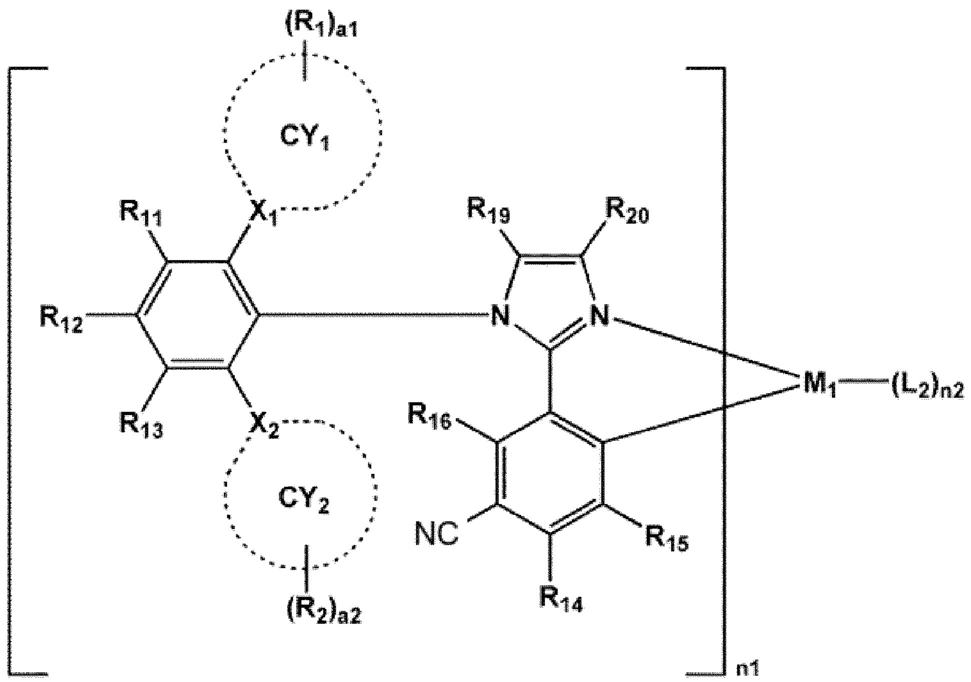

$M_1$ in Formula 1 is selected from a first-row transition metal of the Periodic Table of Elements, a second-row transition metal of the Periodic Table of Elements, and a third-row transition metal of the Periodic Table of Elements.

For example, $M_1$ may be selected from iridium (Ir), platinum (Pt), osmium (Os), titanium (Ti), zirconium (Zr), hafnium (Hf), europium (Eu), terbium (Tb), thulium (Tm), and rhodium (Rh).

In one or more embodiments, $M_1$ may be iridium, but embodiments of the present disclosure are not limited thereto.

In Formula 1, n1 is 1, 2, or 3, wherein, when n1 is two or more, two or more ligands represented by

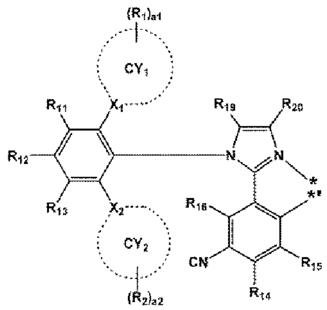

in Formula 1 (wherein * and *' each indicate a binding site to $M_1$ in Formula 1) may be identical to or different from each other.

$L_2$ is selected from ligands represented by Formulae 3A to 3C, 3E and 3F:

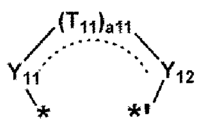

Formula 3A

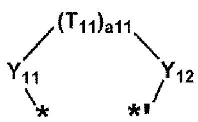

Formula 3B

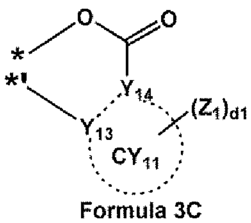

Formula 3C

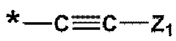

Formula 3E

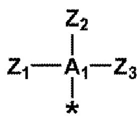

Formula 3F

n2 is 0, 1, 2, 3, or 4, wherein, when n2 is two or more, two or more groups $L_2$ are identical to or different from each other.

$Y_{11}$ is selected from O, N, $N(Z_1)$, $P(Z_1)(Z_2)$, and $As(Z_1)(Z_2)$,

$Y_{12}$ is selected from O, N, $N(Z_3)$, $P(Z_3)(Z_4)$, and $As(Z_3)(Z_4)$,

$CY_{11}$ is a $C_2$-$C_{30}$ heterocyclic group,

$T_{11}$ is each independently selected from a single bond, a double bond, *-C($Z_{11}$)($Z_{12}$)-*', *-C($Z_{11}$)=C($Z_{12}$)-*', *=C($Z_{11}$)-*', *-C($Z_{11}$)=*', *=C($Z_{11}$)-C($Z_{12}$)=C($Z_{13}$)-*', *-C($Z_{11}$)=C($Z_{12}$)-C($Z_{13}$)=*', *-N($Z_{11}$)-*', and a substituted or unsubstituted $C_5$-$C_{30}$ carbocyclic group,

a11 is an integer from 1 to 10,

$Y_{13}$ and $Y_{14}$ are each independently carbon (C) or nitrogen (N), $Y_{13}$ and $Y_{14}$ are linked via a single bond or a double bond,

$A_1$ is P or As,

In one or more embodiments, in Formula 1, $M_1$ may be Ir or Os, and the sum of n1 and n2 may be 3 or 4; or $M_1$ may be Pt, and the sum of n1 and n2 may be 2.

In one or more embodiments, in Formula 1, $M_1$ may be Ir, n1 may be 3, and n2 may be 0, but embodiments of the present disclosure are not limited thereto.

In one or more embodiments, in Formula 1, $M_1$ may be Ir, n1 may be 3, n2 may be 0, and three ligands represented by

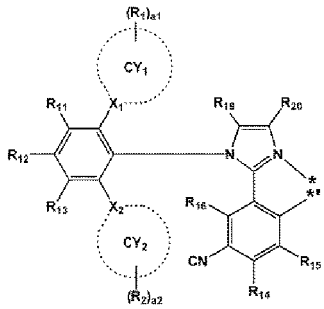

may be identical to one another.

$X_1$ and $X_2$ in Formula 1 are each independently carbon or nitrogen.

In one or more embodiments, $X_1$ and $X_2$ may each be carbon, but embodiments of the present disclosure are not limited thereto.

$CY_1$ and $CY_2$ in Formula 1 are each independently selected from a $C_5$-$C_{30}$ carbocyclic group and a $C_2$-$C_{30}$ heterocyclic group.

For example, $CY_1$ and $CY_2$ may each independently be selected from a cyclopentene group, a cyclohexene group, a benzene group, a pyridine group, a pyrimidine group, a pyridazine group, a pyrazine group, a triazine group, a pyrrole group, a pyrazole group, an imidazole group, a triazole group, an oxazole group, an isoxazole group, an oxadiazole group, a thiazole group, an isothiazole group, and a thiadiazole group.

In one or more embodiments, $CY_1$ and $CY_2$ may each independently be a benzene group, a pyridine group, or a pyrimidine group.

In one or more embodiments, $CY_1$ and $CY_2$ may each be a benzene group, but embodiments of the present disclosure are not limited thereto.

$R_1$, $R_2$, $R_{11}$ to $R_{16}$, $Z_1$ to $Z_4$ and $Z_{11}$ to $Z_{13}$ in Formula 1 are each independently selected from hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C1-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted C1-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and -P(=O)($Q_6$)($Q_9$). $Q_1$ to $Q_9$ are the same as described herein.

For example, $R_1$, $R_2$, $R_{11}$ to $R_{16}$, $Z_1$ to $Z_4$ and $Z_{11}$ to $Z_{13}$ may each independently be selected from: hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -$SF_5$, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group,

a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$,$-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

$$-N(Q_1)(Q_2),\ -Si(Q_3)(Q_4)(Q_5),\ -B(Q_6)(Q_7),\ \text{and}\ -P(=O)(Q_8)(Q_9),$$

wherein $Q_1$ to $Q_9$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$,$CHDCH_3$, $-CHDCD_2H$, $-CHDCDH_2$, $-CHDCD_3$, $-CD_2CD_3$, $-CD_2CD_2H$, and $-CD_2CDH_2$;

an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group,
but embodiments of the present disclosure are not limited thereto.

In one or more embodiments, $R_1$, $R_2$, $R_{11}$ to $R_{16}$, $Z_1$ to $Z_4$ and $Z_{11}$ to $Z_{13}$ may each independently be selected from:

hydrogen, deuterium, -F, a cyano group, a nitro group, $-SF_5$, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a

sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from deuterium,-F, $-CD_3$, $-CD_2H$, $-CDH_2$, $-CF_3$, $-CF_2H$, $-CFH_2$, a cyano group, a nitro group, a $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and

$-N(Q_1)(Q_2)$, $-Si(Q_3)(Q_4)(Q_5)$, $-B(Q_6)(Q_7)$, and $-P(=O)(Q_8)(Q_9)$,

wherein $Q_1$ to $Q_9$ are the same as described herein.

Two or more neighboring groups of $R_1$, $R_2$, $R_{11}$ to $R_{13}$, $CY_1$, and $CY_2$ in Formula 1 may optionally be linked to form a $C_5$-$C_{30}$ carbocyclic group unsubstituted or substituted with at least one $R_{101}$ (for example, a 5-membered or 6-membered carbocyclic group unsubstituted or substituted with at least one $R_{101}$), or a $C_2$-$C_{30}$ heterocyclic group unsubstituted or substituted with at least one $R_{101}$ (for example, a 5-membered or 6-membered heterocyclic group unsubstituted or substituted with at least one $R_{101}$). $R_{101}$ is the same as described in connection with $R_1$.

a1 and a2 in Formula 1 respectively indicate the number of groups $R_1$ and the number of groups $R_2$ and are each independently an integer from 0 to 5.

For example, a1 and a2 may each independently be 0, 1, or 2, but embodiments of the present disclosure are not limited thereto.

d1 is an integer from 0 to 10,

$R_{19}$ and $R_{20}$ in Formula 1 are each independently selected from hydrogen, deuterium, a $C_1$-$C_{30}$ alkyl group, a $C_1$-$C_{30}$ alkyl group substituted with at least one deuterium, a $C_6$-$C_{60}$ aryl group, and a $C_6$-$C_{60}$ aryl group substituted with at least one selected from a $C_1$-$C_{30}$ alkyl group and deuterium.

In one or more embodiments, $R_1$, $R_2$, $R_{11}$ to $R_{16}$, $R_{19}$, and $R_{20}$ in Formula 1 may each independently be selected from:

hydrogen, deuterium, $-CH_3$, $-CD_3$, $-CD_2H$, $-CDH_2$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, $-CD_2CDH_2$, a phenyl group, and a group represented by one of Formulae 9-1 to 9-24; and

a phenyl group substituted with at least one selected from deuterium, $-CD_3$,$-CD_2H$, $-CDH_2$, and a $C_1$-$C_{10}$ alkyl group, but embodiments of the present disclosure are not limited thereto:

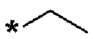
Formula 9-1

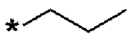
Formula 9-2

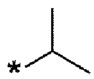
Formula 9-3

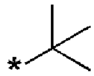
Formula 9-4

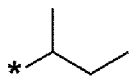
Formula 9-5

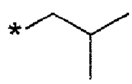
Formula 9-6

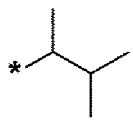
Formula 9-7

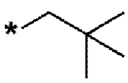
Formula 9-8

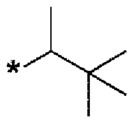
Formula 9-9

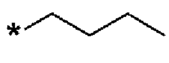
Formula 9-10

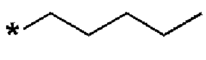
Formula 9-11

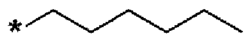
Formula 9-12

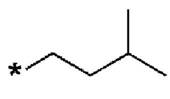
Formula 9-13

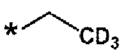
Formula 9-14

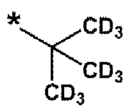
Formula 9-15

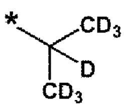
Formula 9-16

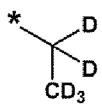
Formula 9-17

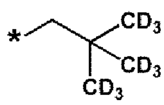
Formula 9-18

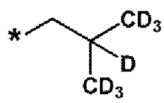
Formula 9-19

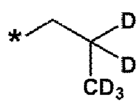
Formula 9-20

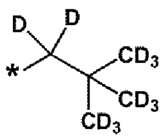

Formula 9-21

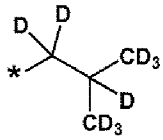

Formula 9-22

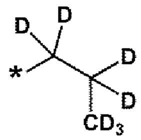

Formula 9-23

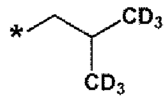

Formula 9-24

wherein, * in Formulae 9-1 to 9-24 indicates a binding site to a neighboring atom.

In one or more embodiments, at least one of $R_1$, $R_2$, $R_{11}$ to $R_{16}$, $R_{19}$, and $R_{20}$ in Formula 1 may be a deuterium-containing substituent, and the deuterium-containing substituent may be selected from:

deuterium; and
a $C_1$-$C_{20}$ alkyl group and a phenyl group, each substituted with at least one deuterium.

For example, the deuterium-containing substituent may be selected from:

deuterium; and
a methyl group, an ethyl group, an n-propyl group, an iso-propyl group, an n-butyl group, a sec-butyl group, an iso-butyl group, a tert-butyl group, an n-pentyl group, an iso-pentyl group, a 1-methylbutyl group, a 2-methylbutyl group, a neo-pentyl group, a 1,2-dimethylpropyl group, a tert-pentyl group, and a phenyl group, each substituted with at least one deuterium.

In one or more embodiments, the deuterium-containing substituent may be selected from:

deuterium; and
a methyl group, an ethyl group, an n-propyl group, an iso-propyl group, an n-butyl group, a sec-butyl group, an iso-butyl group, and a tert-butyl group, each substituted with deuterium, but embodiments of the present disclosure are not limited thereto.

In one or more embodiments, the deuterium-containing substituent may be selected from -D, $-CH_2D$, $-CHD_2$, $-CD_3$, $-CH_2CH_2D$, $-CH_2CHD_2$, $-CH_2CD_3$, $-CHDCH_3$,$-CHDCH_2D$, $-CHDCHD_2$, $-CHDCD_3$, $-CD_2CH_3$, $-CD_2CH_2D$, $-CD_2CHD_2$, $-CD_2CD_3$,$-CH_2CH_2CH_2D$, $-CH_2CH_2CHD_2$, $-CH_2CH_2CD_3$, $-CH_2CHDCH_3$, $-CH_2CHDCH_2D$,$-CH_2CHDCHD_2$, $-CH_2CHDCD_3$, $-CH_2CD_2CH_3$, $-CH_2CD_2CH_2D$, $-CH_2CD_2CHD_2$,$-CH_2CD_2CD_3$, $-CHDCH_2CH_2D$, $-CHDCH_2CHD_2$, $-CHDCH_2CD_3$, $-CHDCHDCH_3$,$-CHDCHDCH_2D$, $-CHDCHDCHD_2$, $-CHDCHDCD_3$, $-CHDCD_2CH_3$, $-CHDCD_2CH_2D$,$-CHDCD_2CHD_2$, $-CHDCD_2CD_3$, $-CD_2CH_2CH_2D$, $-CD_2CH_2CHD_2$, $-CD_2CH_2CD_3$,$-CD_2CHDCH_3$, $-CD_2CHDCH_2D$, $-CD_2CHDCHD_2$, $-CD_2CHDCD_3$, $-CD_2CD_2CH_3$,$-CD_2CD_2CH_2D$, $-CD_2CD_2CHD_2$, $-CD_2CD_2CD_3$, $-CH(CH_3)(CH_2D)$, $-CH(CH_3)(CHD_2)$,$-CH(CH_2D)(CH_2D)$, $-CH(CH_3)(CD_3)$, $-CH(CHD_2)(CHD_2)$, $-CH(CH_2D)(CD_3)$,$-CH(CHD_2)(CHD_2)$, $-CH(CHD_2)(CD_3)$, $-CH(CD_3)_2$, $-CD(CH_3)_2$, $-CD(CH_3)(CH_2D)$,$-CD(CH_3)(CHD_2)$, $-CD(CH_2D)(CH_2D)$, $-CD(CH_3)(CD_3)$, $-CD(CHD_2)(CHD_2)$,$-CD(CH_2D)(CD_3)$, $-CD(CHD_2)(CHD_2)$, $-CD(CHD_2)(CD_3)$, $-CD(CD_3)_2$, and $-C(CD_3)_3$, but embodiments of the present disclosure are not limited thereto.

In one or more embodiments, the deuterium-containing substituent may be selected from deuterium, $-CD_3$, $-CD_2H$, $-CDH_2$, $-CH_2CD_2H$, $-CH_2CDH_2$, $-CHDCH_3$,$-CHDCD_2H$, $-CHDCDH_2$, $-CHDCD_3$, $-CD_2CD_3$, $-CD_2CD_2H$, $-CD_2CDH_2$, and groups represented by Formulae 9-14 to 9-24, but embodiments of the present disclosure are not limited thereto.

In one or more embodiments, the ligand represented by

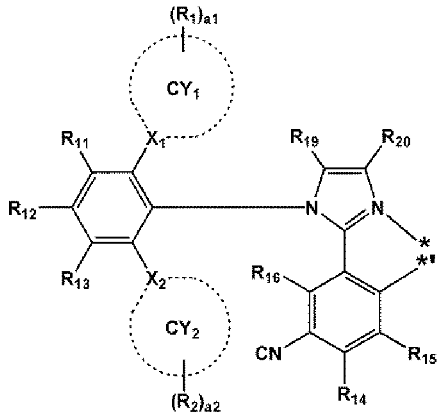

in Formula 1 (wherein * and *' each indicate a binding site to $M_1$ in Formula 1) may include at least one deuterium. Whether the ligand represented by

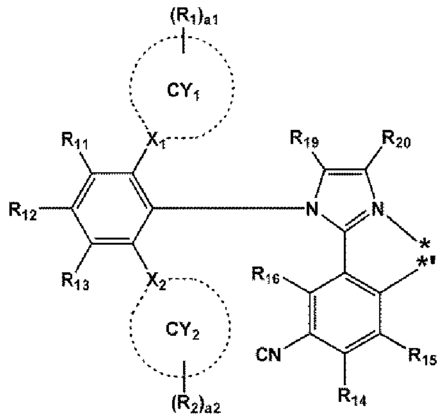

includes deuterium may be confirmed by analyzing the organometallic compound represented by Formula 1 through a $^1H$ NMR spectrum or analyzing a molecular weight of the organometallic compound by using a molecular weight measurement apparatus such as matrix-assisted laser desorption/ionization (MALDI) apparatus.

A compound (hereinafter, referred to as a "first standard compound"), which has the same backbone as the organometallic compound represented by Formula 1 but does not include deuterium, is prepared. A $^1H$ NMR spectrum of the first standard compound and a $^1H$ NMR spectrum of the organometallic compound represented by Formula 1 are obtained. Then, the number of hydrogens that are substituted with deuterium among hydrogens bonded at a specific position (specific carbon) of the organometallic compound represented by Formula 1 may be calculated by comparing integral values of signals of specific ppm selected from the measured spectrum.

In one or more embodiments, a compound (hereinafter, referred to as a "second standard compound") which has the same backbone as the organometallic compound represented by Formula 1 and in which all hydrogens of the organometallic compound represented by Formula 1 are substituted with deuterium is assumed. The number of hydrogens of the organometallic compound represented by Formula 1 that are substituted with deuterium may be calculated by comparing a calculated molecular weight of the second standard compound with a molecular weight of the organometallic compound represented by Formula 1.

In one or more embodiments, at least one of $R_{12}$, $R_{14}$, $R_{19}$, and $R_{20}$ in Formula 1 may be a deuterium-containing substituent as described above. The deuterium-containing substituent is the same as described herein.

In one or more embodiments, at least one of $R_{11}$, $R_{12}$, $R_{13}$, $R_{19}$, and $R_{20}$ in Formula 1 (for example, all of $R_{11}$, $R_{12}$, $R_{13}$, $R_{19}$, and $R_{20}$) may a deuterium-containing substituent as described above. The deuterium-containing substituent is the same as described herein.

In one or more embodiments, $R_{12}$ and $R_{14}$ in Formula 1 may each independently be selected from:

hydrogen, deuterium, $-CH_3$, $-CD_3$, $-CD_2H$, $-CDH_2$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, $-CD_2CDH_2$, a phenyl group, and groups represented by Formulae 9-1 to 9-24; and a phenyl group substituted with at least one selected from deuterium, $-CD_3$,$-CD_2H$, $-CDH_2$, and a $C_1$-$C_{10}$ alkyl group,

and

$R_{19}$ and $R_{20}$ may each independently be hydrogen or deuterium, but embodiments of the present disclosure are not limited thereto.

The organometallic compound represented by Formula 1 may be represented by Formula 1-1:

Formula 1-1

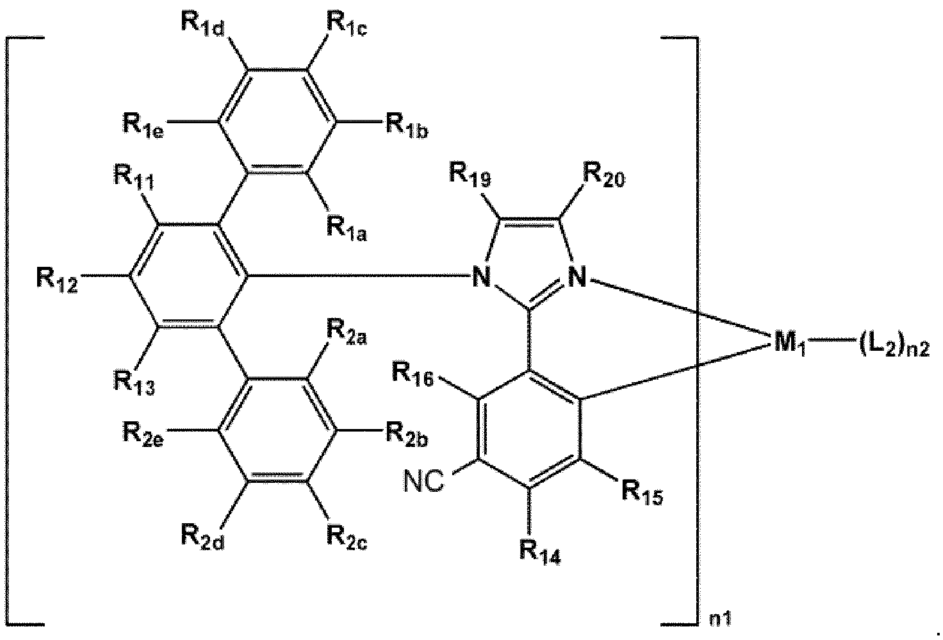

In Formula 1-1, $M_1$, n1, $L_2$, n2, $R_{11}$ to $R_{16}$, $R_{19}$, and $R_{20}$ are the same as described herein, $R_{1a}$ to $R_{1e}$ are the same as described in connection with $R_1$, and $R_{2a}$ to $R_{2e}$ are the same as described in connection with $R_2$.

For example, at least one of $R_{11}$ to $R_{13}$ in Formula 1-1 may each independently be a deuterium-containing substituent as described herein.

In one or more embodiments, in Formula 1-1, at least one of $R_{11}$ to $R_{13}$, at least one of $R_{1a}$ to $R_{1e}$, and at least one of $R_{2a}$ to $R_{2e}$ may each independently be a deuterium-containing substituent as described herein.

In one or more embodiments, $R_{11}$ to $R_{13}$, $R_{1a}$ to $R_{1e}$, and $R_{2a}$ to $R_{2e}$ in Formula 1-1 may each independently be a deuterium-containing substituent as described herein, but embodiments of the present disclosure are not limited thereto.

In one or more embodiments, the organometallic compound represented by Formula 1 may be represented by Formula 1(1):

Formula 1(1)

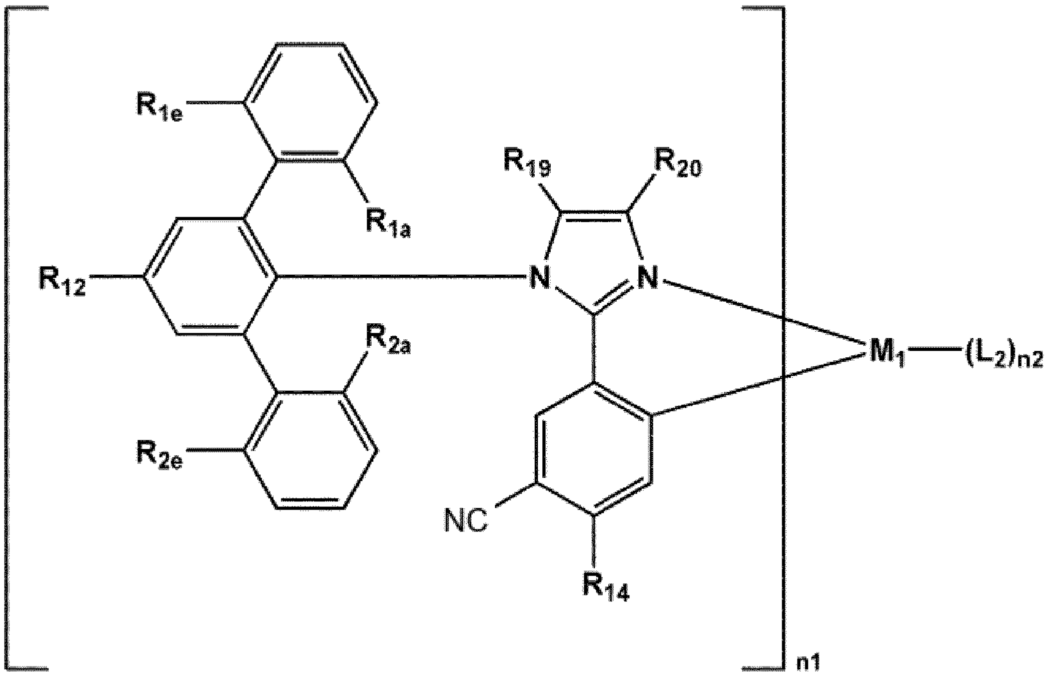

.

In Formula 1 (1), $M_1$, n1, $L_2$, n2, $R_{12}$, $R_{14}$, $R_{19}$, and $R_{20}$ are the same as described herein, $R_{1a}$ and $R_{1e}$ are the same as described in connection with $R_1$, and $R_{2a}$ and $R_{2e}$ are the same as described in connection with $R_2$.

In one or more embodiments, at least one of $R_{1a}$, $R_{1e}$, $R_{2a}$, $R_{2e}$, $R_{12}$, $R_{14}$, $R_{19}$, and $R_{20}$ in Formulae 1-1 and 1(1) may not be hydrogen.

For example, at least one of $R_{1a}$, $R_{1e}$, $R_{2a}$, $R_{2e}$, $R_{12}$, $R_{14}$, $R_{19}$, and $R_{20}$ in Formulae 1-1 and 1(1) may each independently be selected from:

deuterium, $-CH_3$, $-CD_3$, $-CD_2H$, $-CDH_2$, $-CH_2CD_2H$, $-CH_2CDH_2$, $-CHDCH_3$,$-CHDCD_2H$, $-CHDCDH_2$, $-CHDCD_3$, $-CD_2CD_3$, $-CD_2CD_2H$, $-CD_2CDH_2$, a phenyl group, and groups represented by Formulae 9-1 to 9-24; and
a phenyl group substituted with at least one selected from deuterium, $-CD_3$,$-CD_2H$, $-CDH_2$, and a $C_1$-$C_{10}$ alkyl group, but embodiments of the present disclosure are not limited thereto.

In one or more embodiments, at least one of $R_{14}$, $R_{19}$, and $R_{20}$ in Formulae 1-1 and 1(1) may be a deuterium-containing substituent. The deuterium-containing substituent are the same as described herein.

In one or more embodiments, at least one of $R_{19}$ and $R_{20}$ in Formulae 1-1 and 1(1) may be deuterium.

For example, in Formula 1, $L_2$ may be a monodentate ligand, and $L_2$ may be selected from $I^-$, $Br^-$, $Cl^-$, sulfide, nitrate, azide, hydroxide, cyanate, isocyanate, thiocyanate, water, acetonitrile, pyridine, ammonia, carbon monoxide, $P(Ph)_3$, $P(Ph)_2CH_3$, $PPh(CH_3)_2$, and $P(CH_3)_3$, but embodiments of the present disclosure are not limited thereto.

In one or more embodiments, in Formula 1, $L_2$ may be a bidentate ligand, and $L_2$ may be selected from oxalate, acetylacetonate, a picolinic acid, 1,2-bis(diphenylphosphino)ethane, 1,1-bis(diphenylphosphino)methane, glycinate, and ethylenediamine, but embodiments of the present disclosure are not limited thereto.

In one or more embodiments, $L_2$ in Formula 1 may be selected from ligands represented by Formulae 3A to 3C, 3E and 3F:

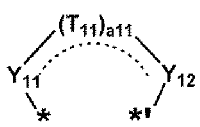

Formula 3A

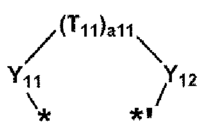

Formula 3B

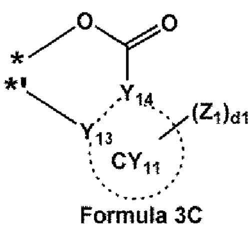

Formula 3C

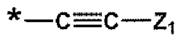

Formula 3E

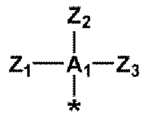

Formula 3F

In Formulae 3A to 3C, 3E and 3F,

$Y_{11}$ is selected from O, N, N($Z_1$), P($Z_1$)($Z_2$), and As($Z_1$)($Z_2$),

$Y_{12}$ is selected from O, N, N($Z_3$), P($Z_3$)($Z_4$), and As($Z_3$)($Z_4$),

$CY_{11}$ is a $C_2$-$C_{30}$ heterocyclic group (for example, a pyridine group, a pyrimidine group, a quinoline group, an isoquinoline group, a quinoxaline group, a carbazole group, or the like),

$T_{11}$ is each independently selected from a single bond, a double bond, *-C($Z_{11}$)($Z_{12}$)-*', *-C($Z_{11}$)=C($Z_{12}$)-*', *=C($Z_{11}$)-*', *-C($Z_{11}$)=*', *=C($Z_{11}$)-C($Z_{12}$)=C($Z_{13}$)-*', *-C($Z_{11}$)=C($Z_{12}$)-C($_{Z13}$)=*', *-N($Z_{11}$)-*', and a substituted or unsubstituted $C_5$-$C_{30}$ carbocyclic group,

a11 is an integer from 1 to 10,

$Y_{13}$ and $Y_{14}$ are each independently carbon (C) or nitrogen (N), wherein $Y_{13}$ and $Y_{14}$ are linked via a single bond or a double bond,

$A_1$ is P or As,

$Z_1$ to $Z_4$ and $Z_{11}$ to $Z_{13}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -N($Q_1$)($Q_2$),-Si($Q_3$)($Q_4$)($Q_5$), -B($Q_6$)($Q_7$), and -P(=O)($Q_8$)($Q_9$),

d1 is an integer from 0 to 10, and

* and *' each indicate a binding site to M in Formula 1.

In one or more embodiments, $L_2$ in Formula 1 may be represented by Formulae 5-118 or 5-119, but embodiments of the present disclosure are not limited thereto:

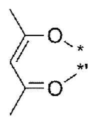

5-118

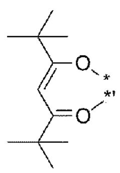

5-119

In Formulae 5-118 or 5-119,

* and *' each indicate a binding site to $M_1$ in Formula 1.

The organometallic compound represented by Formula 1 is neutral and may not have a salt form including an anion and a cation.

The organometallic compound represented by Formula 1 may be selected from Compounds 1 to 9, but embodiments of the present disclosure are not limited thereto:

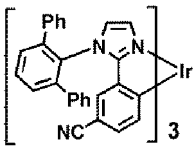
1

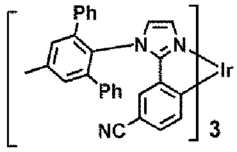
2

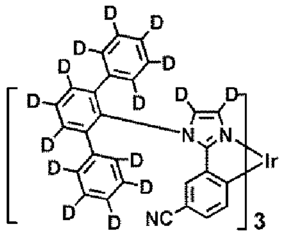
3

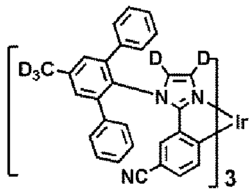
4

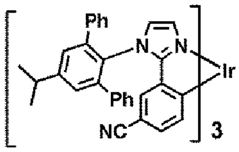
5

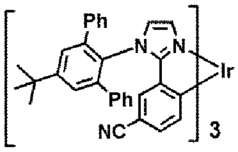
6

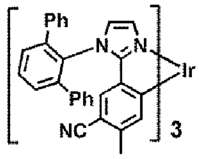
7

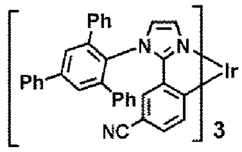
8

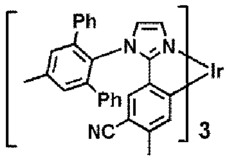
9

wherein "Ph" in Compounds 1 to 9 indicates a phenyl group.

A maximum emission wavelength of the organometallic compound may be in a range of about 440 nanometers (nm) to about 470 nm (for example, about 440 nm to about 467 nm). When the maximum emission wavelength is in a range of about 440 nm to about 470 nm, an organic light-emitting device emitting deep blue light may be provided.

The organometallic compound represented by Formula 1 essentially includes $CY_1$ and $CY_2$ at positions defined herein.

Thus, the organometallic compound may have a natural population analysis (NPA) charge value of about 0.50 or less, for example, about 0 to about 0.48. The NPA charge value is evaluated by a density functional theory (DFT) method using a Gaussian program that is structurally optimized at a level of B3LYP/6-31 G(d,p).

Also, an open fraction value of atom A bonded to $R_{19}$ in Formula 1 (see Formula 1') may be about 0.5 or less, for example, about 0.1 to about 0.49.

Formula 1'

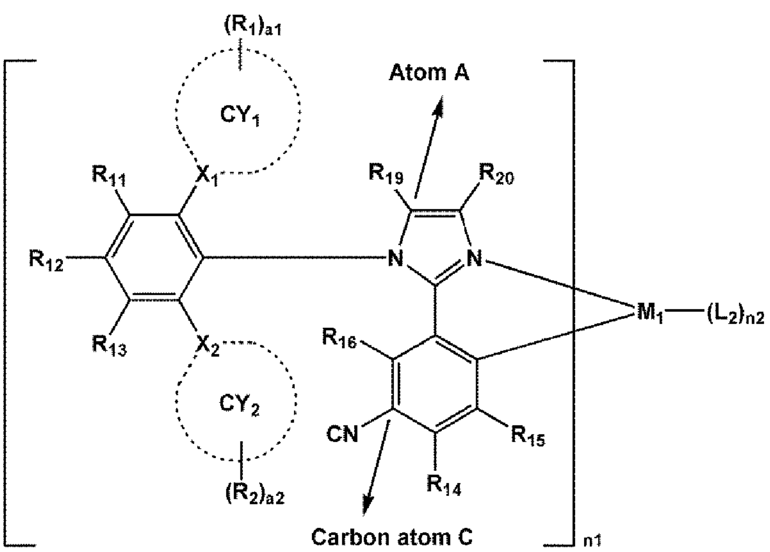


.

The open fraction value is calculated by using Equation 1. Equation 1 will be described below with reference to FIGS. 1 to 3:

Equation 1

$$\text{Open fraction value} = \text{Area}_{screened} / \text{Area}_{free}.$$

In Equation 1,

Areafree represents an area of a two-dimensional figure (see "FIGURE 1" in FIG. 1) obtained by projecting the atom A (see "ATOM A" in FIG. 1) on a plane A (see "PLANE A" in FIG. 1) and is calculated by $\pi$ x (van der Waals radius of atom A)$^2$ (wherein the van der Waals radius of the atom A (that is, van der Waals radius of a carbon atom) refers to "R" in FIG. 1),

$\text{Area}_{screened}$ represents an average value of an area of a two-dimensional figure (see "FIGURE 2" in FIG. 2) obtained by projecting the atom A (see "ATOM A" in FIG. 2) screened by another atom B of Formula 1 (see "ATOM B(1)" and "ATOM B(2)" in FIG. 2) on a plane B (see "PLANE B" in FIG. 2),

assumming that the atom A and the atom B each have a spherical shape,

the plane B is planes in which vectors directing from each of 492 points on a spherical surface of a sphere tessellation (see FIG. 3) toward the origin of the sphere tessellation are normal vectors, and

the $\text{Area}_{screened}$ is calculated by a DFT method using a Gaussian program that is structurally optimized at a level of B3LYP/6-31 G(d,p).

The atom B means a combination of any atoms that can screen the atom A of Formula 1.

The open fraction value represents how much the atom A is opened in Formula 1. As the open fraction value decreases, the atom A is more screened by another atom B in Formula 1 and is less opened. A bond between the atom A and $R_{19}$ in Formula 1 is a relatively weak bond that may be easily damaged by heat or the like generated when an organic light-emitting device is stored and/or driven. Since the atom A of Formula 1 has a relatively small open fraction value as described above, that is, since a relatively large portion of the atom A is screened by another atom B of Formula 1, damage to the bond between the atom A and $R_{19}$ in Formula 1 may be substantially prevented. Thus, the organometallic compound represented by Formula 1 may have robustness.

Since the organometallic compound having the NPA charge value and the open fraction value in the above-described ranges has excellent heat resistance and/or decomposition resistance, an electronic device (for example, an organic light-emitting device) including the organometallic compound may have a long lifespan.

On the other hand, a "carbon atom C" in Formula 1 is essentially bonded to a cyano group (see Formula 1'). Thus, since the organometallic compound represented by Formula 1 has a deep highest occupied molecular orbital (HOMO) energy level (that is, a large absolute value of a HOMO energy level or a low HOMO energy level), the organometallic compound may have a high triplet energy level. Therefore, the use of the organometallic compound represented by Formula 1 may make it possible to emit deep blue light having excellent color purity.

Also, in one or more embodiments, the organometallic compound represented by Formula 1 may include at least one deuterium. For example, at least one of $R_{19}$ and $R_{20}$ in Formula 1 may be a deuterium-containing substituent. Compared with a single bond between carbon and hydrogen, a single bond between carbon and deuterium has a strong bond strength and a short bond length. Thus, the deuterium-containing organometallic compound may have higher thermal stability than the deuterium-free organometallic compound. Therefore, radicalization of the organometallic compound represented by Formula 1 slowly progresses due to heat and/or electric field generated when the organic light-emitting device is kept and/or driven, and thus, an organic light-emitting device including the organometallic compound may have a longer lifespan.

Furthermore, in one or more embodiments, $R_{14}$ in Formula 1 may be a substituent other than hydrogen. For example, $R_{14}$ in Formula 1 may be a $C_1$-$C_{20}$ alkyl group or a deuterium-containing substituent. The organometallic compound represented by Formula 1 may have a high lowest unoccupied molecular orbital (LUMO) energy level and a high triplet ($T_1$) energy level. Thus, the use of the organometallic compound represented by Formula 1 may make it possible to emit blue light having excellent color purity.

Table 1 below shows results obtained when HOMO energy levels, LUMO energy levels, $T_1$ energy levels, and maximum emission wavelengths of some of the organometallic compounds represented by Formula 1 and Compounds E and F were evaluated using a Gaussian 09 program for optimizing a molecular structure through DFT based on B3LYP.

Table 1

| Compound No. | HOMO (eV) | LUMO (eV) | $T_1$(eV) | $\lambda_{max}$ (nm) |
|---|---|---|---|---|
| 1 | -5.19 | -1.26 | 2.66 | 478 |

(continued)

| Compound No. | HOMO (eV) | LUMO (eV) | $T_1$(eV) | $\lambda_{max}$ (nm) |
|---|---|---|---|---|
| 2 | -5.13 | -1.17 | 2.67 | 476 |
| 3 | -5.19 | -1.26 | 2.66 | 478 |
| 4 | -5.13 | -1.17 | 2.67 | 476 |
| 5 | -5.13 | -1.16 | 2.66 | 476 |
| 6 | -5.12 | -1.15 | 2.66 | 476 |
| 7 | -5.09 | -1.18 | 2.69 | 473 |
| 8 | -5.41 | -1.64 | 2.65 | 484 |
| 9 | -5.03 | -1.09 | 2.69 | 471 |
| E | -5.14 | -1.47 | 2.47 | 503 |
| F | -5.18 | -1.50 | 2.48 | 499 |

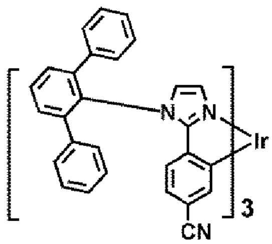

E

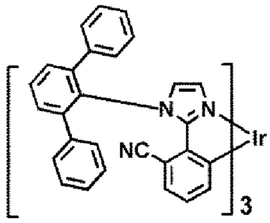

F

From Table 1, it can be confirmed that Compounds 1 to 9 have relatively high $T_1$ energy levels, as compared with Compounds E and F.

On the other hand, in synthesizing an organometallic compound that is represented by Formula 1 but includes at least one deuterium, if the organometallic compound is not completely deuterated, an organometallic compound in which hydrogen is not substituted with deuterium may also be synthesized. Thus, a composition containing the organometallic compound, which includes the organometallic compound represented by Formula 1 (hereinafter, a "first organometallic compound") and further includes an organometallic compound represented by Formula 2 (hereinafter, a "second organometallic compound"), may be provided:

Formula 1

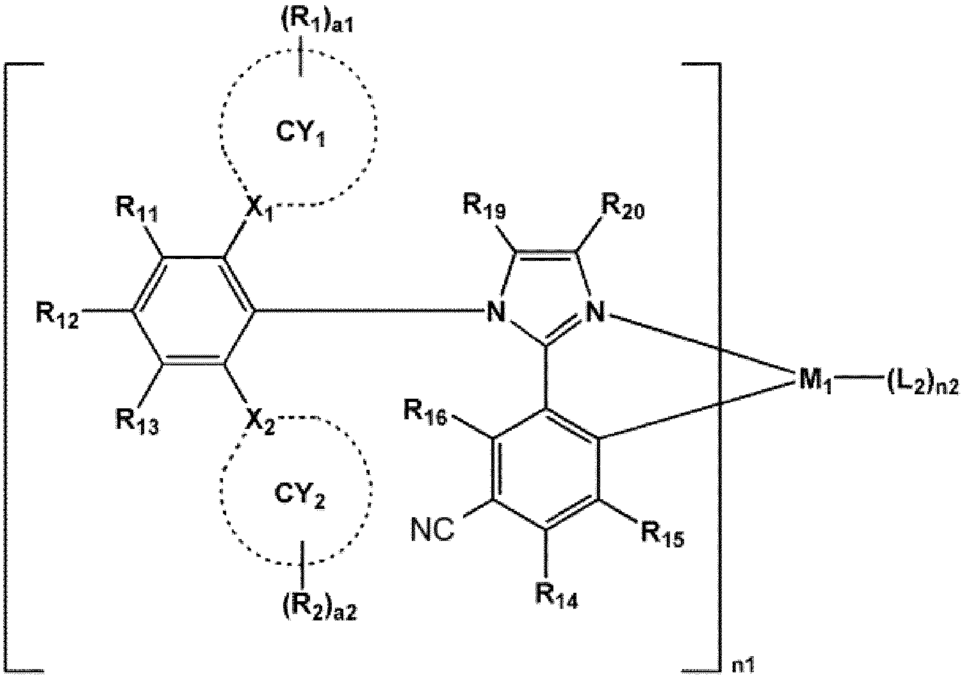

Formula 2

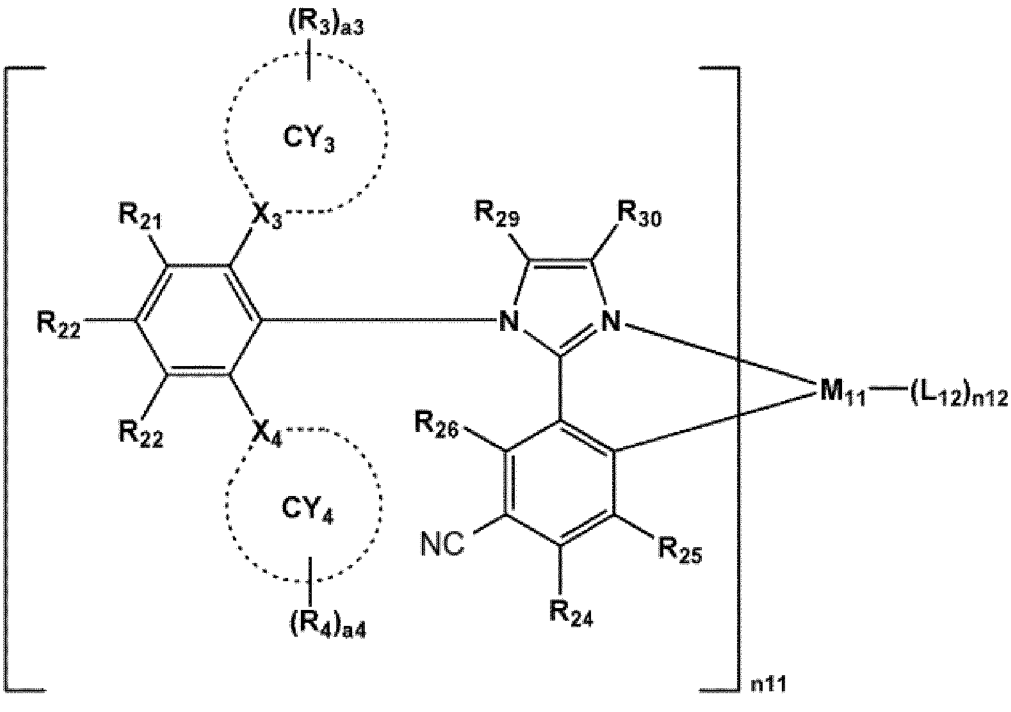

In Formulae 1 and 2,

$M_1$ and $M_{11}$ are each independently selected from a first-row transition metal of the Periodic Table of Elements, a second-row transition metal of the Periodic Table of Elements, and a third-row transition metal of the Periodic Table of Elements,

n1 and n11 are each independently 1, 2, or 3,

$L_2$ and $L_{12}$ are each independently selected from ligands represented by Formulae 3A to 3C, 3E and 3F:

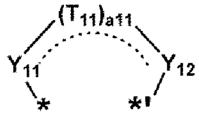

Formula 3A

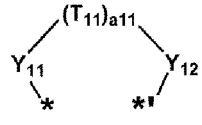

Formula 3B

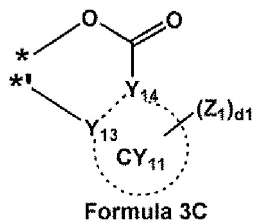

Formula 3C

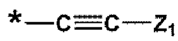

Formula 3E

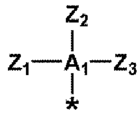

Formula 3F

n2 and n12 are each independently 0, 1, 2, 3, or 4, wherein, when n2 is two or more, two or more groups $L_2$ may be identical to or different from each other, and when n12 is two or more, two or more groups $L_{12}$ may be identical to or different from each other,
$X_1$ to $X_4$ are each independently carbon or nitrogen,
$CY_1$ to $CY_4$ are each independently selected from a $C_5$-$C_{30}$ carbocyclic group and a $C_2$-$C_{30}$ heterocyclic group,
$Y_{11}$ is selected from O, N, $N(Z_1)$, $P(Z_1)(Z_2)$, and $As(Z_1)(Z_2)$,
$Y_{12}$ is selected from O, N, $N(Z_3)$, $P(Z_3)(Z_4)$, and $As(Z_3)(Z_4)$,
$CY_{11}$ is a $C_2$-$C_{30}$ heterocyclic group,
$T_{11}$ is each independently selected from a single bond, a double bond, *-$C(Z_{11})(Z_{12})$-*', *-$C(Z_{11})$=$C(Z_{12})$-", *=$C(Z_{11})$-*', *-$C(Z_{11})$=*', *=$C(Z_{11})$-$C(Z_{12})$=$C(Z_{13})$-*', *-$C(Z_{11})$=$C(Z_{12})$-$C(Z_{13})$=*', *-$N(Z_{11})$-*', and a substituted or unsubstituted $C_5$-$C_{30}$ carbocyclic group,
a11 is an integer from 1 to 10,
$Y_{13}$ and $Y_{14}$ are each independently carbon (C) or nitrogen (N), $Y_{13}$ and $Y_{14}$ are linked via a single bond or a double bond,
$A_1$ is P or As,
$R_1$, $R_2$, $R_{11}$ to $R_{16}$, $Z_1$ to $Z_4$ and $Z_{11}$ to $Z_{13}$ are each independently selected from hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_3)(Q_4)(Q_5)$, -$B(Q_6)(Q_7)$, and -$P(=O)(Q_8)(Q_9)$,
two or more neighboring groups of $R_1$, $R_2$, $R_{11}$ to $R_{13}$, $CY_1$, and $CY_2$ may optionally be linked to form a substituted or unsubstituted $C_5$-$C_{30}$ carbocyclic group or a substituted or unsubstituted $C_2$-$C_{30}$ heterocyclic group,
a1 and a2 are each independently an integer from 0 to 5,
d1 is an integer from 0 to 10
$R_{19}$ and $R_{20}$ are each independently selected from hydrogen, deuterium, a C1-$C_{30}$ alkyl group, a $C_1$-$C_{30}$ alkyl group substituted with at least one deuterium, a $C_6$-$C_{60}$ aryl group, and a $C_6$-$C_{60}$ aryl group substituted with at least one selected from a $C_1$-$C_{30}$ alkyl group and deuterium,
at least one of $R_1$, $R_2$, $R_{11}$ to $R_{16}$, $R_{19}$, and $R_{20}$ is a deuterium-containing substituent,
$R_3$, $R_4$, and $R_{21}$ to $R_{26}$ are each independently selected from hydrogen, -F, -Cl, - Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group,

a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$,$-Si(Q_3)(Q_4)(Q_5)$, $-B(Q_6)(Q_7)$, and $-P(=O)(Q_8)(Q_9)$,
two or more neighboring groups of $R_3$, $R_4$, $R_{21}$ to $R_{23}$, $CY_3$, and $CY_4$ may optionally be linked to form a substituted or unsubstituted $C_5$-$C_{30}$ carbocyclic group or a substituted or unsubstituted $C_2$-$C_{30}$ heterocyclic group,
a3 and a4 are each independently an integer from 0 to 5,
$R_{29}$ and $R_{30}$ are each independently selected from hydrogen, a $C_1$-$C_{30}$ alkyl group, a $C_6$-$C_{60}$ aryl group, and a $C_6$-$C_{60}$ aryl group substituted with at least one $C_1$-$C_{30}$ alkyl group, and
$R_3$, $R_4$, $R_{21}$ to $R_{26}$, $R_{29}$, and $R_{30}$ are each a deuterium-free substituent.

Formula 1 is the same as described herein, and $M_{11}$, n11, $L_{12}$, n12, $X_3$, $X_4$, $CY_3$, $CY_4$, $R_3$, $R_4$, $R_{21}$ to $R_{26}$, a3, a4, $R_{29}$, and $R_{30}$ in Formula 2 are the same as described in connection with $M_1$, n1, $L_2$, n2, $X_1$, $X_2$, $CY_1$, $CY_2$, $R_1$, $R_2$, $R_{11}$ to $R_{16}$, a1, a2, $R_{19}$, and $R_{20}$ in Formula 1, except that deuterium is not included.

For example, in Formula 2,
$M_{11}$ may be Ir or Os, and the sum n11 and n12 may be 3 or 4; or $M_{11}$ may be Pt, and the sum of n11 and n12 may be 2,
$CY_3$ and $CY_4$ may each independently be selected from a cyclopentene group, a cyclohexene group, a benzene group, a pyridine group, a pyrimidine group, a pyridazine group, a pyrazine group, a triazine group, a pyrrole group, a pyrazole group, an imidazole group, a triazole group, an oxazole group, an isoxazole group, an oxadiazole group, a thiazole group, an isothiazole group, and a thiadiazole group,
$R_3$, $R_4$, and $R_{21}$ to $R_{26}$ may each independently be selected from:

hydrogen, -F, a cyano group, a nitro group, $-SF_5$, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from -F, $-CF_3$, $-CF_2H$, $-CFH_2$, a cyano group, a nitro group, a $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and

$$-N(Q_1)(Q_2),\ -Si(Q_3)(Q_4)(Q_5),\ -B(Q_6)(Q_7),\ \text{and}\ -P(=O)(Q_8)(Q_9),$$

a3 and a4 may each independently be 0, 1, or 2,
$R_{29}$ and $R_{30}$ may each independently be selected from a methyl group, an ethyl group, an n-propyl group, an iso-propyl group, an n-butyl group, a sec-butyl group, an iso-butyl group, a tert-butyl group, an n-pentyl group, an iso-pentyl group, a 1-methylbutyl group, a 2-methylbutyl group, a neo-pentyl group, a 1,2-dimethylpropyl group, a tert-pentyl group, and a phenyl group, but embodiments of the present disclosure are not limited thereto.

A deuteration rate of the composition containing the organometallic compound may be 50% or more. The deuteration rate may be calculated by using Equation 2:

Equation 2

$$\text{deuteration rate (\%)} = n_{D2}/(n_{H2} + n_{D2}) \times 100.$$

In Equation 2,

$n_{H2}$ represents the sum of a total number of hydrogens included in the deuterium-containing substituents in the first organometallic compound and a total number of hydrogens included in the deuterium-free substituent of the second organometallic compound corresponding to the deuterium-containing substituent in the first organometallic compound, and

$n_{D2}$ represents a total number of deuterium atoms included in the deuterium-containing substituents in the first organometallic compound.

When a substituent indicated by a dashed box in Compound 4 is a deuterium-containing substituent, a deuterium-free substituent corresponding to the deuterium-containing substituent in Compound 4' may mean a substituent indicated by a dashed box in Compound 4'. That is, in the present disclosure, substituents bonded to carbon at the same position in two compounds that differ from each other only in terms of the presence or absence of isotope are defined as "corresponding" substituents.

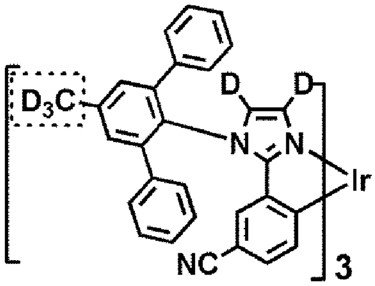

4

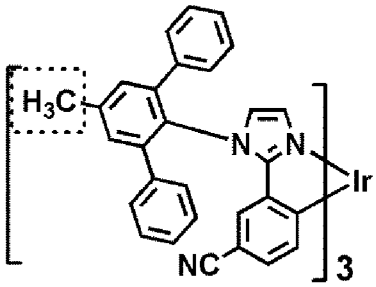

4'

For example, if the first organometallic compound includes two deuterium-containing substituents, $n_{D2}$ means the total number of deuterium atoms included in the two deuterium-containing substituents. Also, $n_{H2}$ means the sum of the number of hydrogens included in the two deuterium-containing substituents and the number of hydrogens included in the deuterium-free substituent of the second organometallic compound corresponding to the two deuterium-containing substituents.

In one or more embodiments, the deuteration rate may be about 70% or more, about 90% or more, about 95% or more, about 96% or more, about 97% or more, about 98% or more, or about 99% or more, but embodiments of the present disclosure are not limited thereto.

Synthesis methods of the organometallic compound represented by Formula 1 may be recognizable by one of ordinary skill in the art by referring to Synthesis Examples provided below. The composition containing the organometallic compound is not the addition of at least one second organometallic compound, but may result from an incomplete deuteration in synthesizing the organometallic compound represented by Formula 1. For example, the composition may comprise a mixture of Compound 3 and a resultant from an incomplete deuteration of Compound 3 or a mixture of Compound 4 and a resultant from an incomplete deuteration of Compound 4, but embodiments of the present disclosure are not limited thereto.

Synthesis methods of the organometallic compound represented by Formula 1 may be recognizable by one of ordinary skill in the art by referring to Synthesis Examples provided below.

The organometallic compound represented by Formula 1 or the composition containing the organometallic compound may be suitable for use as a dopant in an organic layer of an organic light-emitting device, for example, an emission layer in the organic layer.

According to one or more embodiments, an organic light-emitting device may include:

a first electrode;
a second electrode; and
an organic layer disposed between the first electrode and the second electrode,
wherein the organic layer includes an emission layer, and
wherein the organic layer may include at least one organometallic compound represented by Formula 1 or may include a composition containing the organometallic compound.

Since the organic light-emitting device includes the organic layer including the organometallic compound represented by Formula 1 or the composition containing the organometallic compound, the organic light-emitting device may have high efficiency, a long lifespan, and high color purity.

The organometallic compound represented by Formula 1 or the composition containing the organometallic compound may be used between a pair of electrodes of the organic light-emitting device. For example, the organometallic compound represented by Formula 1 or the composition containing the organometallic compound may be included in the emission layer. The organometallic compound or the composition containing the organometallic compound may act as a dopant, and the emission layer may further include a host (that is, an amount of the organometallic compound represented by Formula 1 or the composition containing the organometallic compound is smaller than an amount of the host). In this embodiment, the dopant may emit blue light.

The expression "(an organic layer) includes at least one of organometallic compounds" as used herein may include an embodiment in which "(an organic layer) includes identical organometallic compounds represented by Formula 1" and an embodiment in which "(an organic layer) includes two or more different organometallic compounds represented by Formula 1."

For example, the organic layer may include, as the organometallic compound, only Compound 1. In this embodiment, Compound 1 may be included in an emission layer of the organic light-emitting device. In one or more embodiments, the organic layer may include, as the organometallic compound, Compound 1 and Compound 2. In these embodiments, Compound 1 and Compound 2 may be included in an identical layer (for example, Compound 1 and Compound 2 all may be included in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes at least one selected from a hole injection layer, a hole transport layer, and an electron blocking layer, and wherein the electron transport region includes at least one selected from a hole blocking layer, an electron transport layer, and an electron injection layer.

The term "organic layer" as used herein refers to a single layer and/or a plurality of layers between the first electrode and the second electrode of the organic light-emitting device. The "organic layer" may include, in addition to an organic compound, an organometallic complex including metal.

FIG. 4 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 4. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode 11.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer. The hole transport layer may be a single layer or may include two or more layers.

The hole transport region may include only either a hole injection layer or a hole transport layer. In one or more embodiments, the hole transport region may have a hole injection layer/hole transport layer structure, a hole injection layer/hole transport layer/electron blocking layer structure, a hole transport layer/electron blocking layer structure, a hole

injection layer/first hole transport layer/second hole transport layer structure, a hole injection layer/first hole transport layer/second hole transport layer/electron blocking layer structure, or a first hole transport layer/second hole transport layer/electron blocking layer structure, in which layers of each structure may be sequentially stacked on the first electrode 11 in this stated order.

A hole injection layer may be formed on the first electrode 11 by using one or more suitable methods selected from vacuum deposition, spin coating, casting, and Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.001 nanometers per second (nm/sec) to about 10 nm/sec (about 0.01 Angstroms per second (Å/sec) to about 100 Å/sec). However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) to about 5,000 rpm, and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

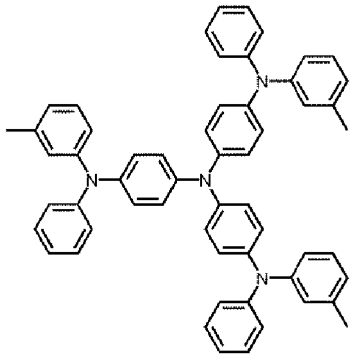
m-MTDATA

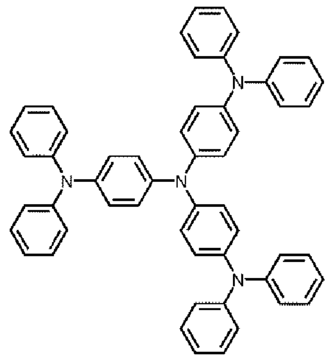
TDATA

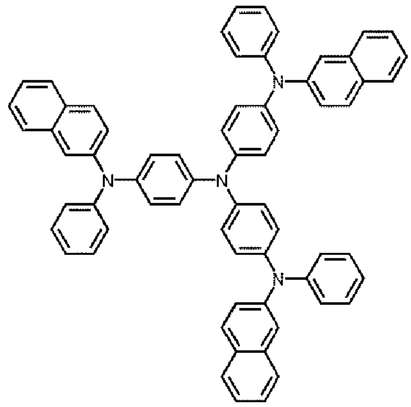
2-TNATA

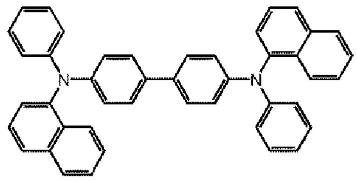
NPB

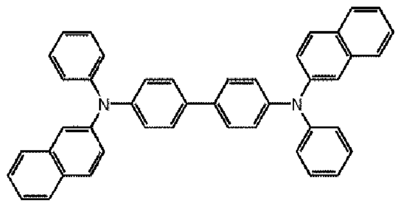
β-NPB

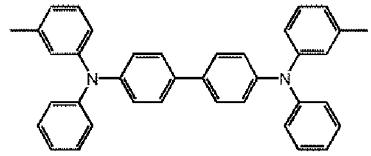
TPD

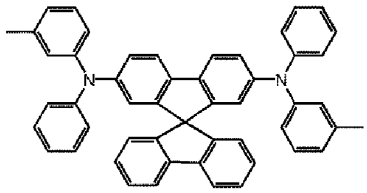
Spiro-TPD

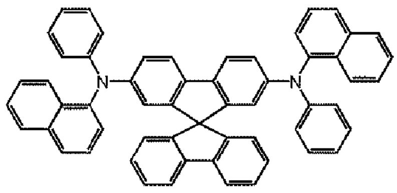
Spiro-NPB

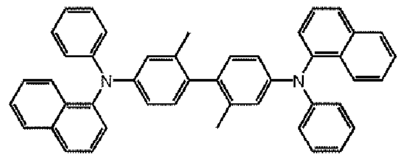
methylated NPB

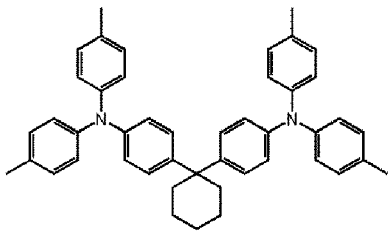
TAPC

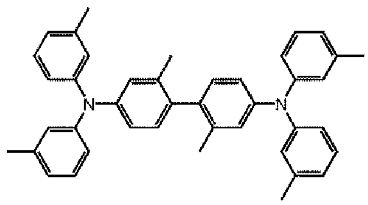
HMTPD

Formula 201

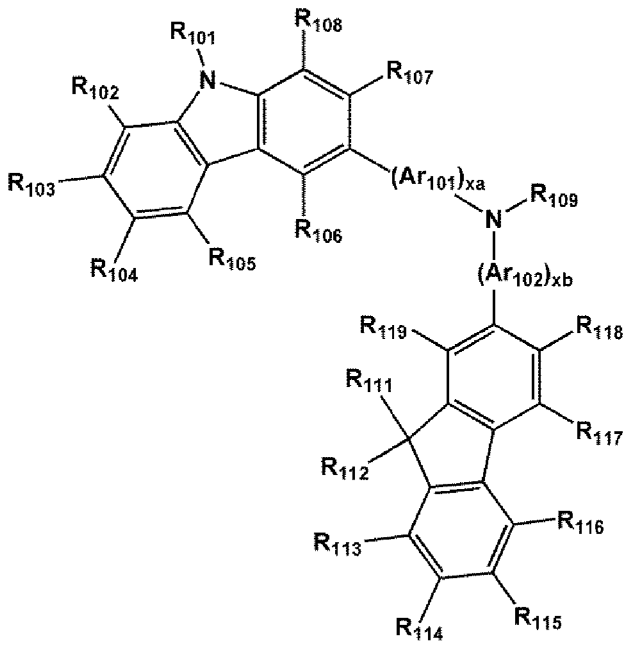

Formula 202

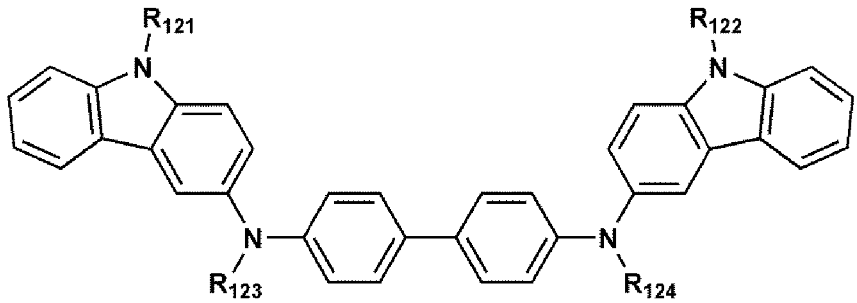

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

In Formula 201, xa and xb may each independently be an integer from 0 to 5, or 0, 1, or 2. For example, xa is 1 and xb is 0, but xa and xb are not limited thereto.

$R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);

a $C_1$-$C_{10}$ alkyl group or a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;

a phenyl group, a naphthyl group, an anthracenyl group, a fluorenyl group, and a pyrenyl group; and

a phenyl group, a naphthyl group, an anthracenyl group, a fluorenyl group, and a pyrenyl group, each substituted with at least one selected from deuterium, -F, -Cl, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group, but embodiments of the present disclosure are not limited thereto.

$R_{109}$ in Formula 201 may be selected from:

a phenyl group, a naphthyl group, an anthracenyl group, and a pyridinyl group; and

a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

According to an embodiment, the compound represented by Formula 201 may be represented by Formula 201A, but embodiments of the present disclosure are not limited thereto:

Formula 201A

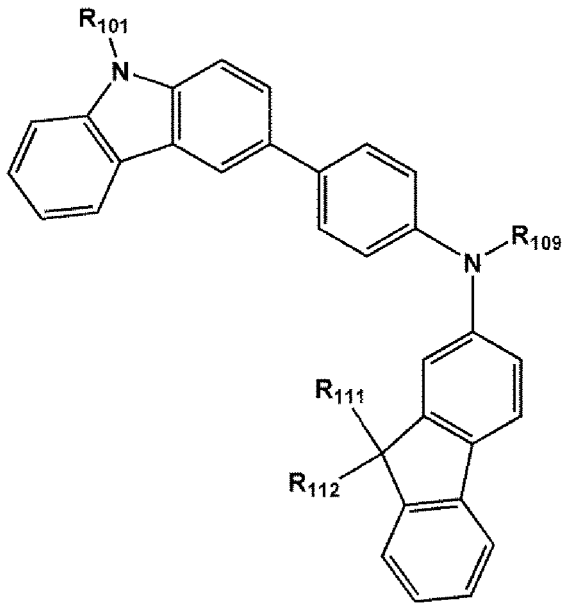

$R_{101}$, $R_{111}$, $R_{112}$, and $R_{109}$ in Formula 201A may be understood by referring to the description provided herein.

For example, the compound represented by Formula 201 and the compound represented by Formula 202 may include compounds HT1 to HT20 illustrated below, but embodiments of the present disclosure are not limited thereto.

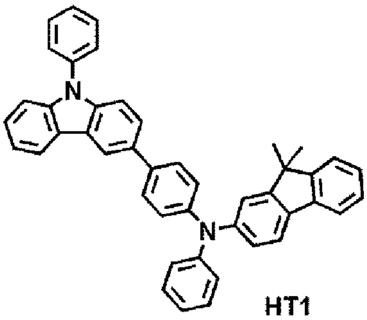

HT1

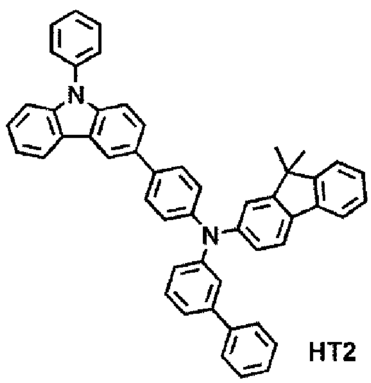

HT2

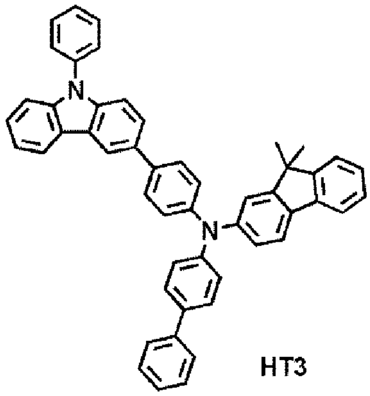

HT3

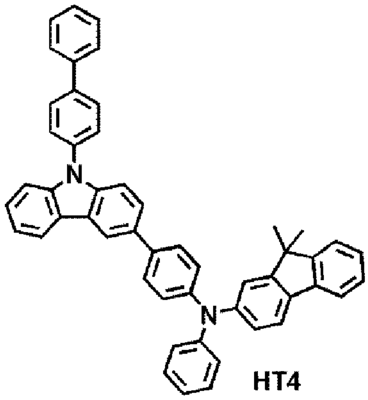

HT4

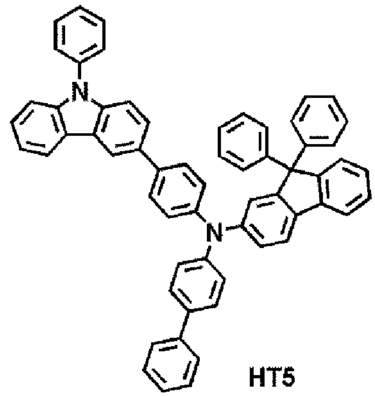

HT5

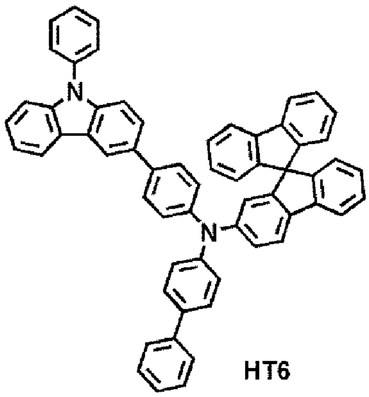

HT6

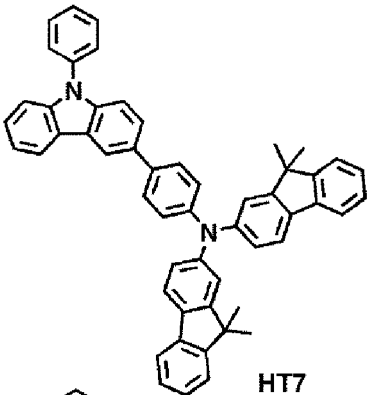

HT7

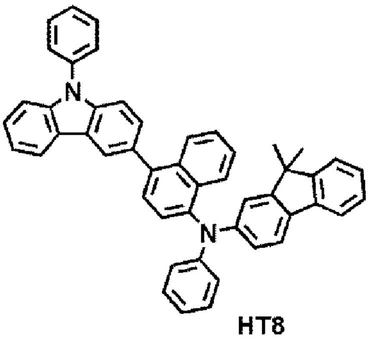

HT8

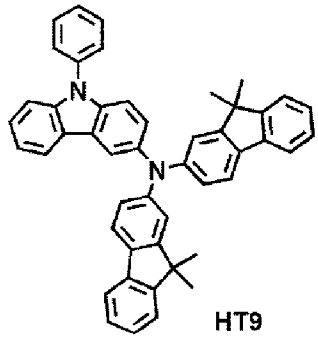

HT9

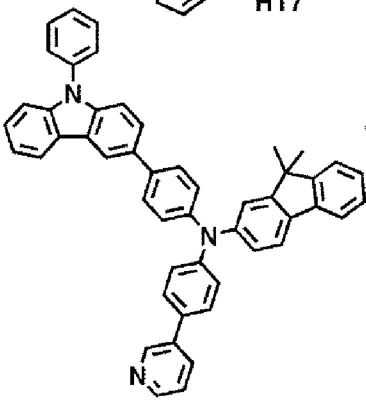

HT10

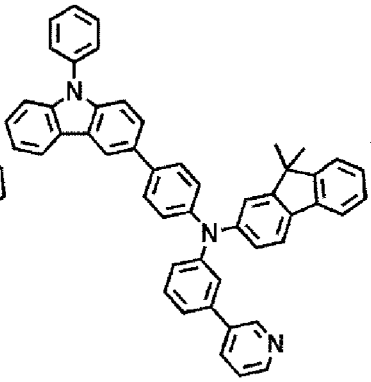

HT11

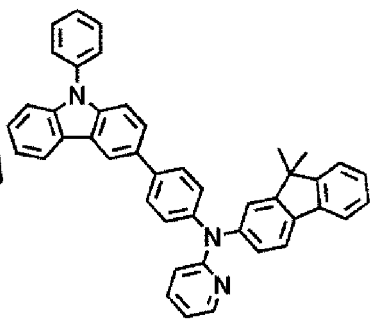

HT12

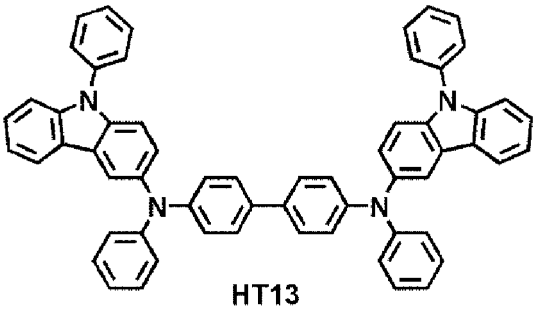

HT13

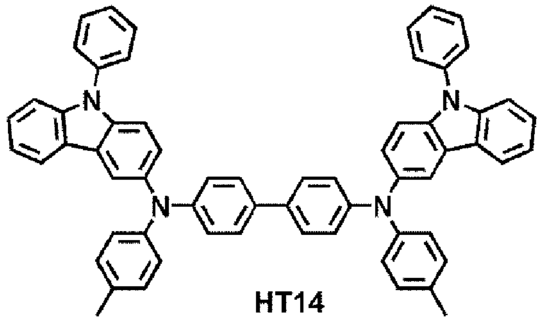

HT14

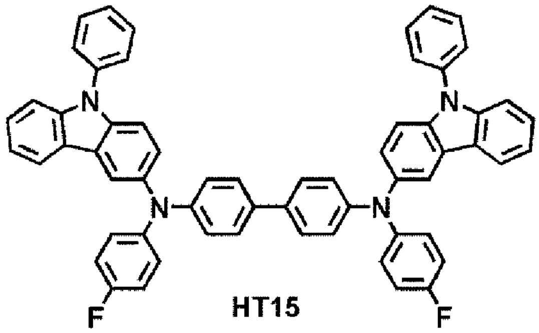

HT15

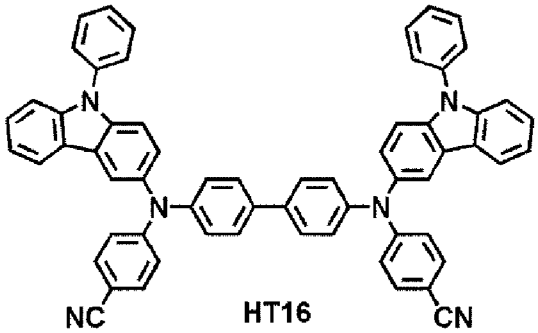

HT16

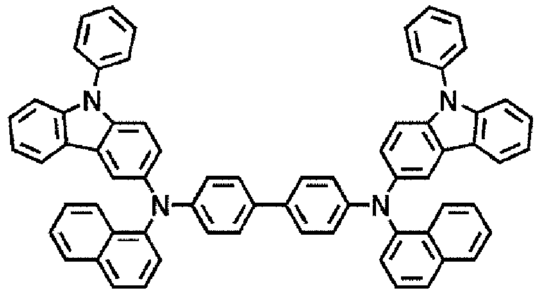

HT17

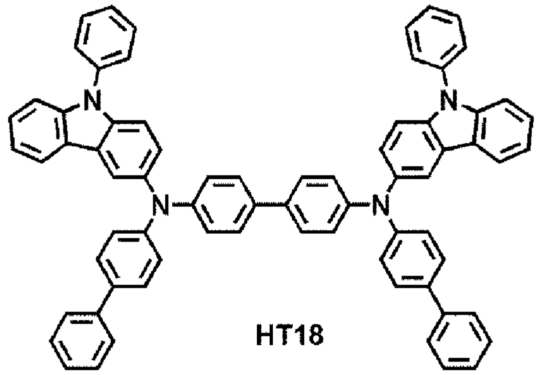

HT18

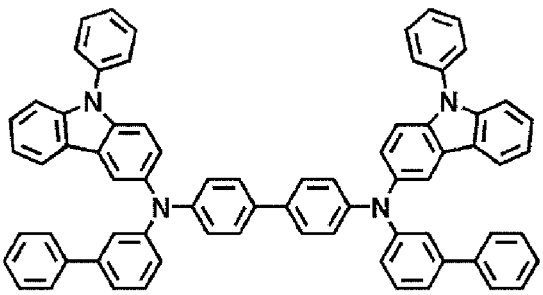

HT19

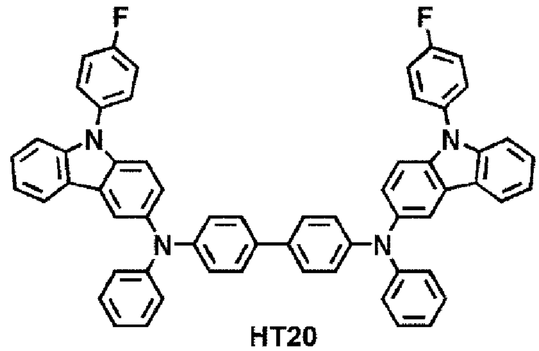

HT20

A thickness of the hole transport region may be in a range of about 10 nanometers (nm) to about 1,000 nm (about 100 Angstroms (Å) to about 10,000 Å), for example, about 10 nm to about 100 nm (about 100 Å to about 1,000 Å). When the hole transport region includes at least one of a hole injection layer and a hole transport layer, the thickness of the hole injection layer may be in a range of about 10 nm to about 1,000 nm (about 100 Å to about 10,000 Å), and for example, about 10 nm to about 100 nm (about 100 Å to about 1,000 Å), and the thickness of the hole transport layer may be in a range of about 5 nm to about 200 nm (about 50 Å to about 2,000 Å), and for example, about 10 nm to about 150 nm (about 100 Å to about 1,500 Å). While not wishing to be bound by theory, it is understood that when the thicknesses

of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for improving conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenum oxide; and a cyano group-containing compound, such as Compound HT-D1 or Compound HT-D2 below, but embodiments of the present disclosure are not limited thereto.

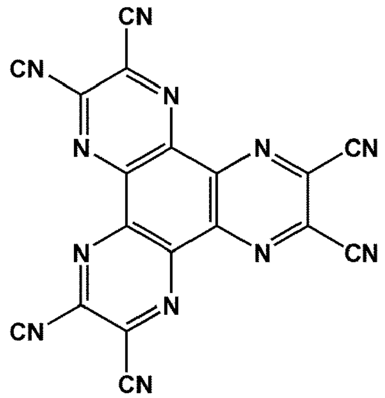

HT-D1

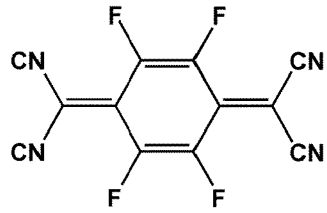

F4-TCNQ

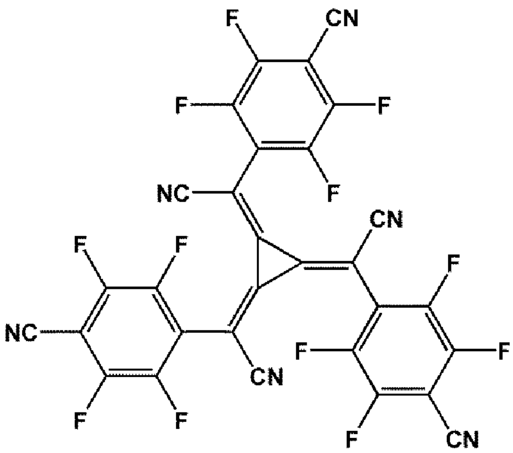

HT-D2

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied to form the hole injection layer although the deposition or coating conditions may vary according to the material that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1 or a composition containing the organometallic compound.

The host may include at least one selected from TPBi, TBADN, ADN (also referred to as "DNA"), CBP, CDBP, TCP, mCP, Compound H50, and Compound H51:

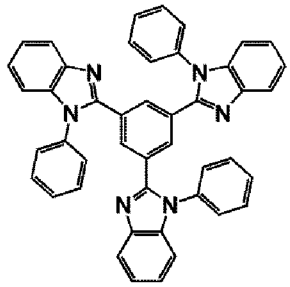

TPBi

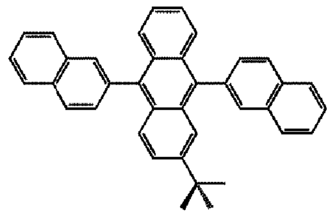

TBADN

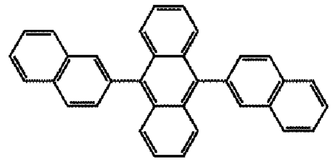

ADN

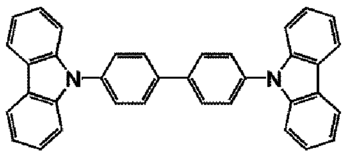

CBP

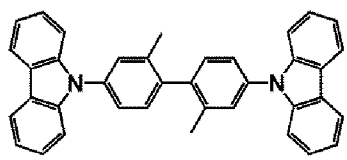

CDBP

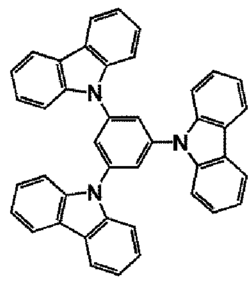

TCP

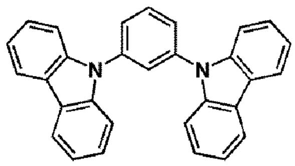

mCP

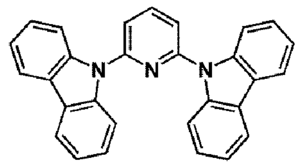

H50

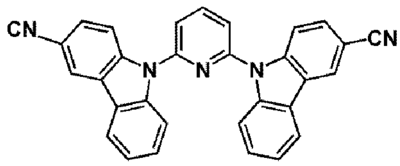

H51

.

When the organic light-emitting device is a full-color organic light-emitting device, the emission layer may be patterned into a red emission layer, a green emission layer, and a blue emission layer. In one or more embodiments, due to a stack structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host, but embodiments of the present disclosure are not limited thereto.

The dopant may include at least one of organometallic compounds represented by Formula 1 or a composition containing the organometallic compound.

A thickness of the emission layer may be in a range of about 10 nm to about 100 nm (about 100 Å to about 1,000 Å), for example, about 20 nm to about 60 nm (about 200 Å to about 600 Å). While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include at least one selected from a hole blocking layer, an electron transport layer, and an electron injection layer.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto.

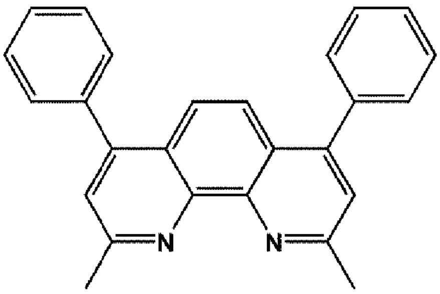

BCP

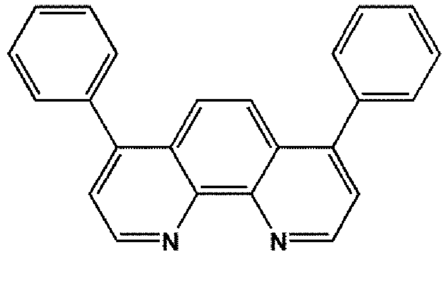

Bphen

A thickness of the hole blocking layer may be in a range of about 2 nm to about 100 nm (about 20 Å to about 1,000 Å), for example, about 3 nm to about 30 nm (about 30 Å to about 300 Å). While not wishing to be bound by theory, it is understood that when the thickness of the hole blocking layer is within these ranges, the hole blocking layer may have improved hole blocking ability without a substantial increase in driving voltage.

The electron transport layer may include at least one selected from BCP, Bphen, $Alq_3$, BAlq, TAZ, and NTAZ.

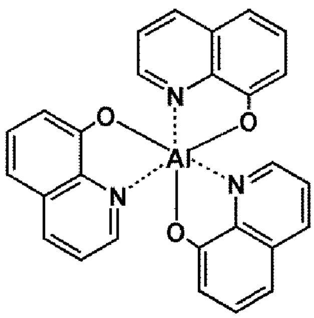

$Alq_3$

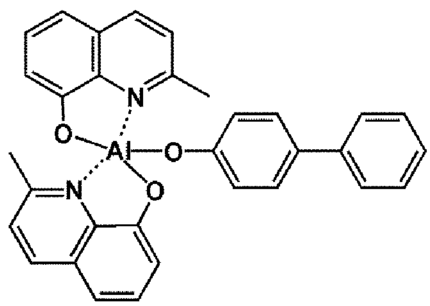

BAlq

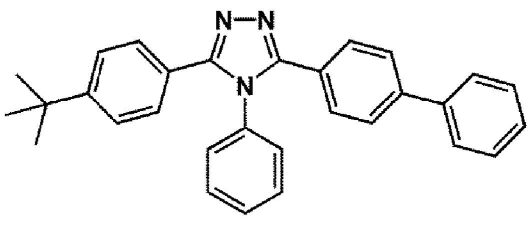

TAZ

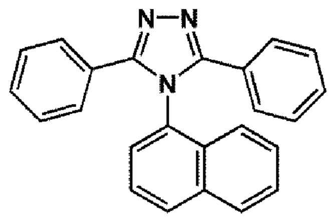

NTAZ

In one or more embodiments, the electron transport layer may include at least one of ET1 to ET19, but embodiments of the present disclosure are not limited thereto:

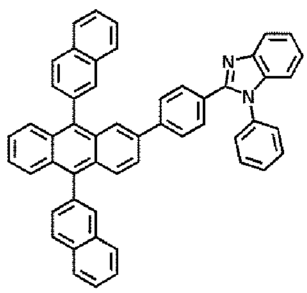

ET1

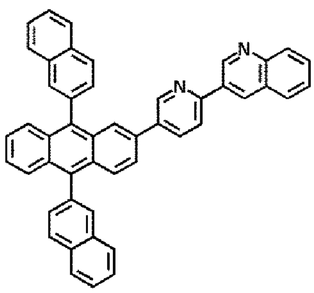

ET2

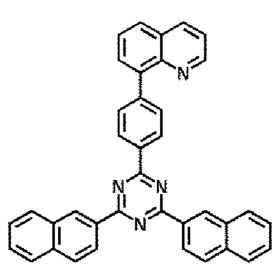

ET3

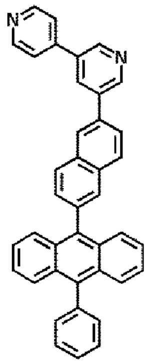

**ET4**

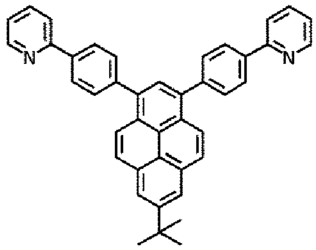

**ET5**

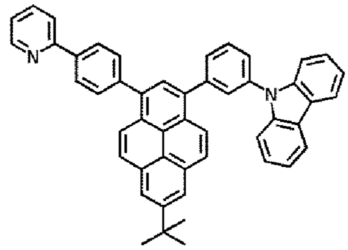

**ET6**

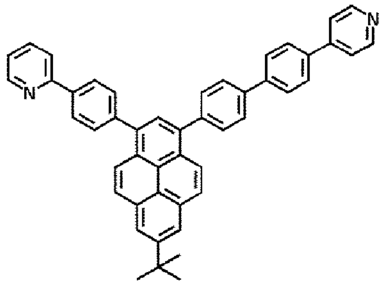

**ET7**

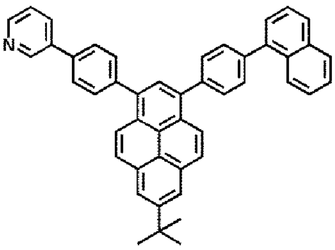

**ET8**

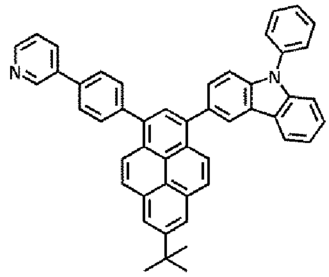

**ET9**

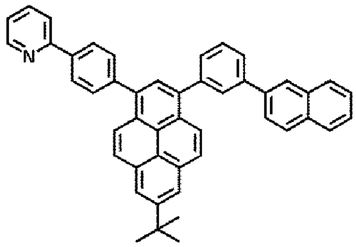

**ET10**

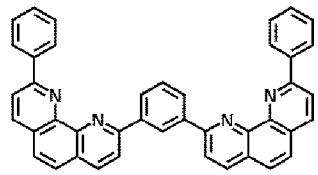

**ET11**

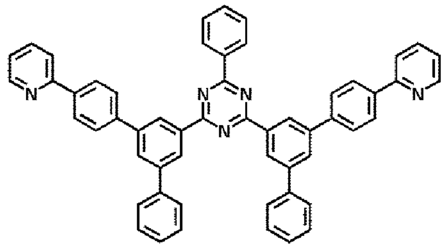

**ET12**

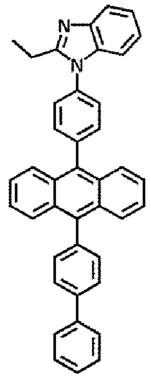

**ET13**

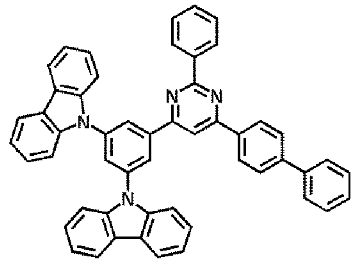

**ET14**

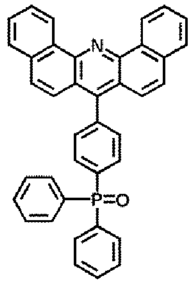

**ET15**

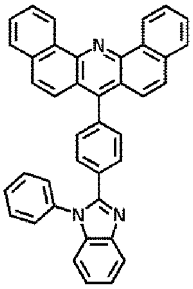
ET16

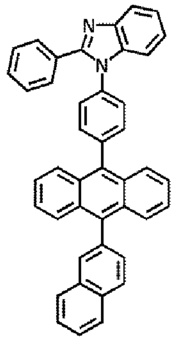
ET17

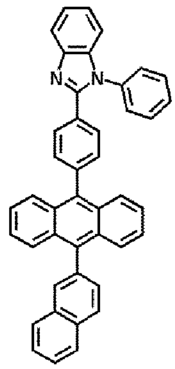
ET18

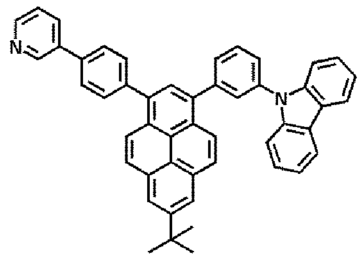
ET19
.

A thickness of the electron transport layer may be in a range of about 10 nm to about 100 nm (about 100 Å to about 1,000 Å), for example, about 15 nm to about 50 nm (about 150 Å to about 500 Å). While not wishing to be bound by theory, it is understood that when the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2.

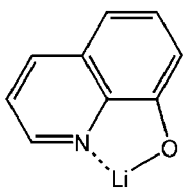
ET-D1

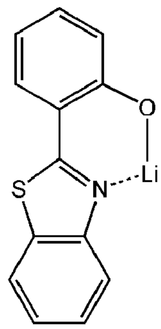
ET-D2

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 0.1 nm to about 10 nm (about 1 Å to about 100 Å), for example, about 0.3 nm to about 9 nm (about 3 Å to about 90 Å). While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 4, but embodiments of the present disclosure are not limited thereto.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by -$OA_{101}$ (wherein $A_{101}$ is the $C_1$-$C_{60}$ alkyl group), and non-limiting examples thereof include a methoxy group, an ethoxy group, and an isopropyloxy group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent hydrocarbon monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and a $C_6$-$C_{60}$ arylene group as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a heterocyclic aromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having a heterocyclic aromatic system that has at least one heteroatom selected from N, O, P, Si, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates -$OA_{102}$ (wherein $A_{102}$ is the $C_6$-$C_{60}$ aryl group), a $C_6$-$C_{60}$ arylthio group as used herein indicates -$SA_{103}$ (wherein $A_{103}$ is the $C_6$-$C_{60}$ aryl group), and the term "$C_7$-$C_{60}$ arylalkyl group" as used herein indicates -$A_{104}A_{105}$ (wherein $A_{104}$ is the $C_6$-$C_{59}$ aryl group and $A_{105}$ is the $C_1$-$C_{53}$ alkyl group).

The term "$C_1$-$C_{60}$ heteroaryloxy group" as used herein refers to -$OA_{106}$ (wherein $A_{106}$ is the $C_1$-$C_{60}$ heteroaryl group), and the term "$C_1$-$C_{60}$ heteroarylthio group" as used herein indicates -$SA_{107}$ (wherein $A_{107}$ is the $C_1$-$C_{60}$ heteroaryl group).

The term "$C_2$-$C_{60}$ heteroarylalkyl group" as used herein refers to -$A_{108}A_{109}$ ($A_{109}$ is a $C_1$-$C_{59}$ heteroaryl group, and $A_{108}$ is a $C_1$-$C_{59}$ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent

group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The term "$C_5$-$C_{30}$ carbocyclic group" as used herein refers to a monocyclic group or a polycyclic group, and, according to its chemical structure, a monovalent, divalent, trivalent, tetravalent, pentavalent, or hexavalent group.

The term "$C_2$-$C_{30}$ heterocyclic group" as used herein refers to a saturated or unsaturated cyclic group having, as a ring-forming atom, at least one heteroatom selected from N, O, Si, P, and S other than 2 to 30 carbon atoms. The term "$C_2$-$C_{30}$ heterocyclic group" as used herein refers to a monocyclic group or a polycyclic group, and, according to its chemical structure, a monovalent, divalent, trivalent, tetravalent, pentavalent, or hexavalent group.

At least one substituent of the substituted $C_5$-$C_{30}$ carbocyclic group, substituted $C_2$-$C_{30}$ heterocyclic group, substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, and substituted monovalent non-aromatic condensed heteropolycyclic group may be selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a C1-$C_{60}$ alkoxy group, each substituted with at least one selected from deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$,$-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a C1-C60 heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_{21}$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and$-P(=O)(Q_{28})(Q_{29})$; and

$$-N(Q_{31})(Q_{32}),\ -Si(Q_{33})(Q_{34})(Q_{35}),\ -B(Q_{36})(Q_{37}),\ \text{and}\ -P(=O)(Q_{36})(Q_{39}),$$

wherein $Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amino group, an amidino group, a hydrazine group,

a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

When a group containing a specified number of carbon atoms is substituted with any of the groups listed in the preceding paragraph, the number of carbon atoms in the resulting "substituted" group is defined as the sum of the carbon atoms contained in the original (unsubstituted) group and the carbon atoms (if any) contained in the substituent. For example, when the term "substituted $C_1$-$C_{30}$ alkyl" refers to a $C_1$-$C_{30}$ alkyl group substituted with $C_6$-$C_{30}$ aryl group, the total number of carbon atoms in the resulting aryl substituted alkyl group is $C_7$-$C_{60}$.

Hereinafter, a compound and an organic light-emitting device according to embodiments are described in detail with reference to Examples. However, the organic light-emitting device is not limited thereto. The wording "B was used instead of A" used in describing Synthesis Examples means that an amount of A used was identical to an amount of B used, in terms of a molar equivalent.

Example

Synthesis Example 1: Synthesis of Compound 1

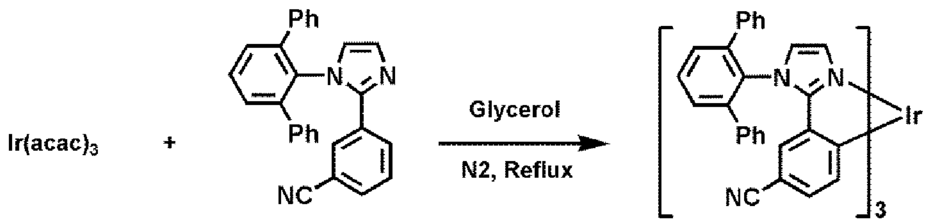


Ligand 1 Compound 1

3.29 mmol of $Ir(acac)_3$, 16.47 mmol of Ligand 1, and glycerol were added to a reaction vessel, and the mixture was refluxed for 12 hours in a nitrogen atmosphere. After the reaction was completed, the resultant mixture was cooled to room temperature, and the organic layer was separated by adding dichloromethane and distilled water. The organic layer was washed twice with distilled water, dried using $MgSO_4$, and the solvent was removed under reduced pressure. The crude product was purified by silica gel column chromatography (eluent: dichloromethane and n-hexane) to obtain 0.51 mmol of Compound 1. The structure and purity (99% or more) of Compound 1 were determined using NMR, HPLC, and LCMS.
1H-NMR (300 MHz, $CD_2Cl_2$) $\delta$ 7.8 (1H, t), 7.7-7.55(2H, m), 7.1-6.7(10.5H, m), 6.6(1H, s), 6.55-6.4 (2H, m).

Synthesis Example 2: Synthesis of Compound 2

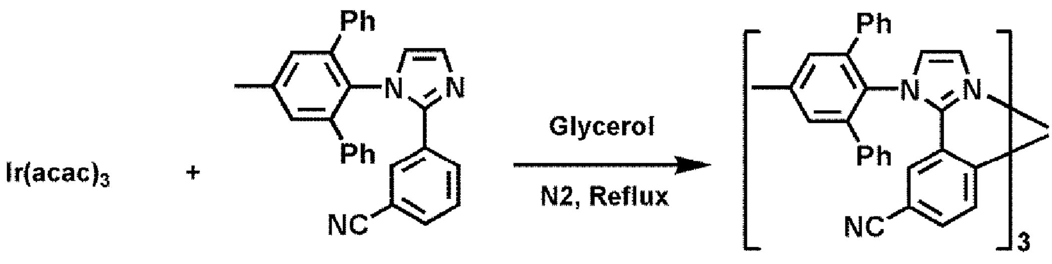


Ligand 2

Compound 2

0.50 mmol of Compound 2 was synthesized in the same manner as in Synthesis Example 1, except that Ligand 2 was used instead of Ligand 1. The structure and purity (99% or more) of Compound 2 were determined using NMR, HPLC, and LCMS.

1H-NMR (300 MHz, $CD_2Cl_2$) $\delta$ 7.50 (1H, s), 7.45(1H, s), 7.15-6.88(3H, m), 6.86-6.84(3H, m), 6.82-6.72 (5H, m), 6.68(1H, s), 6.46-6.42(2H, m), 5.46 (1H, s), 2.59(3H, s)

Synthesis Example 3: Synthesis of Compound 3

Synthesis of Ligand 3

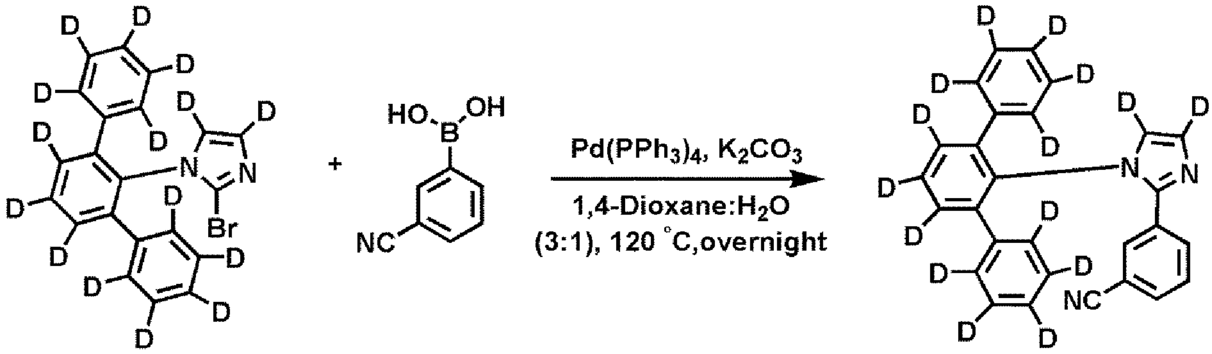


Intermediate 3

Ligand 3

14 mmol (5.5 g) of Intermediate 3, 14 mmol of 3-cyano-phenylboronic acid, 0.45 mmol (0.52 g) of tetrakis-(triphenylphosphine)palladium(0), and 45 mmol (6.21 g) of potassium carbonate were mixed with 120 ml of a mixture of 1,4-dioxane and water (volume ratio: 3:1), and the mixture was refluxed at a temperature of 120°C for overnight. The reaction mixture was cooled, and the product was extracted with ethyl acetate and water. The organic layer was washed three times with water, dried using magnesium sulfate, and the solvent was removed under reduced pressure. The crude product obtained therefrom was purified by silica gel column chromatography (eluent: dichloromethane and hexane), thereby obtaining 7 mmol (3.0 g) of Ligand 3. The structure and purity (99.73% or more) of Ligand 3 were determined using NMR, HPLC, and LCMS. As a result of the NMR analysis, it was determined that the deuterium substitution rate was 79% or more.

1H-NMR (300 MHz, $CD_2Cl_2$) $\delta$ 7.7 (0.11H, s), 7.6(1H, m), 7.7-7.2(3H, m), 6.99(0.11H, s), 6.9 (2H, s), 6.8(0.1H, s)

Synthesis of Compound 3

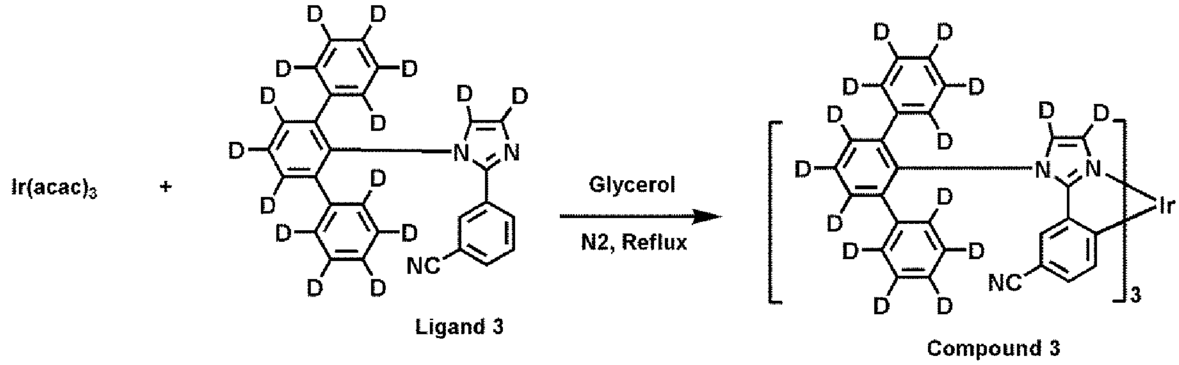


Ligand 3

Compound 3

0.55 mmol of Compound 3 was synthesized in the same manner as in Synthesis Example 1, except that Ligand 3 was used instead of Ligand 1. The structure and purity (99% or more) of Compound 3 were determined using NMR, HPLC, and LCMS.

1H-NMR (300 MHz, $CD_2Cl_2$) δ 7.80 (0.10 H, s), 7.70(0.08 H, s), 7.50 (0.08H, s), 7.10 (0.13H, 7.00(1H, s), 6.91(0.10H, s), 6.88(0.24H, t), 6.85(1H, s), 6.80-6.75(0.24H, m), 6.60(1H, s), 6.50(0.18H, s), 6.40(1H, d), 5.45 (0.24H, s)

Synthesis Example 4: Synthesis of Compound 4

Synthesis of Ligand 4

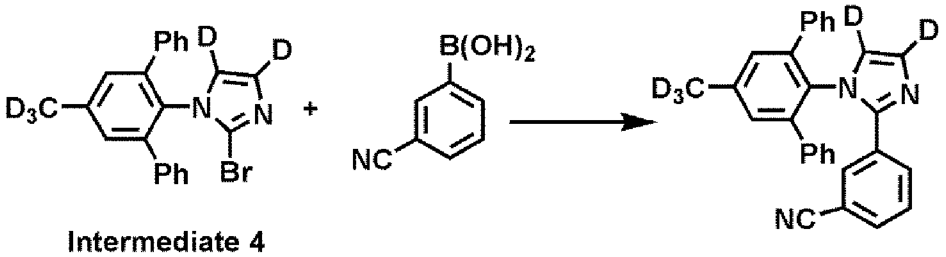

Intermediate 4

Ligand 4

Ligand 4 was synthesized in the same manner as in Synthesis of Ligand 3 in Synthesis Example 3, except that Intermediate 4 was used instead of Intermediate 3. The structure and deuterium substitution rate of Ligand 4 were determined using NMR, HPLC, and LCMS.

1H-NMR (300 MHz, $CD_2Cl_2$) δ 7.5 (0.36 H, d), 7.4-7.1(1.33H, m), 7-6.7(1H, m), 2.5 (0.16H, s)

Synthesis of Compound 4

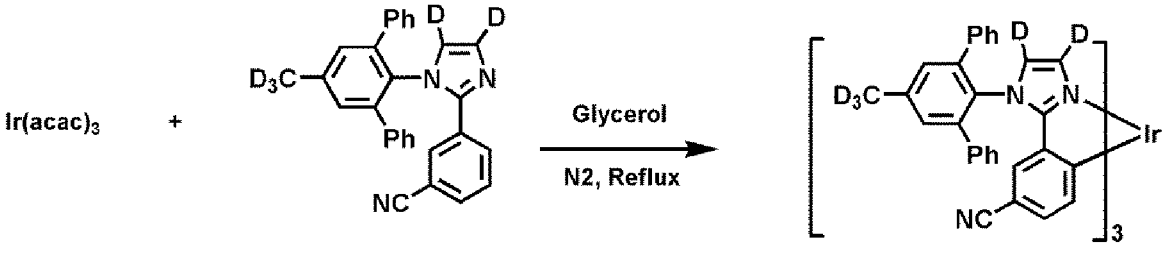


Ligand 4

Compound 4

0.53 mmol of Compound 4 was synthesized in the same manner as in Synthesis Example 1, except that Ligand 4 was used instead of Ligand 1. The structure and purity (99% or more) of Compound 4 were determined using NMR,

HPLC, and LCMS.

1H-NMR (300 MHz, $CD_2Cl_2$) δ 7.47 (0.1 H, s), 7.38 (0.1 H, s), 7.10-6.65(4.2H, m), 6.46 (1H, m), 5.5 (0.2H, s), 2.57 (0.39H, s)

Synthesis Example 5: Synthesis of Compound 5

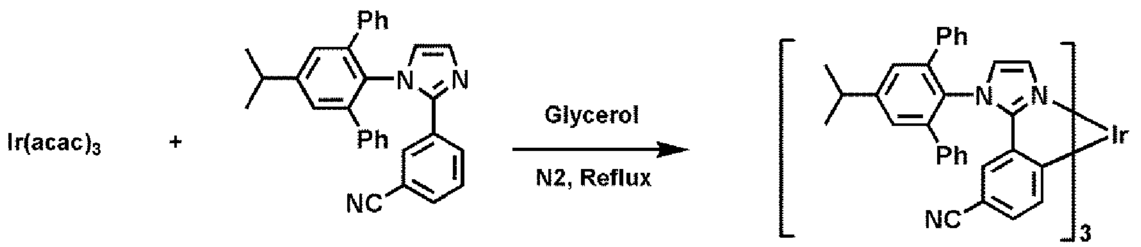


Ligand 5

Compound 5

0.50 mmol of Compound 5 was synthesized in the same manner as in Synthesis Example 1, except that Ligand 5 was used instead of Ligand 1. The structure and purity (99% or more) of Compound 5 were determined using NMR, HPLC, and LCMS.

1H-NMR (300 MHz, $CD_2Cl_2$) δ 7.50 (1H, s), 7.45(1H, s), 7.2-6.8(11.2H, m), 6.7-6.6 (3H, m), 5.46 (1H, s), 3.2(1H, m), 1.4(6H, d)

Synthesis Example 6: Synthesis of Compound 6

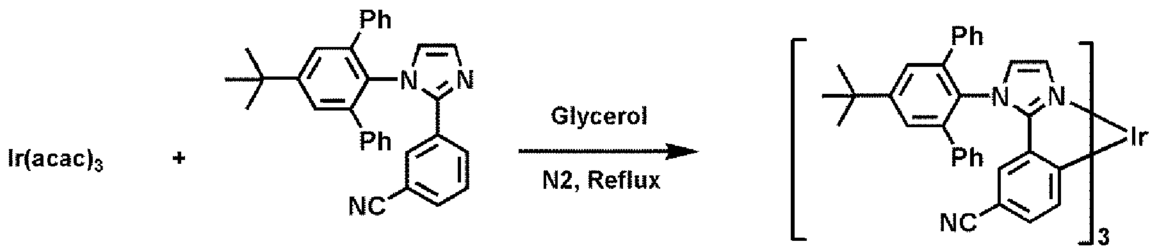


Ligand 6

Compound 6

0.51 mmol of Compound 6 was synthesized in the same manner as in Synthesis Example 1, except that Ligand 6 was used instead of Ligand 1. The structure and purity (99% or more) of Compound 6 were determined using NMR, HPLC, and LCMS.

1H-NMR (300 MHz, $CD_2Cl_2$) δ 7.65 (1H, s), 7.56(1H, s), 7.2-7.0(3H, m), 6.9-6.6 (8H, m), 5.4 (1H, s), 1.47(9H, s)

Synthesis Example 7: Synthesis of Compound 7

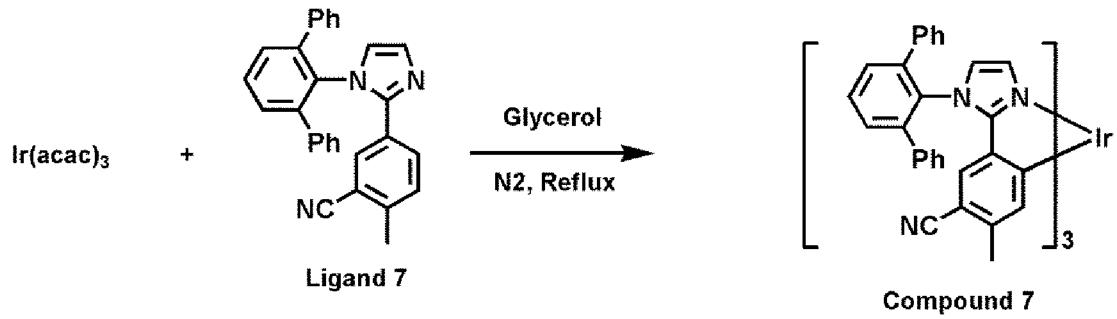


Ligand 7

Compound 7

0.53 mmol of Compound 7 was synthesized in the same manner as in Synthesis Example 1, except that Ligand 7 was used instead of Ligand 1. The structure and purity (99% or more) of Compound 7 were determined using NMR, HPLC, and LCMS.
1H-NMR (300 MHz, $CD_2Cl_2$) δ 7.50 (1H, s), 7.45(1H, s), 7.15-6.88(3H, m), 6.86-6.84(3H, m), 6.82-6.72 (5H, m), 6.68(1H, s), 6.46-6.42(2H, m), 5.46 (1H, s), 2.60(3H, s)

Synthesis Example 8: Synthesis of Compound 8

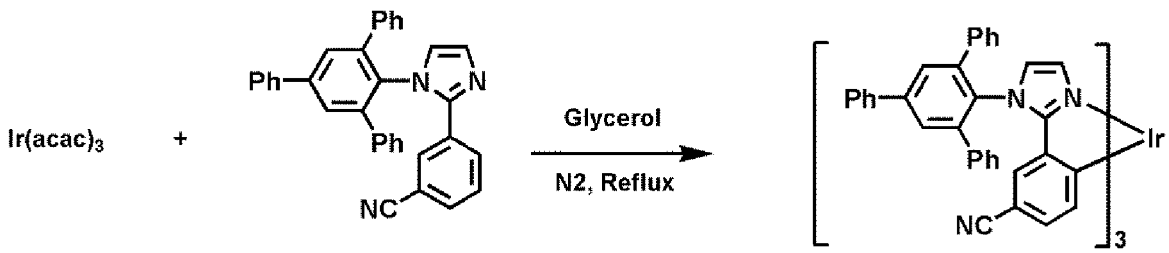


Ligand 8

Compound 8

0.48 mmol of Compound 8 was synthesized in the same manner as in Synthesis Example 1, except that Ligand 8 was used instead of Ligand 1. The structure and purity (99% or more) of Compound 8 were determined using NMR, HPLC, and LCMS.
1H-NMR (300 MHz, $CD_2Cl_2$) δ 7.8 (1H, s), 7.7(2H, d), 7.6-7.5(2H, m), 7.5-7.4(1H, m), 7.1-7.0 (3H, t), 7.0-6.9(5H, m), 6.9-6.8(4H, m), 6.55 (1H, s), 6.5-6.4(1H, m), 5.5(1H,s)

Synthesis Example 9: Synthesis of Compound 9

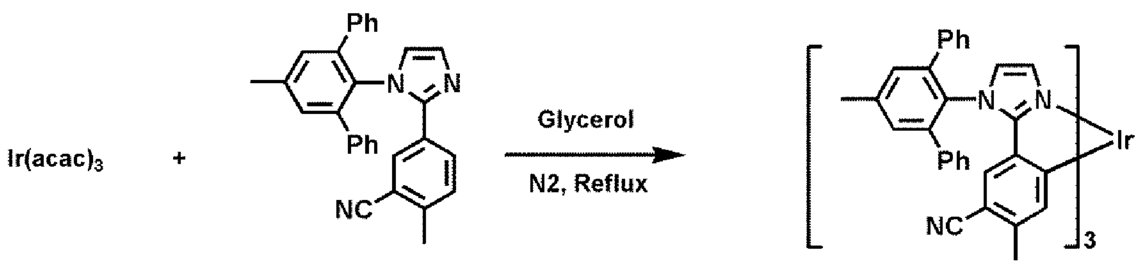


Ligand 9

Compound 9

0.5 mmol of Compound 9 was synthesized in the same manner as in Synthesis Example 1, except that Ligand 9 was used instead of Ligand 1. The structure and purity (99% or more) of Compound 9 were determined using NMR, HPLC, and LCMS.
1H-NMR (300 MHz, $CD_2Cl_2$) δ 7.50-7.45 (2H, d), 7.15-6.9(3H, m), 6.85-6.7(5H, m), 6.7-6.65 (2H, m), 6.6(1H, s), 6.4(2H,

s), 5.5(1H, s), 2.6(3H, s), 2.2(3H, s)

Evaluation Example 1: Evaluation of HOMO, LUMO, and Triplet ($T_1$) Energy Level

The HOMO energy levels, LUMO energy levels, and $T_1$ energy levels of Compounds 1 to 9, E, and F were evaluated using the methods provided in Table 2. Results thereof are shown in Table 3.

Table 2

| | |
|---|---|
| HOMO energy level evaluation method | After a voltage-current (V-A) graph of each Compound is obtained by using cyclic voltammetry (CV) (electrolyte: 0.1 molar (M) $Bu_4NClO_4$ / solvent: $CH_2Cl_2$ / electrode: three-electrode system (working electrode: GC, reference electrode: Ag/AgCl, auxiliary electrode: Pt)), the HOMO energy level of each Compound is calculated from onset reduction potential of the V-A graph. |
| LUMO energy level evaluation method | After each Compound is diluted with $CHCl_3$ to a concentration of $1x10^{-5}$ M and a UV absorption spectrum is measured at room temperature by using a Shimadzu UV-350 Spectrometer, the LUMO energy level of each Compound is calculated by using an optical band gap (Eg) from an edge of the UV absorption spectrum. |
| $T_1$ energy level evaluation method | After a mixture of toluene and each Compound (1 mg of each Compound is dissolved in 3 cc of toluene) is added to a quartz cell and then added to liquid nitrogen (77 Kelvins, K), a photoluminescence (PL) spectrum is measured by using a PL measurement apparatus. The $T_1$ energy level is calculated through analysis of a peak alone observed only at a low temperature by comparing the PL spectrum with a general room-temperature PL spectrum. |

Table 3

| Compound No. | HOMO (eV) | LUMO (eV) | $T_1$ (eV) |
|---|---|---|---|
| 1 | -5.26 | -2.60 | 2.66 |
| 2 | -5.24 | -2.57 | 2.67 |
| 3 | -5.26 | -2.60 | 2.66 |
| 4 | -5.24 | -2.57 | 2.67 |
| 5 | -5.28 | -2.62 | 2.66 |
| 6 | -5.26 | -2.60 | 2.66 |
| 7 | -5.20 | -2.52 | 2.68 |
| 8 | -5.26 | -2.60 | 2.66 |
| 9 | -5.14 | -2.45 | 2.69 |
| E | -5.28 | -3.03 | 2.48 |
| F | -5.32 | -3.06 | 2.47 |

It can be confirmed from Table 3 that Compounds 1 to 9 have electrical characteristics suitable for use as materials for an organic light-emitting device. For example, it can be confirmed that Compounds 1 to 9 have relatively higher triplet energy levels than Compounds E and F.

Evaluation Example 2: Evaluation of PL Spectrum

Light emission characteristics of each Compound were evaluated by evaluating PL spectra of Compounds 1 to 9, E, and F. Compound 1 was diluted with $CHCl_3$ to a concentration of 10 millimolar (mM), and a PL spectrum was measured at room temperature by using ISC PC1 Spectrofluorometer with a xenon lamp. This process was repeated on Compounds 2 to 9, E, and F.

Maximum wavelengths of the PL spectra of Compounds 1 to 9, E, and F are shown in Table 4.

Table 4

| Compound No. | $\lambda_{max}$ (nm) |
|---|---|
| 1 | 466 |
| 2 | 464 |
| 3 | 466 |
| 4 | 464 |
| 5 | 466 |
| 6 | 466 |
| 7 | 463 |
| 8 | 466 |
| 9 | 461 |
| E | 500 |
| F | 502 |

Referring to Table 4, compounds (Compounds 1 to 9), in which a cyano group is substituted at a para-position with respect to an Ir-carbon bond (Compound 1 to 9), exhibit a maximum emission wavelength of 470 nanometers (nm) or less (for example, 466 nm or less). On the other hand, compounds (Compounds E and F), in which a cyano group is not substituted at a para-position with respect to an Ir-carbon bond, exhibit a maximum emission wavelength greater than 470 nm. It can be seen from these results that deep blue light emission is provided when the cyano group is substituted at the para-position with respect to the Ir-carbon bond. It can be confirmed from Table 4 that Compounds 1 to 9 have excellent light emission characteristics.

Evaluation Example 3: Evaluation of NPA Charge Value and Open Fraction Value

The NPA charge values of Compounds 1 to 9 and A to F were evaluated by using a DFT method of a Gaussian program that was structurally optimized at a level of B3LYP/6-31G(d,p). Results thereof are shown in Table 5 below. Also, the open fraction value of an atom A of each of Compounds 1 to 9 and A to F (the position of the atom A of each Compound refers to the position of the atom A marked in Compound 1) was evaluated based on Equation 1. Results thereof are shown in Table 5.

Table 5

| Compound No. | NPA charge value | Open fraction value |
|---|---|---|
| 1 | 0.4651 | 0.4695 |
| 2 | 0.4654 | 0.4428 |
| 3 | 0.4651 | 0.4695 |
| 4 | 0.4654 | 0.4428 |
| 5 | 0.4728 | 0.4609 |
| 6 | 0.4744 | 0.4581 |
| 7 | 0.4677 | 0.4645 |
| 8 | 0.4579 | 0.4611 |
| 9 | 0.4679 | 0.4650 |
| A | 0.5003 | 0.5488 |
| B | 0.4943 | 0.5006 |
| C | 0.5011 | 0.4941 |
| D | 0.4740 | 0.5030 |
| E | 0.4984 | 0.3654 |
| F | 0.5010 | 0.4880 |

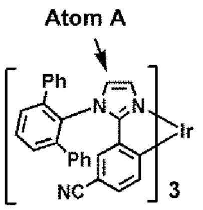


1

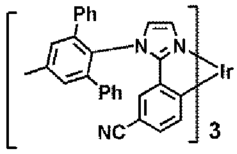

2

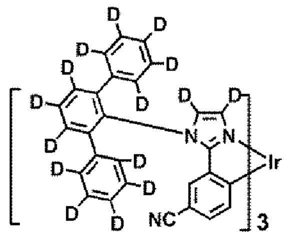

3

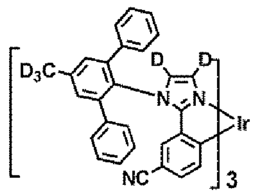

4

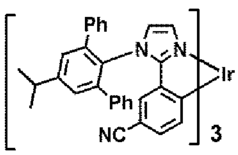

5

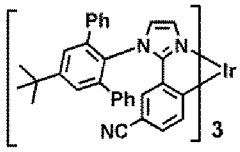

6

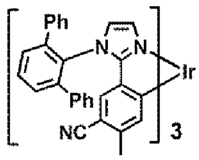

7

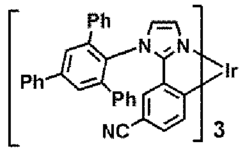

8

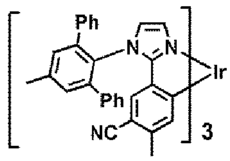

9

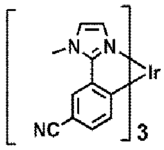

A

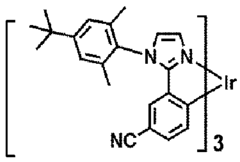

B

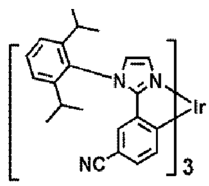

C

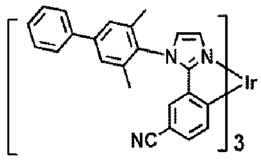

D

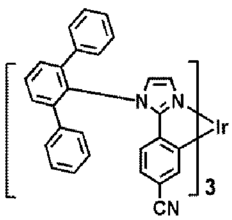

E

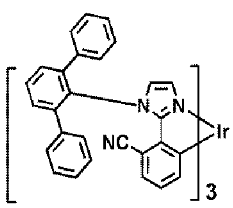

F

Referring to Table 5, it can be confirmed that Compounds 1 to 9 have relatively small NPA charge values and open fraction values at the same time, as compared with Compounds A to F.

Example 1

A glass substrate, on which an ITO electrode (first electrode, anode) having a thickness of 150 nm (1,500 Å) was formed, was sonicated with distilled water. After the sonicating with distilled water was completed, the glass substrate was ultrasonically cleaned by sequentially using isopropyl alcohol, acetone, and methanol, was dried, and then transferred to a plasma cleaner. Then, the glass substrate was cleaned for 5 minutes by using oxygen plasma and was provided to a vacuum deposition apparatus.

Compound HT3 was vacuum-deposited on the ITO electrode of the glass substrate to form a first hole injection layer having a thickness of 350 nm (3,500 Å), Compound HT-D1 was vacuum-deposited on the first hole injection layer to form a second hole injection layer having a thickness of 30 nm (300 Å), and TAPC was vacuum-deposited on the second hole injection layer to form an electron blocking layer having a thickness of 10 nm (100 Å), thereby forming a hole transport region.

mCP (host) and Compound 1 (dopant, 7 wt%) were co-deposited on the hole transport region to form an emission layer having a thickness of 30 nm (300 Å).

Compound ET3 was vacuum-deposited on the emission layer to form an electron transport layer having a thickness of 25 nm (250 Å), ET-D1 (LiQ) was deposited on the electron transport layer to form an electron injection layer having a thickness of 0.5 nm (5 Å), and Al was deposited on the electron injection layer to form a second electrode (cathode) having a thickness of 100 nm (1,000 Å), thereby completing the manufacture of an organic light-emitting device.

Examples 2 to 9 and Comparative Examples 1 to 4

Organic light-emitting devices of Examples 2 to 9 and Comparative Examples 1 to 4 were manufactured in the same manner as in Example 1, except that Compounds shown in Table 6 were each used instead of Compound 1 as a dopant in forming an emission layer.

Evaluation Example 4: Evaluation of Characteristics of Organic Light-emitting Devices

An EL spectrum, a change in current density according to voltage, a change in luminance according to voltage, conversion efficiency, lifespan, and CIE color coordinates were measured with respect to the organic light-emitting devices manufactured according to Examples 1 to 9 and Comparative Examples 1 to 4. Specific measurement methods are as follows, and results thereof are shown in Table 6.

(1) Measurement of EL Spectrum

The EL spectra of the manufactured organic light-emitting devices were measured by using a luminance meter (Minolta Cs-1000A) at a luminance of 500 candelas per square meter (cd/$m^2$).

(2) Measurement of Change in Current Density According to Voltage

A current value flowing through the manufactured organic light-emitting devices was measured by using a current-voltage meter (Keithley 2400) with respect to the manufactured organic light-emitting devices while increasing a voltage from 0 volts (V) to 10 V, and a current density was obtained by dividing the measured current value by an area.

(3) Measurement of Change in Luminance According to Voltage

Luminance was measured by using a luminance meter (Minolta Cs-1000A) with respect to the manufactured organic light-emitting devices while increasing a voltage from 0 V to 10 V.

(4) Measurement of Conversion Efficiency

Current efficiency (cd/A) of the same current density (10 milliamperes per square centimeter, mA/$cm^2$) was calculated by using the luminance and the current density measured from (2) and (3) and the voltage. Then, conversion efficiency was calculated by dividing the current efficiency by a y value of CIE color coordinates measured in (6).

(5) Measurement of Lifespan

An amount of time ($T_{95}$) that lapsed when luminance measured from (3) was 95% ($T_{95}$) of initial luminance (100%) was calculated.

(6) Measurement of CIE Color Coordinates

CIE color coordinates were obtained by measuring EL spectra of the manufactured organic light-emitting devices at a luminance of 500 candelas per square meter (cd/$m^2$) by using a luminance meter (Minolta Cs-1000A).

Table 6

| | Emission layer | | Current density (mA/$cm^2$) | Luminance (cd/$m^2$) | Efficiency* (%) | $T_{95}$* (%) | $\lambda_{max}$ in EL spectrum (nm) | Color coordinates (x, y) |
|---|---|---|---|---|---|---|---|---|
| | Host | Dopant | | | | | | |
| Example 1 | mCP | 1 | 10 | 500 | 103 | 350 | 465 | (0.17,0.33) |
| Example 2 | mCP | 2 | 10 | 500 | 105 | 320 | 465 | (0.17,0.32) |

(continued)

| | Emission layer | | Current density ($mA/cm^2$) | Luminance ($cd/m^2$) | Efficiency* (%) | $T_{95}$* (%) | $\lambda_{max}$ in EL spectrum (nm) | Color coordinates (x, y) |
|---|---|---|---|---|---|---|---|---|
| | Host | Dopant | | | | | | |
| Example 3 | mCP | 3 | 10 | 500 | 103 | 400 | 465 | (0.17,0.33) |
| Example 4 | mCP | 4 | 10 | 500 | 105 | 370 | 465 | (0.17,0.32) |
| Example 5 | mCP | 5 | 10 | 500 | 106 | 250 | 465 | (0.17,0.32) |
| Example 6 | mCP | 6 | 10 | 500 | 106 | 280 | 465 | (0.17,0.32) |
| Example 7 | mCP | 7 | 10 | 500 | 101 | 220 | 462 | (0.17,0.30) |
| Example 8 | mCP | 8 | 10 | 500 | 100 | 300 | 466 | (0.18,0.34) |
| Example 9 | mCP | 9 | 10 | 500 | 100 | 210 | 462 | (0.17,0.30) |
| Comparative Example 1 | mCP | A | 10 | 500 | 95 | 30 | 460 | (0.17,0.26) |
| Comparative Example 2 | mCP | B | 10 | 500 | 105 | 80 | 462 | (0.17,0.30) |
| Comparative Example 3 | mCP | C | 10 | 500 | 100 | 100 | 460 | (0.17,0.26) |
| Comparative Example 4 | mCP | D | 10 | 500 | 102 | 115 | 464 | (0.18,0.31) |
| Efficiency*, $T_{95}$* : Relative values of efficiency and $T_{95}$ of with respect to those Comparative Example 3 | | | | | | | | |

From Table 6, it can be confirmed that the organic light-emitting devices of Examples 1 to 9 emit deep blue light having excellent color purity and have remarkably improved lifespan characteristics, as compared with the organic light-emitting devices of Comparative Examples 1 to 4.

The organometallic compound according to embodiments has excellent electrical characteristics and thermal stability. Accordingly, an organic light-emitting device including the organometallic compound may have excellent driving voltage, current density, efficiency, power, color purity, and lifespan characteristics.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present disclosure as defined by the following claims.

## Claims

**1.** An organometallic compound represented by Formula 1:

Formula 1

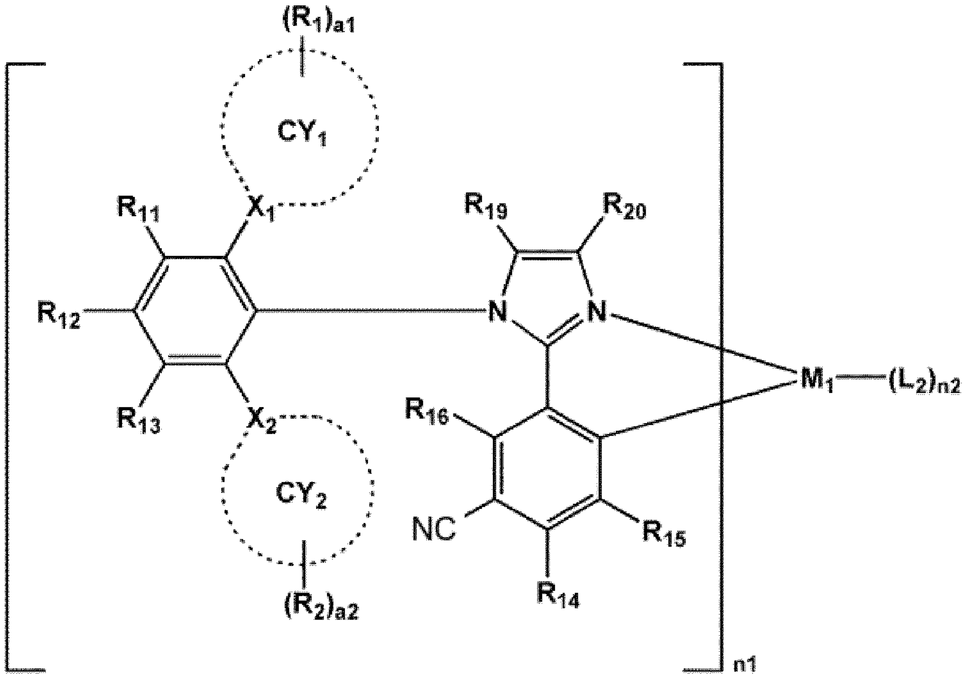

wherein, in Formula 1,

$M_1$ is selected from a first-row transition metal of the Periodic Table of Elements, a second-row transition metal of the Periodic Table of Elements, and a third-row transition metal of the Periodic Table of Elements,
n1 is 1, 2, or 3,
$L_2$ is selected from ligands represented by Formulae 3A to 3C, 3E and 3F:

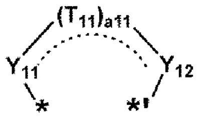
Formula 3A

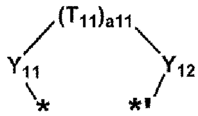
Formula 3B

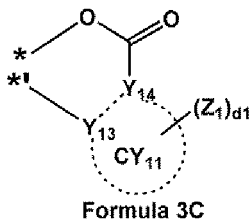
Formula 3C

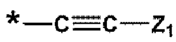
Formula 3E

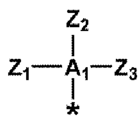
Formula 3F

n2 is 0, 1, 2, 3, or 4, wherein, when n2 is two or more, two or more groups $L_2$ are identical to or different from each other,
$X_1$ and $X_2$ are each independently carbon or nitrogen,
$CY_1$ and $CY_2$ are each independently selected from a $C_5$-$C_{30}$ carbocyclic group and a $C_2$-$C_{30}$ heterocyclic group,
$Y_{11}$ is selected from O, N, $N(Z_1)$, $P(Z_1)(Z_2)$, and $As(Z_1)(Z_2)$,
$Y_{12}$ is selected from O, N, $N(Z_3)$, $P(Z_3)(Z_4)$, and $As(Z_3)(Z_4)$,
$CY_{11}$ is a $C_2$-$C_{30}$ heterocyclic group,
$T_{11}$ is each independently selected from a single bond, a double bond, $*-C(Z_{11})(Z_{12})-*'$, $*-C(Z_{11})=C(Z_{12})-*'$, $*=C(Z_{11})-*'$, $*-C(Z_{11})=*'$, $*=C(Z_{11})-C(Z_{12})=C(Z_{13})-*'$, $*-C(Z_{11})=C(Z_{12})-C(Z_{13})=*'$, $*-N(Z_{11})-*'$, and a substituted or unsubstituted $C_5$-$C_{30}$ carbocyclic group,

a11 is an integer from 1 to 10,
$Y_{13}$ and $Y_{14}$ are each independently carbon (C) or nitrogen (N), $Y_{13}$ and $Y_{14}$ are linked via a single bond or a double bond,
$A_1$ is P or As,
$R_1$, $R_2$, $R_{11}$ to $R_{16}$, $Z_1$ to $Z_4$ and $Z_{11}$ to $Z_{13}$ are each independently selected from hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted C1-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, and $-P(=O)(Q_8)(Q_9)$,
two or more neighboring groups of $R_1$, $R_2$, $R_{11}$ to $R_{13}$, $CY_1$, and $CY_2$ are optionally linked to form a substituted or unsubstituted $C_5$-$C_{30}$ carbocyclic group or a substituted or unsubstituted $C_2$-$C_{30}$ heterocyclic group,
a1 and a2 are each independently an integer from 0 to 5,
d1 is an integer from 0 to 10,
$R_{19}$ and $R_{20}$ are each independently selected from hydrogen, deuterium, a C1-$C_{30}$ alkyl group, a $C_1$-$C_{30}$ alkyl group substituted with at least one deuterium, a $C_6$-$C_{60}$ aryl group, and a $C_6$-$C_{60}$ aryl group substituted with at least one selected from a $C_1$-$C_{30}$ alkyl group and deuterium, and
wherein the substituents of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group are selected from:
deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl,-Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(O_{11})(O_{12})$,$-Si(Q_{13})(Q_{14})(Q_{15})$, $-B(O_{16})(O_{17})$, and $-P(=O)(O_{18})(O_{19})$;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group,

a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(O_{21})(O_{22})$, $-Si(Q_{23})(Q_{24})(Q_{25})$, $-B(Q_{26})(Q_{27})$, and-$P(=O)(O_{28})(O_{29})$; and

$$-N(Q_{31})(Q_{32}),\ -Si(Q_{33})(Q_{34})(Q_{35}),\ -B(Q_{36})(Q_{37}),\ \text{and}\ -P(=O)(O_{38})(O_{39}),$$

wherein $Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

**2.** The organometallic compound of claim 1, wherein
$M_1$ is Ir or Os, and the sum of n1 and n2 is 3 or 4; or
$M_1$ is Pt, and the sum of n1 and n2 is 2.

**3.** The organometallic compound of claim 1 or 2, wherein
$CY_1$ and $CY_2$ are each independently selected from a cyclopentene group, a cyclohexene group, a benzene group, a pyridine group, a pyrimidine group, a pyridazine group, a pyrazine group, a triazine group, a pyrrole group, a pyrazole group, an imidazole group, a triazole group, an oxazole group, an isoxazole group, an oxadiazole group, a thiazole group, an isothiazole group, and a thiadiazole group, and/or wherein
$R_1$, $R_2$, and $R_{11}$ to $R_{16}$ are each independently selected from:

hydrogen, deuterium, -F, a cyano group, a nitro group, $-SF_5$, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from deuterium, -F, $-CD_3$, $-CD_2H$, $-CDH_2$, $-CF_3$, $-CF_2H$, $-CFH_2$, a cyano group, a nitro group, a $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and

$-N(Q_1)(Q_2)$, $-Si(Q_3)(Q_4)(Q_5)$, $-B(Q_6)(Q_7)$, and $-P(=O)(Q_8)(Q_9)$,

wherein $Q_1$ to $Q_9$ are each independently selected from:

$-CH_3$, $-CD_3$, $-CD_2H$, $-CDH_2$, $-CH_2CH_3$, $-CH_2CD_3$, $-CH_2CD_2H$, $-CH_2CDH_2$,$CHDCH_3$, $-CHDCD_2H$, $-CHDCDH_2$, $-CHDCD_3$, $-CD_2CD_3$, $-CD_2CD_2H$, and $-CD_2CDH_2$;

an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a $C_1$-$C_{10}$ alkyl group, and a phenyl group.

**4.** The organometallic compound of any of claims 1 to 3, wherein
$R_1$, $R_2$, $R_{11}$ to $R_{16}$, $R_{19}$, and $R_{20}$ are each independently selected from:

hydrogen, deuterium, $-CH_3$, $-CD_3$, $-CD_2H$, $-CDH_2$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, $-CD_2CDH_2$, a phenyl group, and groups represented by Formulae 9-1 to 9-24; and
a phenyl group substituted with at least one selected from deuterium, $-CD_3$,$-CD_2H$, $-CDH_2$, and a $C_1$-$C_{10}$ alkyl group:

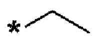
Formula 9-1

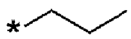
Formula 9-2

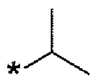
Formula 9-3

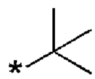
Formula 9-4

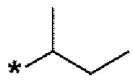
Formula 9-5

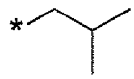
Formula 9-6

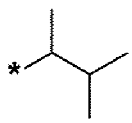
Formula 9-7

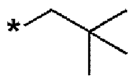
Formula 9-8

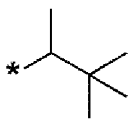
Formula 9-9

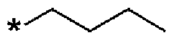
Formula 9-10

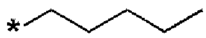
Formula 9-11

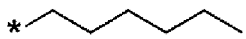
Formula 9-12

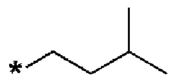
Formula 9-13

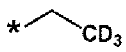
Formula 9-14

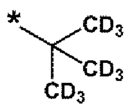
Formula 9-15

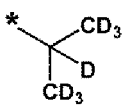
Formula 9-16

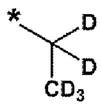
Formula 9-17

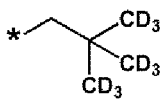
Formula 9-18

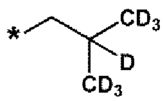
Formula 9-19

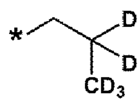
Formula 9-20

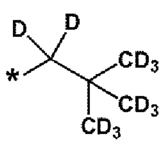
Formula 9-21

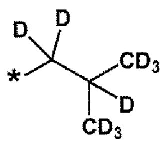
Formula 9-22

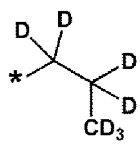
Formula 9-23

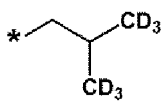
Formula 9-24

wherein * in Formulae 9-1 to 9-24 indicates a binding site to a neighboring atom.

**5.** The organometallic compound of any of claims 1 to 4, wherein
at least one of $R_1$, $R_2$, $R_{11}$ to $R_{16}$, $R_{19}$, and $R_{20}$ is a deuterium-containing substituent, and
the deuterium-containing substituent is selected from:

deuterium; and
a $C_1$-$C_{20}$ alkyl group and a phenyl group, each substituted with at least one deuterium, preferably wherein

the deuterium-containing substituent is selected from:

deuterium; and
a methyl group, an ethyl group, an n-propyl group, an iso-propyl group, an n-butyl group, a sec-butyl group, an iso-butyl group, a tert-butyl group, an n-pentyl group, an iso-pentyl group, a 1-methylbutyl group, a 2-methylbutyl group, a neo-pentyl group, a 1,2-dimethylpropyl group, a tert-pentyl group, and a phenyl group, each substituted with at least one deuterium.

**6.** The organometallic compound of any of claims 1 to 5, wherein at least one of $R_{12}$, $R_{14}$, $R_{19}$, and $R_{20}$ is selected from:

deuterium; and
a methyl group, an ethyl group, an n-propyl group, an iso-propyl group, an n-butyl group, a sec-butyl group, an iso-butyl group, a tert-butyl group, an n-pentyl group, an iso-pentyl group, a 1-methylbutyl group, a 2-methylbutyl group, a neo-pentyl group, a 1,2-dimethylpropyl group, a tert-pentyl group, and a phenyl group, each substituted with at least one deuterium, and/or wherein
$R_{12}$ and $R_{14}$ are each independently selected from:

hydrogen, deuterium, $-CH_3$, $-CD_3$, $-CD_2H$, $-CDH_2$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, $-CD_2CDH_2$, a phenyl group, and groups represented by Formulae 9-1 to 9-24; and
a phenyl group substituted with at least one selected from deuterium, $-CD_3$,$-CD_2H$, $-CDH_2$, and a $C_1$-$C_{10}$ alkyl group, and
$R_{19}$ and $R_{20}$ are each independently hydrogen or deuterium,

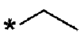
Formula 9-1

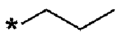
Formula 9-2

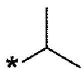
Formula 9-3

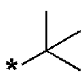
Formula 9-4

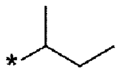
Formula 9-5

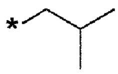
Formula 9-6

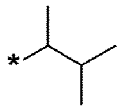
Formula 9-7

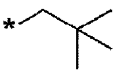
Formula 9-8

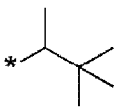
Formula 9-9

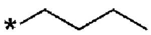
Formula 9-10

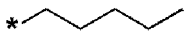
Formula 9-11

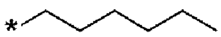
Formula 9-12

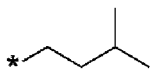
Formula 9-13

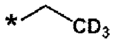
Formula 9-14

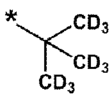
Formula 9-15

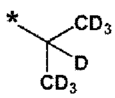
Formula 9-16

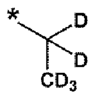
Formula 9-17

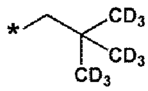
Formula 9-18

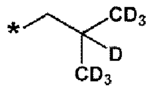
Formula 9-19

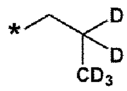
Formula 9-20

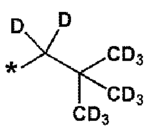
Formula 9-21

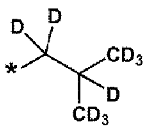
Formula 9-22

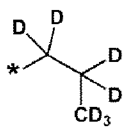
Formula 9-23

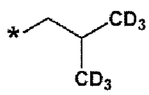
Formula 9-24

wherein * in Formulae 9-1 to 9-24 indicates a binding site to a neighboring atom.

**7.** The organometallic compound of any of claims 1 to 6, wherein the organometallic compound is represented by Formula 1-1:

Formula 1-1

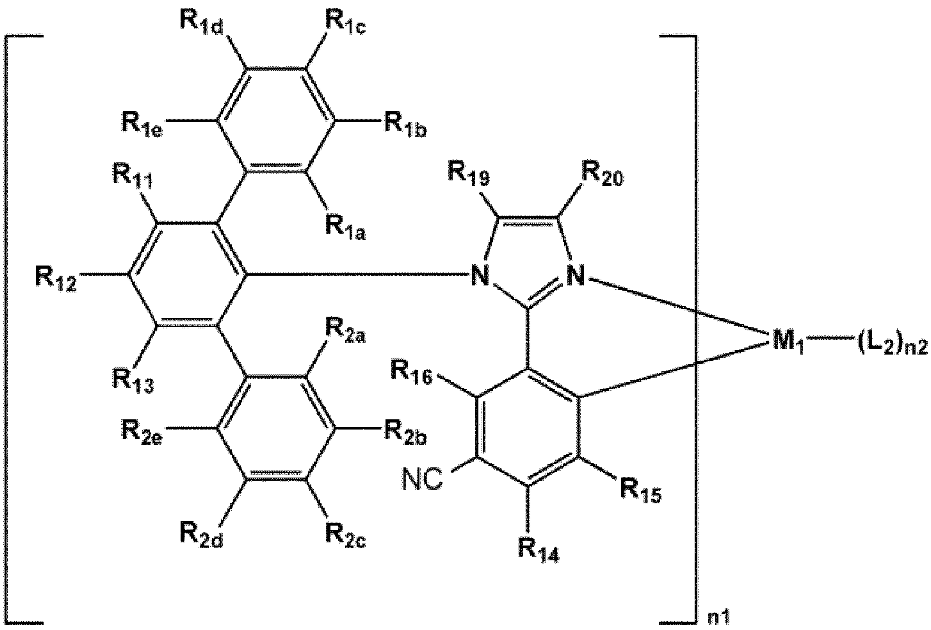

,

wherein, in Formula 1-1, $M_1$, n1, $L_2$, n2, $R_{11}$ to $R_{16}$, $R_{19}$, and $R_{20}$ are the same as described in claim 1, $R_{1a}$ to $R_{1e}$ are the same as described in connection with $R_1$ in claim 1, and $R_{2a}$ to $R_{2e}$ are the same as described in connection with $R_2$ in claim 1, preferably wherein
the organometallic compound is represented by Formula 1(1):

Formula 1(1)

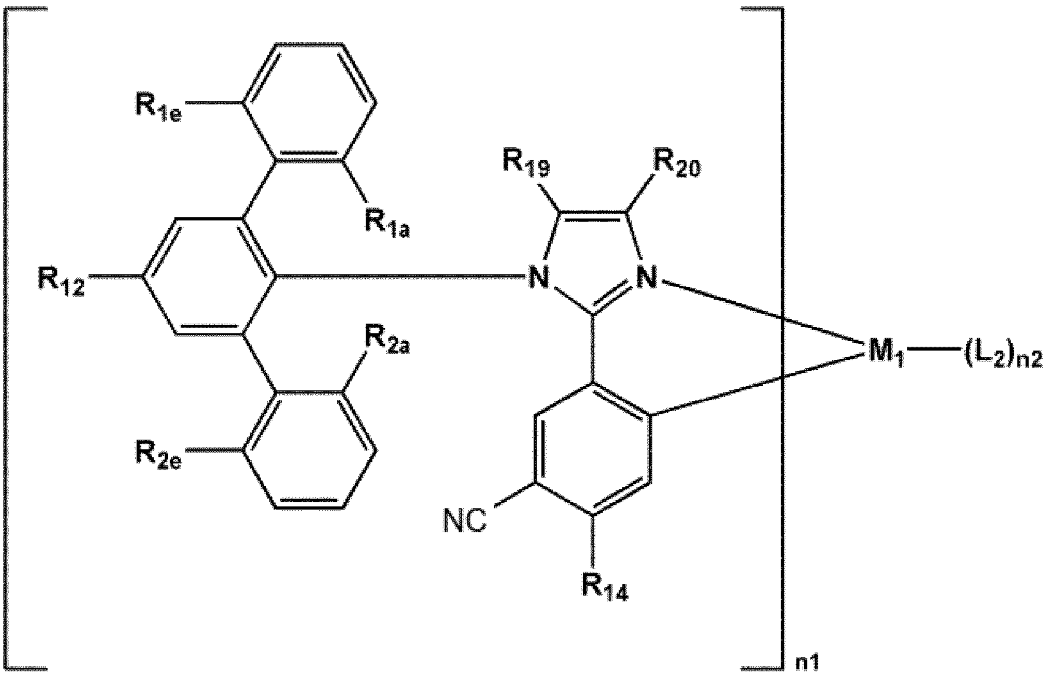

,

wherein, in Formula 1(1), $M_1$, n1, $L_2$, n2, $R_{12}$, $R_{14}$, $R_{19}$, and $R_{20}$ are the same as described in claim 1, $R_{1a}$ and $R_{1e}$

are the same as described in connection with $R_1$ in claim 1, and $R_{2a}$ and $R_{2e}$ are the same as described in connection with $R_2$ in claim 1.

**8.** The organometallic compound of claim 1, wherein the organometallic compound is one of Compounds 1 to 9:

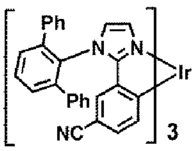
1

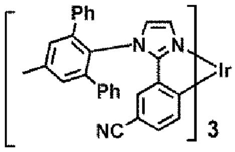
2

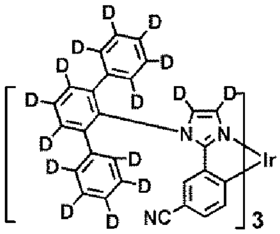
3

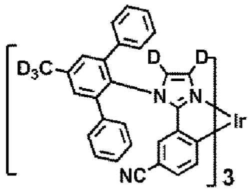
4

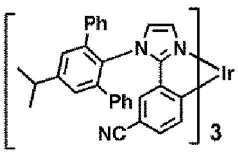
5

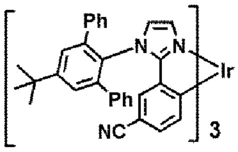
6

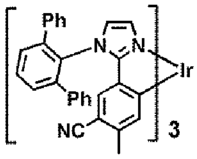
7

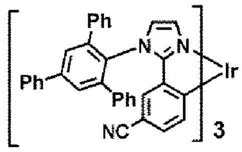
8

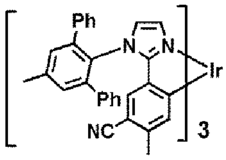
9

wherein "Ph" in Compounds 1 to 9 indicates a phenyl group.

**9.** The organometallic compound of any of claims 1 to 8, wherein
the organometallic compound has a natural population analysis (NPA) charge value of 0.48 or less, and
the NPA charge value is evaluated by a density functional theory (DFT) method using a Gaussian program that is structurally optimized at a level of B3LYP/6-31G(d,p), and/or wherein
an open fraction value of atom A bonded to $R_{19}$ of Formula 1 is 0.5 or less, and the open fraction value is calculated by using Equation 1:

Equation 1

$$\text{Open Fraction values} = \text{Area}_{\text{screened}} / \text{Area}_{\text{free}},$$

wherein, in Equation 1,

Areafree represents an area of a two-dimensional figure obtained by projecting the atom A on a plane A and is calculated by $\pi$ x (van der Waals radius of the atom A)$^2$,
$\text{Area}_{\text{screened}}$ represents an average value of an area of a two-dimensional figure obtained by projecting the atom A screened by another atom B of Formula 1 on a plane B,
assuming that the atom A and the atom B each have a spherical shape,
the plane B is planes in which vectors directing from 492 points on a spherical surface of a sphere tessellation toward an origin of the sphere tessellation are normal vectors, and
$\text{Area}_{\text{screened}}$ is calculated by a density functional theory (DFT) method using a Gaussian program that is structurally optimized at a level of B3LYP/6-31G(d,p).

**10.** A composition containing an organometallic compound, the composition comprising:

a first organometallic compound represented by Formula 1; and
a second organometallic compound represented by Formula 2:

Formula 1

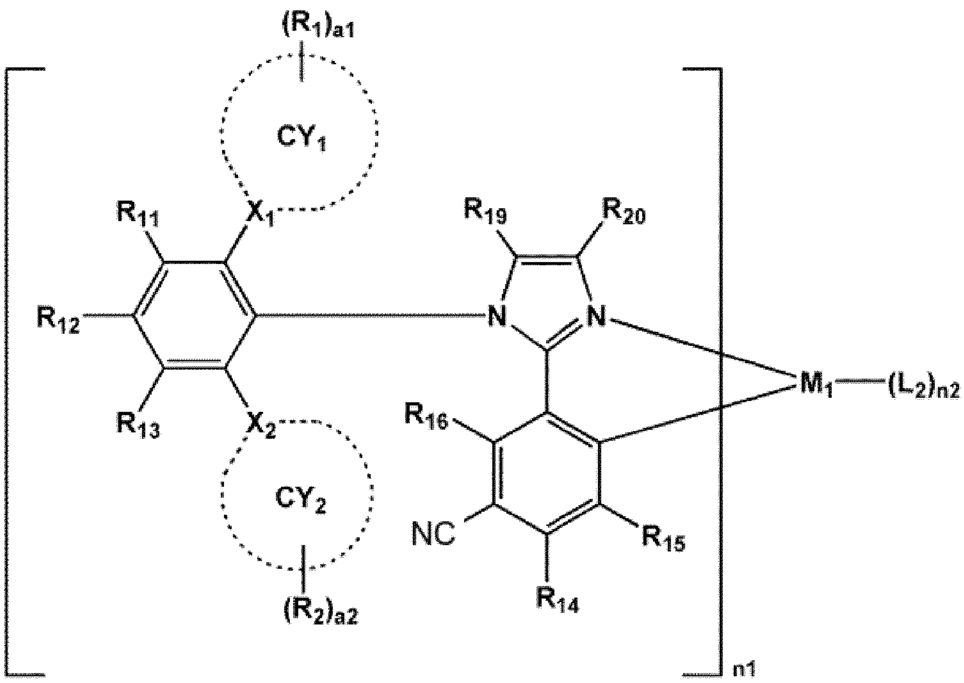

Formula 2

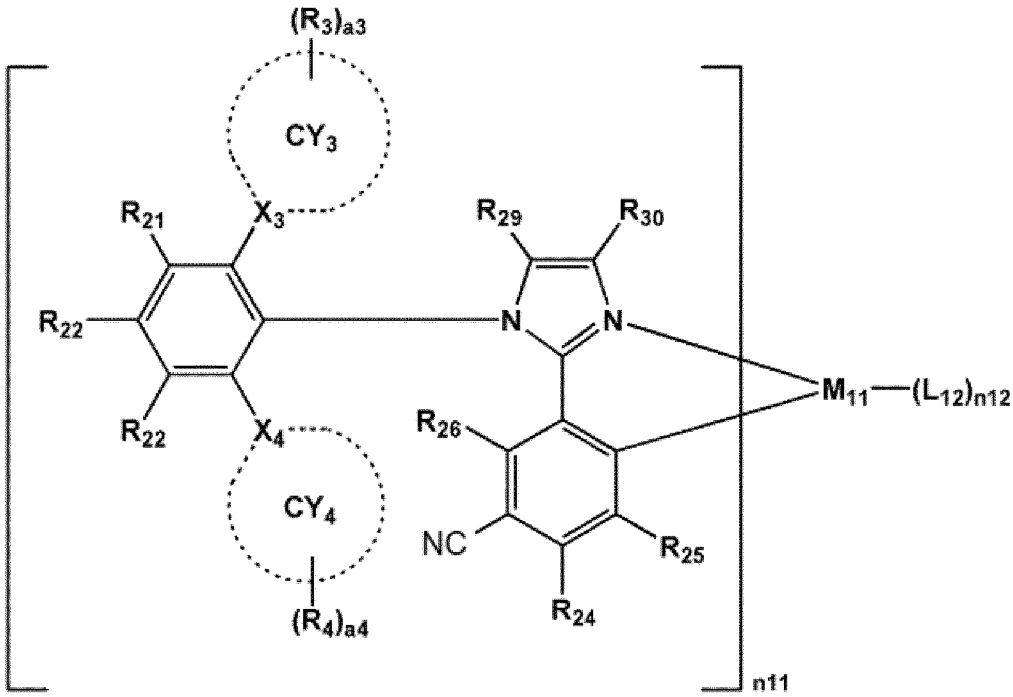

,

wherein, in Formulae 1 and 2,

$M_1$ and $M_{11}$ are each independently selected from a first-row transition metal of the Periodic Table of Elements, a second-row transition metal of the Periodic Table of Elements, and a third-row transition metal of the Periodic Table of Elements,
n1 and n11 are each independently 1, 2, or 3,
$L_2$ and $L_{12}$ are each independently selected from ligands represented by Formulae 3A to 3C, 3E and 3F:

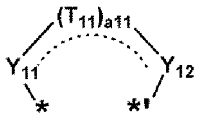
Formula 3A

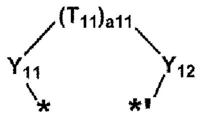
Formula 3B

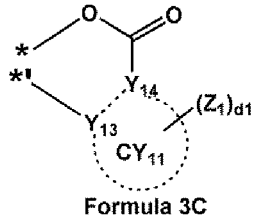
Formula 3C

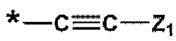
Formula 3E

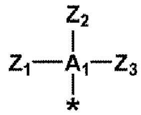
Formula 3F

n2 and n12 are each independently O, 1, 2, 3, or 4, wherein, when n2 is two or more, two or more groups $L_2$ are identical to or different from each other, and when n12 is two or more, two or more groups $L_{12}$ are identical to or different from each other,
$X_1$ to $X_4$ are each independently carbon or nitrogen,
$CY_1$ to $CY_4$ are each independently selected from a $C_5$-$C_{30}$ carbocyclic group and a $C_2$-$C_{30}$ heterocyclic group,
$Y_{11}$ is selected from O, N, $N(Z_1)$, $P(Z_1)(Z_2)$, and $As(Z_1)(Z_2)$,
$Y_{12}$ is selected from O, N, $N(Z_3)$, $P(Z_3)(Z_4)$, and $As(Z_3)(Z_4)$,
$CY_{11}$ is a $C_2$-$C_{30}$ heterocyclic group,
$T_{11}$ is each independently selected from a single bond, a double bond, *-$C(Z_{11})(Z_{12})$-*', *-$C(Z_{11})=C(Z_{12})$-*', *=$C(Z_{11})$-*', *-$C(Z_{11})$=*', *=$C(Z_{11})$-$C(Z_{12})=C(Z_{13})$-*', *-$C(Z_{11})=C(Z_{12})$-$C(Z_{13})$=*', *-$N(Z_{11})$-*', and a substituted or unsubstituted $C_5$-$C_{30}$ carbocyclic group,
a11 is an integer from 1 to 10,
$Y_{13}$ and $Y_{14}$ are each independently carbon (C) or nitrogen (N), $Y_{13}$ and $Y_{14}$ are linked via a single bond or a double bond,
$A_1$ is P or As,
$R_1$, $R_2$, $R_{11}$ to $R_{16}$ $Z_1$ to $Z_4$ and $Z_{11}$ to $Z_{13}$ are each independently selected from hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -$N(O_1)(O_2)$, -$Si(Q_3)(Q_4)(Q_5)$, -$B(Q_6)(Q_7)$, and -$P(=O)(Q_8)(Q_9)$,
two or more neighboring groups of $R_1$, $R_2$, $R_{11}$ to $R_{13}$, $CY_1$, and $CY_2$ are optionally linked to form a substituted or unsubstituted $C_5$-$C_{30}$ carbocyclic group or a substituted or unsubstituted $C_2$-$C_{30}$ heterocyclic group,
a1 and a2 are each independently an integer from 0 to 5,
d1 is an integer from 0 to 10,
$R_{19}$ and $R_{20}$ are each independently selected from hydrogen, deuterium, a C1-$C_{30}$ alkyl group, a $C_1$-$C_{30}$ alkyl

group substituted with at least one deuterium, a $C_6$-$C_{60}$ aryl group, and a $C_6$-$C_{60}$ aryl group substituted with at least one selected from a $C_1$-$C_{30}$ alkyl group and deuterium,

at least one of $R_1$, $R_2$, $R_{11}$ to $R_{16}$, $R_{19}$, and $R_{20}$ is a deuterium-containing substituent,

$R_3$, $R_4$, and $R_{21}$ to $R_{26}$ are each independently selected from hydrogen, -F, -Cl, - Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(O_1)(O_2)$,$-Si(Q_3)(Q_4)(Q_5)$, $-B(Q_6)(Q_7)$, and $-P(=O)(Q_8)(Q_9)$,

two or more neighboring groups of $R_3$, $R_4$, $R_{21}$ to $R_{23}$, $CY_3$, and $CY_4$ are optionally linked to form a substituted or unsubstituted $C_5$-$C_{30}$ carbocyclic group or a substituted or unsubstituted $C_2$-$C_{30}$ heterocyclic group,

a3 and a4 are each independently an integer from 0 to 5,

$R_{29}$ and $R_{30}$ are each independently selected from hydrogen, a $C_1$-$C_{30}$ alkyl group, a $C_6$-$C_{60}$ aryl group, and a $C_6$-$C_{60}$ aryl group substituted with at least one $C_1$-$C_{30}$ alkyl group, and

$R_3$, $R_4$, $R_{21}$ to $R_{26}$, $R_{29}$, and $R_{30}$ are each a deuterium-free substituent;

wherein the substituents of the substituted $C_1$-$C_{60}$ alkyl group, substituted $C_2$-$C_{60}$ alkenyl group, substituted $C_2$-$C_{60}$ alkynyl group, substituted $C_1$-$C_{60}$ alkoxy group, substituted $C_3$-$C_{10}$ cycloalkyl group, substituted $C_1$-$C_{10}$ heterocycloalkyl group, substituted $C_3$-$C_{10}$ cycloalkenyl group, substituted $C_1$-$C_{10}$ heterocycloalkenyl group, substituted $C_6$-$C_{60}$ aryl group, substituted $C_6$-$C_{60}$ aryloxy group, substituted $C_6$-$C_{60}$ arylthio group, substituted $C_7$-$C_{60}$ arylalkyl group, substituted $C_1$-$C_{60}$ heteroaryl group, substituted $C_1$-$C_{60}$ heteroaryloxy group, substituted $C_1$-$C_{60}$ heteroarylthio group, substituted $C_2$-$C_{60}$ heteroarylalkyl group, substituted monovalent non-aromatic condensed polycyclic group, substituted monovalent non-aromatic condensed heteropolycyclic group, substituted $C_5$-$C_{30}$ carbocyclic group, and substituted $C_2$-$C_{30}$ heterocyclic group are selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a C1-$C_{60}$ alkoxy group, each substituted with at least one selected from deuterium, -F, -Cl, - Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(O_{11})(O_{12})$,$-Si(Q_{13})(Q_{14})(Q_{15})$, $-B(O_{16})(O_{17})$, and $-P(=O)(O_{18})(O_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a

salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, -N($O_{21}$)($O_{22}$), -Si($Q_{23}$)($Q_{24}$)($Q_{25}$), -B(Q26)(Q27), and - P(=O)($O_{28}$)($O_{29}$); and

-N($Q_{31}$)($Q_{32}$), -Si($Q_{33}$)($Q_{34}$)($Q_{35}$), -B($Q_{36}$)($Q_{37}$), and -P(=O)($O_{38}$)($O_{39}$),

wherein $Q_1$ to $Q_9$, $Q_{11}$ to $Q_{19}$, $Q_{21}$ to $Q_{29}$, and $Q3_1$ to $Q_{39}$ are each independently selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a C1-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

**11.** The composition of claim 10, wherein
a deuteration rate represented by Equation 2 is 50% or more:

Equation 2

$$\text{deuteration rate (\%)} = n_{D2}/(n_{H2} + n_{D2}) \times 100,$$

wherein, in Equation 2,

$n_{H2}$ represents the sum of a total number of hydrogens included in deuterium-containing substituents in the first organometallic compound and a total number of hydrogens included in a deuterium-free substituent of the second organometallic compound corresponding to the deuterium-containing substituent in the first organometallic compound, and
$n_{D2}$ represents a total number of deuterium atoms included in the deuterium-containing substituents in the first organometallic compound.

**12.** The composition of claim 10 or 11, wherein
the composition comprises a mixture of Compound 3 and an incompletely deuterated Compound 3, or a mixture of Compound 4 and an incompletely deuterated

Compound 4:

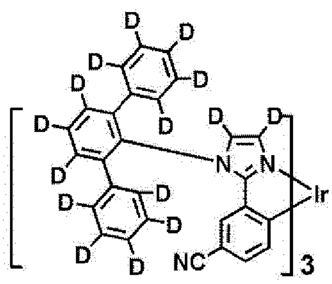

3

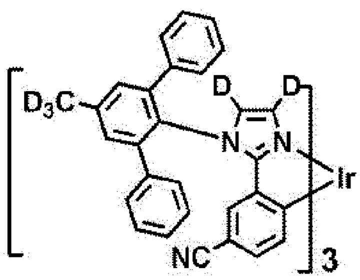

4

.

**13.** An organic light-emitting device comprising:

a first electrode;
a second electrode; and
an organic layer disposed between the first electrode and the second electrode,
wherein the organic layer comprises an emission layer, and
wherein the organic layer comprises at least one organometallic compound of any of claims 1 to 9 or the composition of any of claims 10 to 12.

**14.** The organic light-emitting device of claim 13, wherein
the emission layer comprises the organometallic compound or the composition, preferably wherein
the emission layer further comprises a host.

**Patentansprüche**

**1.** Organometallische Verbindung, dargestellt durch Formel 1:

Formel 1

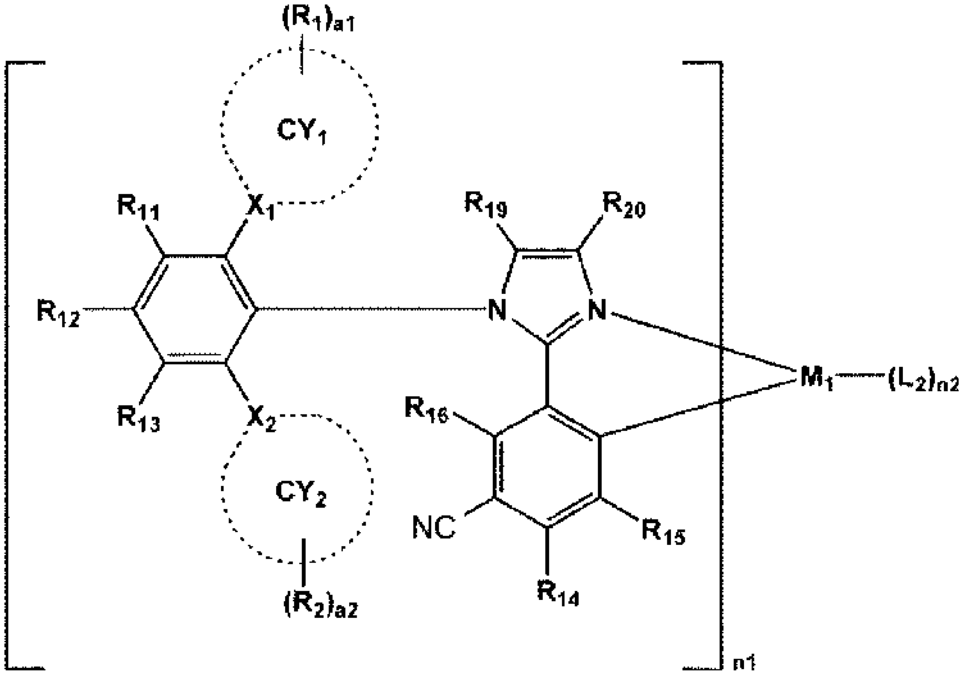

,

wobei in Formel 1

$M_1$ ausgewählt ist aus einem Übergangsmetall der ersten Reihe des Periodensystems der Elemente, einem Übergangsmetall der zweiten Reihe des Periodensystems der Elemente und einem Übergangsmetall der dritten Reihe des Periodensystems der Elemente,
n1 1, 2 oder 3 ist,
$L_2$ ausgewählt ist aus Liganden, die durch Formel 3A bis 3C, 3E und 3F dargestellt sind:

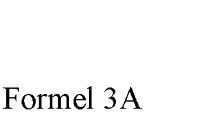

Formel 3A

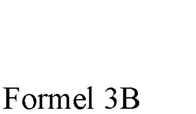

Formel 3B

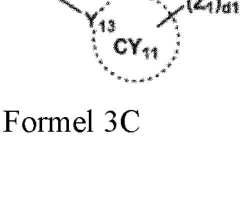

Formel 3C

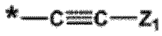

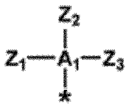

Formel 3E Formel 3F ,

n2 0, 1, 2, 3 oder 4 ist, wobei, wenn n2 zwei oder mehr ist, zwei oder mehr Gruppen $L_2$ miteinander identisch oder unterschiedlich voneinander sind,
$X_1$ und $X_2$ jeweils unabhängig Kohlenstoff oder Stickstoff sind,
$CY_1$ und $CY_2$ jeweils unabhängig ausgewählt sind aus einer carbocylischen $C_5$-$C_{30}$-Gruppe und einer heterocyclischen $C_2$-$C_{30}$-Gruppe,
$Y_{11}$ ausgewählt ist aus O, N, $N(Z_1)$, $P(Z_1)(Z_2)$ und $As(Z_1)(Z_2)$,
$Y_{12}$ ausgewählt ist aus O, N, $N(Z_3)$, $P(Z_3)(Z_4)$ und $As(Z_3)(Z_4)$,
$CY_{11}$ eine heterocyclische $C_2$-$C_{30}$-Gruppe ist,
$T_{11}$ jeweils unabhängig ausgewählt ist aus einer Einzelbindung, einer Doppelbindung, *-$C(Z_{11})(Z_{12})$-*', *-$C(Z_{11})=C(Z_{12})$-*', *=$C(Z_{11})$-*', *-$C(Z_{11})$=*', *=$C(Z_{11})$-$C(Z_{12})=C(Z_{13})$-*', *-$C(Z_{11})=C(Z_{12})$-$C(Z_{13})$=*', *-$N(Z_n)$-*' und einer substituierten oder nicht substituierten carbocyclischen $C_5$-$C_{30}$-Gruppe,
a11 eine ganze Zahl von 1 bis 10 ist,
$Y_{13}$ und $Y_{14}$ jeweils unabhängig Kohlenstoff (C) oder Stickstoff (N) sind, wobei $Y_{13}$ und $Y_{14}$ über eine Einzelbindung oder eine Doppelbindung verbunden sind,
$A_1$ P oder As ist,
$R_1$, $R_2$, $R_{11}$ bis $R_{16}$, $Z_1$ bis $Z_4$ und $Z_{11}$ bis $Z_{13}$ jeweils unabhängig ausgewählt sind aus Wasserstoff, Deuterium, -F, -Cl, -Br, -I, -$SF_5$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_7$-$C_{60}$-Arylalkylgruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten $C_2$-$C_{60}$-Heteroarylalkylgruppe, einer substituierten oder nicht substituierten monovalenten nichtaromatischen kondensierten polycyclischen Gruppe, einer substituierten oder nicht substituierten monovalenten nichtaromatischen kondensierten heteropolycyclischen Gruppe, -$N(Q_1)(Q_2)$, -$Si(Q_3)(Q_4)(Q_5)$,-$B(Q_6)(Q_7)$ und -$P(=O)(Q_8)(Q_9)$,
zwei oder mehr benachbarte Gruppen von $R_1$, $R_2$, $R_{11}$ bis $R_{13}$, $CY_1$ und $CY_2$ optional verbunden sind, um eine substituierte oder nicht substituierte carbocyclische $C_5$-$C_{31}$-Gruppe oder eine substituierte oder nicht substituierte heterocyclische $C_2$-$C_{31}$-Gruppe zu bilden,
a1 und a2 jeweils unabhängig eine ganze Zahl von 0 bis 5 sind,
d1 eine ganze Zahl von 0 bis 10 ist,
$R_{19}$ und $R_{20}$ jeweils unabhängig ausgewählt sind aus Wasserstoff, Deuterium, einer $C_1$-$C_{30}$-Alkylgruppe, einer $C_1$-$C_{30}$-Alkylgruppe substituiert mit zumindest einem Deuterium, einer $C_6$-$C_{60}$-Arylgruppe und einer $C_6$-$C_{60}$-Arylgruppe substituiert mit zumindest einem ausgewählt aus einer $C_1$-$C_{30}$-Alkylgruppe und Deuterium, und
wobei die Substituenten der substituierten carbocyclischen $C_5$-$C_{30}$-Gruppe, der substituierten heterocyclischen $C_2$-$C_{30}$-Gruppe, der substituierten $C_1$-$C_{60}$-Alkylgruppe, der substituierten $C_2$-$C_{60}$-Alkenylgruppe, der substituierten $C_2$-$C_{60}$-Alkynylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten $C_2$-$C_{60}$-Heteroarylalkylgruppe, der substituierten monovalenten nichtaromatischen kondensierten polycyclischen Gruppe und der substituierten monovalenten nichtaromatischen kondensierten heteropolycyclischen Gruppe ausgewählt sind aus:

Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit zumindest einem ausgewählt aus Deuterium, -F, -Cl, - Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe, einer monovalenten nichtaromatischen kondensierten heteropolycyclischen Gruppe, $-N(Q_{11})(Q_{12})$, $-Si(Q_{13})(Q_{14})(Q_{15})$, $-B(Q_{16})(Q_{17})$ und-$P(=O)(Q_{18})(Q_{19})$;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe und einer monovalenten nichtaromatischen kondensierten heteropolycyclischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe und einer monovalenten nichtaromatischen kondensierten heteropolycyclischen Gruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgrupppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe, einer monovalenten nichtaromatischen kondensierten heteropolycyclischen Gruppe, $-N(Q_{21})(Q_{22})$, $-Si(Q_{23})(Q_{24})(Q_{25})$, $-B(Q_{26})(Q_{27})$ und-$P(=O)(Q_{28})(Q_{29})$; und

$-N(Q_{31})(Q_{32})$, $-Si(Q_{33})(Q_{34})(Q_{35})$, $-B(Q_{36})(Q_{37})$ und $-P(=O)(O_{38})(O_{39})$,

wobei $Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe substituiert mit zumindest einem ausgewählt aus einer $C_1$-$C_{60}$-Alkylgruppe und einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe und einer monovalenten nichtaromatischen kondensierten heteropolycyclischen Gruppe.

**2.** Organometallische Verbindung nach Anspruch 1, wobei
$M_1$ Ir oder Os ist, und die Summe von n1 und n2 3 oder 4 ist; oder
$M_1$ Pt ist, und die Summe von n1 und n2 2 ist.

**3.** Organometallische Verbindung nach Anspruch 1 oder 2, wobei

$CY_1$ und $CY_2$ jeweils unabhängig ausgewählt sind aus einer Cyclopentengruppe, einer Cyclohexengruppe, einer Benzolgruppe, einer Pyridingruppe, einer Pyrimidingruppe, einer Pyridazingruppe, einer Pyrazingruppe, einer Triazingruppe, einer Pyrrolgruppe, einer Pyrazolgruppe, einer Imidazolgruppe, einer Triazolgruppe, einer Oxazolgruppe, einer Isoxazolgruppe, einer Oxadiazolgruppe, einer Thiazolgruppe, einer Isothiazolgruppe und einer Thiadiazolgruppe, und/oder wobei
$R_1$, $R_2$ und $R_{11}$ bis $R_{16}$ jeweils unabhängig ausgewählt sind aus:

Wasserstoff, Deuterium, -F, einer Cyanogruppe, einer Nitrogruppe, $-SF_5$, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, einer Dibenzofuranylgruppe und einer Dibenzothiophenylgruppe;
einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer Isohexylgruppe, einer sec-Hexylgruppe, einer tert-Hexylgruppe, einer n-Heptylgruppe, einer Isoheptylgruppe, einer sec-Heptylgruppe, einer tert-Heptylgruppe, einer n-Octylgruppe, einer Isooctylgruppe, einer sec-Octylgruppe, einer tert-Octylgruppe, einer n-Nonylgruppe, einer Isononylgruppe, einer sec-Nonylgruppe, einer tert-Nonylgruppe, einer n-Decylgruppe, einer Isodecylgruppe, einer sec-Decylgruppe, einer tert-Decylgruppe, einer Methoxygruppe, einer Ethoxygruppe, einer Propoxygruppe, einer Butoxygruppe, einer Pentoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, einer Dibenzofuranylgruppe und einer Dibenzothiophenylgruppe, jeweils substituiert mit zumindest einem ausgewählt aus Deuterium, -F, $-CD_3$, $-CD_2H$, $-CDH_2$, $-CF_3$,$-CF_2H$, $-CFH_2$, einer Cyanogruppe, einer Nitrogruppe, einer $C_1$-$C_{10}$-Alkylgruppe, einer $C_1$-$C_{10}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe, einer Dibenzofuranylgruppe und einer Dibenzothiophenylgruppe; und
$-N(Q_1)(Q_2)$, $-Si(Q_3)(Q_4)(Q_5)$, $-B(Q_6)(Q_7)$ und $-P(=O)(Q_8)(Q_9)$,
wobei $Q_1$ bis $Q_9$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$,$CHDCD_2H$, $-CHDCDH_2$, $-CHDCD_3$, $-CD_2CD_3$, $-CD_2CD_2H$ und $-CD_2CDH_2$;

einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jeweils substituiert mit zumindest einem ausgewählt aus Deuterium, einer $C_1$-$C_{10}$-Alkylgruppe und einer Phenylgruppe.

**4.** Organometallische Verbindung nach einem der Ansprüche 1 bis 3, wobei $R_1$, $R_2$, $R_{11}$ bis $R_{16}$, $R_{19}$ und $R_{20}$ jeweils unabhängig ausgewählt sind aus:

Wasserstoff, Deuterium, $-CH_3$, $-CD_3$, $-CD_2H$, $-CDH_2$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, einer Phenylgruppe und Gruppen dargestellt durch Formel 9-1 bis 9-24; und

einer Phenylgruppe substituiert mit zumindest einem ausgewählt aus Deuterium, $-CD_3$,$-CD_2H$, $-CDH_2$ und einer $C_1$-$C_{10}$-Alkylgruppe:

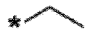
Formel 9-1

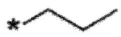
Formel 9-2

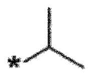
Formel 9-3

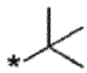
Formel 9-4

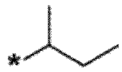
Formel 9-5

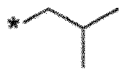
Formel 9-6

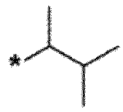
Formel 9-7

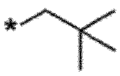
Formel 9-8

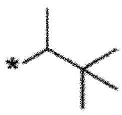
Formel 9-9

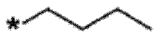
Formel 9-10

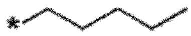
Formel 9-11

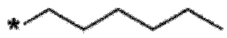
Formel 9-12

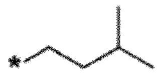
Formel 9-13

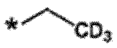
Formel 9-14

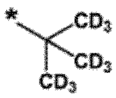
Formel 9-15

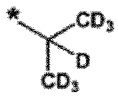
Formel 9-16

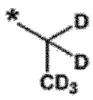
Formel 9-17

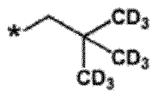
Formel 9-18

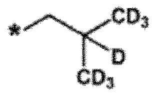
Formel 9-19

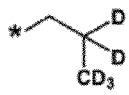
Formel 9-20

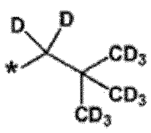
Formel 9-21

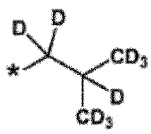
Formel 9-22

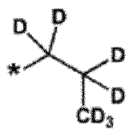
Formel 9-23

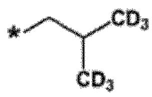
Formel 9-24,

wobei * in Formel 9-1 bis 9-24 eine Bindungsstelle zu einem benachbarten Atom angibt.

**5.** Organometallische Verbindung nach einem der Ansprüche 1 bis 4, wobei zumindest eines von $R_1$, $R_2$, $R_{11}$ bis $R_{16}$, $R_{19}$ und $R_{20}$ ein Deuterium enthaltender Substituent ist, und der Deuterium enthaltende Substituent ausgewählt ist aus:

Deuterium; und
einer $C_1$-$C_{20}$-Alkylgruppe und einer Phenylgruppe, jeweils substituiert mit zumindest einem Deuterium, wobei bevorzugt
der Deuterium enthaltende Substituent ausgewählt ist aus:

Deuterium; und
einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer n-Pentylgruppe, einer Isopentylgruppe, einer 1-Methylbutylgruppe, einer 2-Methylbutylgruppe, einer Neopentylgruppe, einer 1,2-Dimethylpropylgruppe, einer tert-Pentylgruppe und einer Phenylgruppe, jeweils substituiert mit zumindest einem Deuterium.

**6.** Organometallische Verbindung nach einem der Ansprüche 1 bis 5, wobei zumindest eines von $R_{12}$, $R_{14}$, $R_{19}$ und $R_{20}$ ausgewählt ist aus:

Deuterium; und

einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer n-Pentylgruppe, einer Isopentylgruppe, einer 1-Methylbutylgruppe, einer 2-Methylbutylgruppe, einer Neopentylgruppe, einer 1,2-Dimethylpropylgruppe, einer tert-Pentylgruppe und einer Phenylgruppe, jeweils substituiert mit zumindest einem Deuterium, und/oder wobei

$R_{12}$ und $R_{14}$ jeweils unabhängig ausgewählt sind aus:

Wasserstoff, Deuterium, $-CH_3$, $-CD_3$, $-CD_2H$, $-CDH_2$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, einer Phenylgruppe und Gruppen dargestellt durch Formel 9-1 bis 9-24; und

einer Phenylgruppe substituiert mit zumindest einem ausgewählt aus Deuterium, $-CD_3$,$-CD_2H$, $-CDH_2$ und einer $C_1$-$C_{10}$-Alkylgruppe, und

$R_{19}$ und $R_{20}$ jeweils unabhängig Wasserstoff oder Deuterium sind,

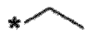 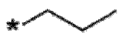 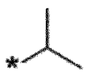 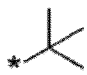 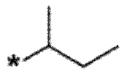 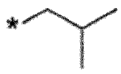 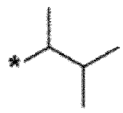

Formel 9-1 Formel 9-2 Formel 9-3 Formel 9-4 Formel 9-5 Formel 9-6 Formel 9-7

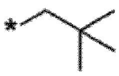 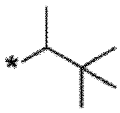 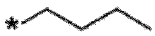 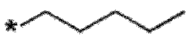 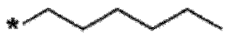 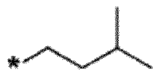

Formel 9-8 Formel 9-9 Formel 9-10 Formel 9-11 Formel 9-12 Formel 9-13

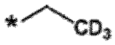 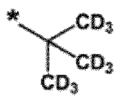 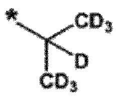 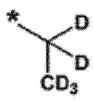 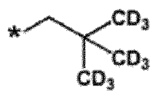 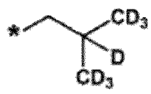 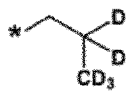

Formel 9-14 Formel 9-15 Formel 9-16 Formel 9-17 Formel 9-18 Formel 9-19 Formel 9-20

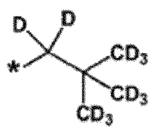 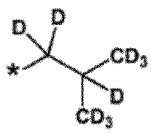 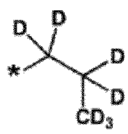 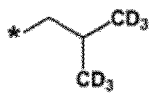

Formel 9-21 Formel 9-22 Formel 9-23 Formel 9-24,

wobei * in Formel 9-1 bis 9-24 eine Bindungsstelle zu einem benachbarten Atom angibt.

**7.** Organometallische Verbindung nach einem der Ansprüche 1 bis 6, wobei die organometallische Verbindung dargestellt ist durch Formel 1-1:

Formel 1-1

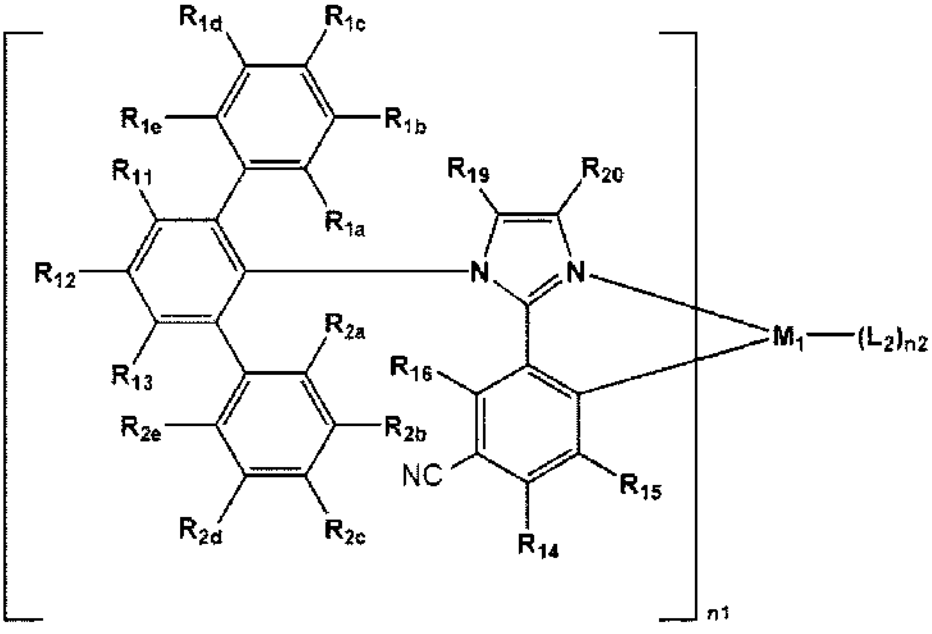

wobei in Formel 1-1, Mi, n1, $L_2$, n2, $R_{11}$ bis $R_{16}$, $R_{19}$ und $R_{20}$ die gleichen wie in Anspruch 1 beschrieben sind, $R_{1a}$ bis $R_{1e}$ die gleichen wie in Verbindung mit $R_1$ in Anspruch 1 beschrieben sind, und $R_{2a}$ bis $R_{2e}$ die gleichen wie in Verbindung mit $R_2$ in Anspruch 1 beschrieben sind, wobei bevorzugt
die organometallische Verbindung dargestellt ist durch Formel 1(1):

Formel 1(1)

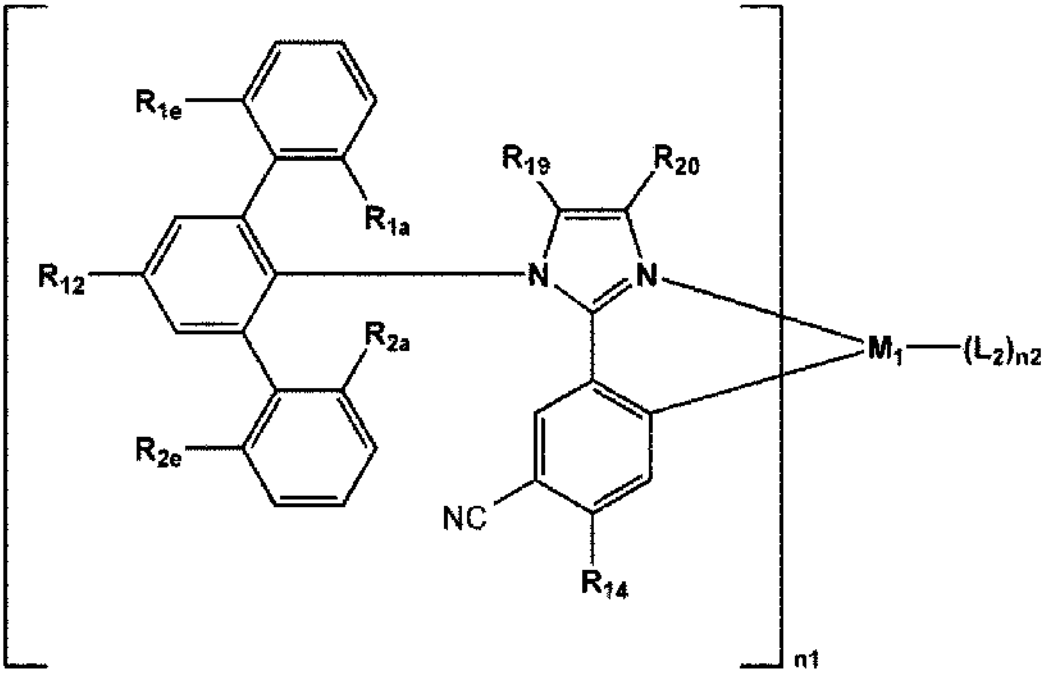

wobei in Formel 1(1), Mi, n1, $L_2$, n2, $R_{12}$, $R_{14}$, $R_{19}$ und $R_{20}$ die gleichen wie in Anspruch 1 beschrieben sind, $R_{1a}$ und $R_{1e}$ die gleichen wie in Verbindung mit $R_1$ in Anspruch 1 beschrieben sind, und $R_{2a}$ und $R_{2e}$ die gleichen wie

in Verbindung mit $R_2$ in Anspruch 1 beschrieben sind.

**8.** Organometallische Verbindung nach Anspruch 1, wobei die organometallische Verbindung eine der Verbindungen 1 bis 9 ist:

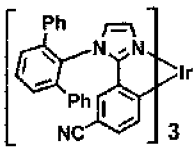

1

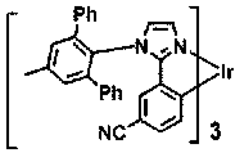

2

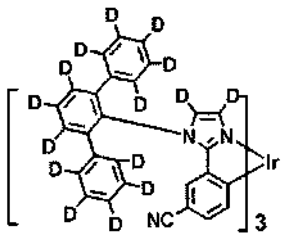

3

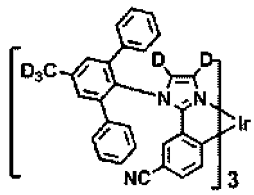

4

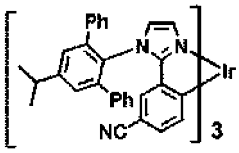

5

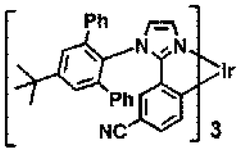

6

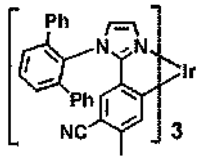

7

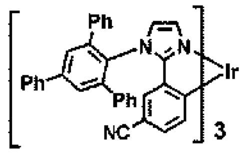

8

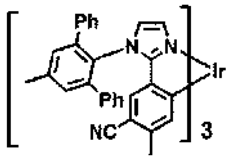

9

wobei "Ph" in Verbindung 1 bis 9 eine Phenylgruppe angibt.

**9.** Organometallische Verbindung nach einem der Ansprüche 1 bis 8, wobei die organometallische Verbindung einen Ladungswert der natürlichen Populationsanalyse (NPA) von 0,48 oder weniger aufweist, und der NPA-Ladungswert durch ein Verfahren der Dichtefunktionaltheorie (DFT) unter Verwendung eines Gaußschen Programms bewertet wird, das auf einem Niveau von B3LYP/6-31G(d,p) strukturell optimiert ist, und/oder wobei ein offener Fraktionswert von Atom A gebunden an $R_{19}$ der Formel 1 0,5 oder weniger ist, und der offene Fraktionswert unter Verwendung von Gleichung 1 berechnet wird:

Gleichung 1

$$\text{Offene Bruchwerte} = \text{Fläche}_{\text{abgeschirmt}} / \text{Fläche}_{\text{frei}},$$

wobei in Gleichung 1

$\text{Fläche}_{\text{frei}}$ eine Fläche einer zweidimensionalen Figur darstellt, die durch Projizieren des Atoms A auf eine Ebene A erhalten wird und durch $\pi$ x (Van-der-Waals-Radius des Atoms A)$^2$ berechnet wird,
$\text{Fläche}_{\text{abgeschirmt}}$ einen Durchschnittswert einer Fläche einer zweidimensionalen Figur darstellt, die durch Projizieren des Atoms A, das von einem anderen Atom B der Formel 1 abgeschirmt wird, auf eine Ebene B erhalten wird,
unter der Annahme, dass das Atom A und das Atom B jeweils eine Kugelform aufweisen, die Ebene B Ebenen ist, in denen Vektoren, die von 492 Punkten auf einer kugelförmigen Oberfläche einer Kugel-Tessellation zu einem Ursprung der Kugel-Tessellation gerichtet sind, normale Vektoren sind, und
$\text{Fläche}_{\text{abgeschirmt}}$ durch ein Verfahren der Dichtefunktionaltheorie (DFT) unter Verwendung eines Gaußschen Programms berechnet wird, das auf einem Niveau von B3LYP/6-31G(d,p) strukturell optimiert ist.

**10.** Zusammensetzung, die eine organometallische Verbindung enthält, wobei die Zusammensetzung Folgendes umfasst:

eine erste organometallische Verbindung dargestellt durch Formel 1; und
eine zweite organometallische Verbindung dargestellt durch Formel 2:

Formel 1

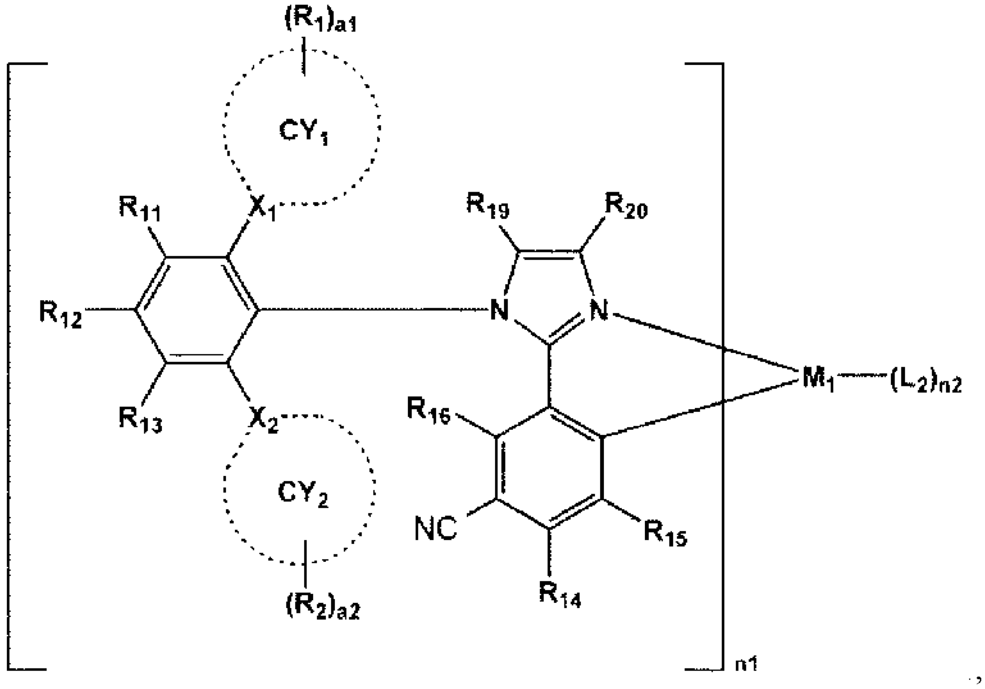

Formel 2

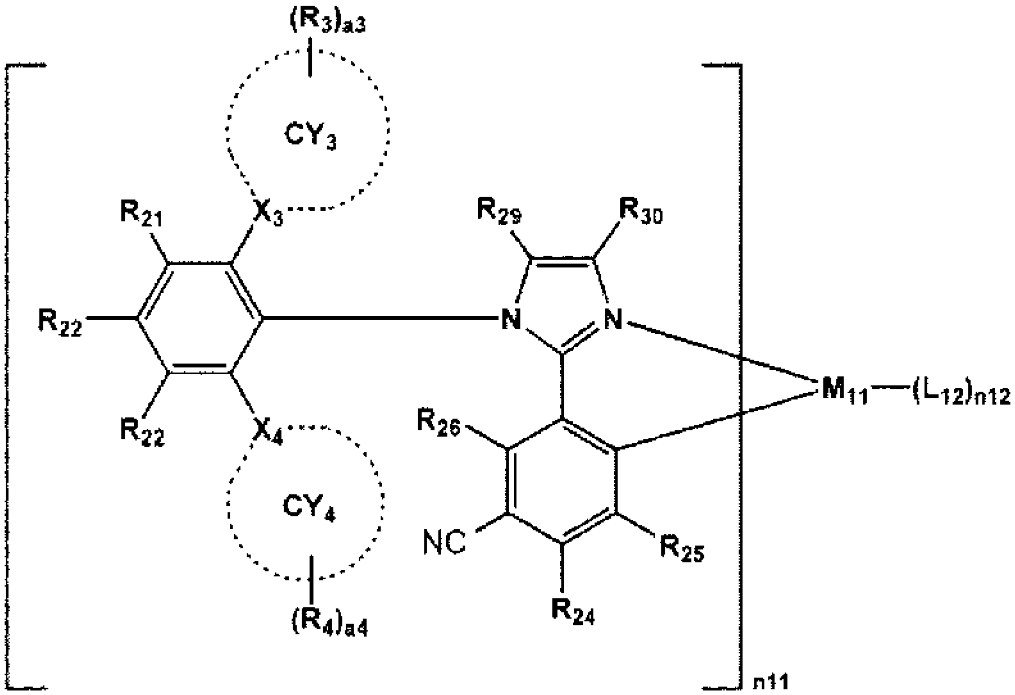

,

wobei in Formel 1 und 2

$M_1$ und $M_{11}$ jeweils unabhängig ausgewählt sind aus einem Übergangsmetall der ersten Reihe des Periodensystems der Elemente, einem Übergangsmetall der zweiten Reihe des Periodensystems der Elemente und einem Übergangsmetall der dritten Reihe des Periodensystems der Elemente,

n1 und n11 jeweils unabhängig 1,2 oder 3 sind,

$L_2$ und $L_{12}$ jeweils unabhängig ausgewählt sind aus Liganden, die durch Formel 3A bis 3C, 3E und 3F dargestellt sind:

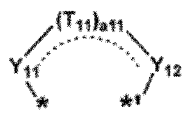

Formel 3A

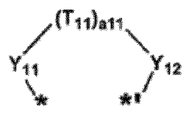

Formel 3B

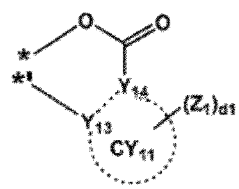

Formel 3C

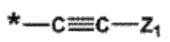

Formel 3E

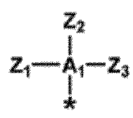

Formel 3F

,

n2 und n12 jeweils unabhängig 0, 1, 2, 3 oder 4 sind, wobei, wenn n2 zwei oder mehr ist, zwei oder mehr Gruppen $L_2$ miteinander identisch oder unterschiedlich voneinander sind, und wenn n12 zwei oder mehr ist, zwei oder mehr Gruppen $L_{12}$ miteinander identisch oder unterschiedlich voneinander sind,

$X_1$ bis $X_4$ jeweils unabhängig Kohlenstoff oder Stickstoff sind,

$CY_1$ bis $CY_4$ jeweils unabhängig ausgewählt sind aus einer carbocyclischen $C_5$-$C_{30}$-Gruppe und einer heterocyclischen $C_2$-$C_{30}$-Gruppe,

$Y_{11}$ ausgewählt ist aus O, N, $N(Z_1)$, $P(Z_1)(Z_2)$ und $As(Z_1)(Z_2)$,
$Y_{12}$ ausgewählt ist aus O, N, $N(Z_3)$, $P(Z_3)(Z_4)$ und $As(Z_3)(Z_4)$,
$CY_{11}$ eine heterocyclische $C_2$-$C_{30}$-Gruppe ist,
$T_{11}$ jeweils unabhängig ausgewählt ist aus einer Einzelbindung, einer Doppelbindung, *-C($Z_{11}$)($Z_{12}$)-*', *-C($Z_{11}$)=C($Z_{12}$)-*', *=C($Z_{11}$)-*', *-C($Z_{11}$)=*', *=C($Z_{11}$)-C($Z_{12}$)=C($Z_{13}$)-*', *-C($Z_{11}$)=C($Z_{12}$)-C($Z_{13}$)=*', *-N($Z_{11}$)-*' und einer substituierten oder nicht substituierten carbocyclischen $C_5$-$C_{30}$-Gruppe,
a11 eine ganze Zahl von 1 bis 10 ist,
$Y_{13}$ und $Y_{14}$ jeweils unabhängig Kohlenstoff (C) oder Stickstoff (N) sind, wobei $Y_{13}$ und $Y_{14}$ über eine Einzelbindung oder eine Doppelbindung verbunden sind,
$A_1$ P oder As ist,
$R_1$, $R_2$, $R_{11}$ bis $R_{16}$, $Z_1$ bis $Z_4$ und $Z_{11}$ bis $Z_{13}$ jeweils unabhängig ausgewählt sind aus Wasserstoff, Deuterium, -F, -Cl, -Br, -I, -$SF_5$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_7$-$C_{60}$-Arylalkylgruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten $C_2$-$C_{60}$-Heteroarylalkylgruppe, einer substituierten oder nicht substituierten monovalenten nichtaromatischen kondensierten polycyclischen Gruppe, einer substituierten oder nicht substituierten monovalenten nichtaromatischen kondensierten heteropolycyclischen Gruppe, -N($Q_1$)($Q_2$), -Si($Q_3$)($Q_4$)($Q_5$),-B($Q_6$)($Q_7$) und -P(=O)($Q_8$)($Q_9$),
zwei oder mehr benachbarte Gruppen von $R_1$, $R_2$, $R_{11}$ bis $R_{13}$, $CY_1$ und $CY_2$ optional verbunden sind, um eine substituierte oder nicht substituierte carbocyclische $C_5$-$C_{30}$-Gruppe oder eine substituierte oder nicht substituierte heterocyclische $C_2$-$C_{30}$-Gruppe zu bilden,
a1 und a2 jeweils unabhängig eine ganze Zahl von 0 bis 5 sind,
d1 eine ganze Zahl von 0 bis 10 ist,
$R_{19}$ und $R_{20}$ jeweils unabhängig ausgewählt sind aus Wasserstoff, Deuterium, einer $C_1$-$C_{30}$-Alkylgruppe, einer $C_1$-$C_{30}$-Alkylgruppe substituiert mit zumindest einem Deuterium, einer $C_6$-$C_{60}$-Arylgruppe und einer $C_6$-$C_{60}$-Arylgruppe substituiert mit zumindest einem ausgewählt aus einer $C_1$-$C_{30}$-Alkylgruppe und Deuterium,
zumindest eines von $R_1$, $R_2$, $R_{11}$ bis $R_{16}$, $R_{19}$ und $R_{20}$ ein Deuterium enthaltender Substituent ist,
$R_3$, $R_4$ und $R_{21}$ bis $R_{26}$ jeweils unabhängig ausgewählt sind aus Wasserstoff, -F, -Cl, -Br,-I, -$SF_5$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer substituierten oder nicht substituierten $C_1$-$C_{60}$-Alkylgruppe, einer substituierten oder nicht substituierten $C_2$-$C_{60}$-Alkenylgruppe, einer substituierten oder nicht substituierten $C_2$-$C_{60}$-Alkynylgruppe, einer substituierten oder nicht substituierten $C_1$-$C_{60}$-Alkoxygruppe, einer substituierten oder nicht substituierten $C_3$-$C_{10}$-Cycloalkylgruppe, einer substituierten oder nicht substituierten $C_1$-$C_{10}$-Heterocycloalkylgruppe, einer substituierten oder nicht substituierten $C_3$-$C_{10}$-Cycloalkenylgruppe, einer substituierten oder nicht substituierten $C_1$-$C_{10}$-Heterocycloalkenylgruppe, einer substituierten oder nicht substituierten $C_6$-$C_{60}$-Arylgruppe, einer substituierten oder nicht substituierten $C_6$-$C_{60}$-Aryloxygruppe, einer substituierten oder nicht substituierten $C_6$-$C_{60}$-Arylthiogruppe, einer substituierten oder nicht substituierten $C_7$-$C_{60}$-Arylalkylgruppe, einer substituierten oder nicht substituierten $C_1$-$C_{60}$-Heteroarylgruppe, einer substituierten oder nicht substituierten $C_1$-$C_{60}$-Heteroaryloxygruppe, einer substituierten oder nicht substituierten $C_1$-$C_{60}$-Heteroarylthiogruppe, einer substituierten oder nicht substituierten $C_2$-$C_{60}$-Heteroarylalkylgruppe, einer substituierten oder nicht substituierten monovalenten nichtaromatischen kondensierten polycyclischen Gruppe, einer substituierten oder nicht substituierten monovalenten nichtaromatischen kondensierten heteropolycyclischen Gruppe,-N($Q_1$)($Q_2$), Si($Q_3$)($Q_4$)($Q_5$), -B($Q_6$)($Q_7$) und -P(=O)($Q_8$)($Q_9$),
zwei oder mehr benachbarte Gruppen von $R_3$, $R_4$, $R_{21}$ bis $R_{23}$, $CY_3$ und $CY_4$ optional verbunden sind, um eine substituierte oder nicht substituierte carbocyclische $C_5$-$C_{30}$-Gruppe oder eine substituierte oder nicht substituierte heterocyclische $C_2$-$C_{30}$-Gruppe zu bilden,
a3 und a4 jeweils unabhängig eine ganze Zahl von 0 bis 5 sind,

$R_{29}$ und $R_{30}$ jeweils unabhängig ausgewählt sind aus Wasserstoff, einer $C_1$-$C_{30}$-Alkylgruppe, einer $C_6$-$C_{60}$-Arylgruppe und einer $C_6$-$C_{60}$-Arylgruppe substituiert mit zumindest einer $C_1$-$C_{30}$-Alkylgruppe, und
$R_3$, $R_4$, $R_{21}$ bis $R_{26}$, $R_{29}$ und $R_{30}$ jeweils ein deuteriumfreier Substituent sind;
wobei die Substituenten der substituierten $C_1$-$C_{60}$-Alkylgruppe, substituierten $C_2$-$C_{60}$-Alkenylgruppe, substituierten $C_2$-$C_{60}$-Alkynylgruppe, substituierten $C_1$-$C_{60}$-Alkoxygruppe, substituierten $C_3$-$C_{10}$-Cycloalkylgruppe, substituierten $C_1$-$C_{10}$-Heterocycloalkylgruppe, substituierten $C_3$-$C_{10}$-Cycloalkenylgruppe, substituierten $C_1$-$C_{10}$-Heterocycloalkenylgruppe, substituierten $C_6$-$C_{60}$-Arylgruppe, substituierten $C_6$-$C_{60}$-Aryloxygruppe, substituierten $C_6$-$C_{60}$-Arylthiogruppe, substituierten $C_7$-$C_{60}$-Arylalkylgruppe, substituierten $C_1$-$C_{60}$-Heteroarylgruppe, substituierten $C_1$-$C_{60}$-Heteroaryloxygruppe, substituierten $C_1$-$C_{60}$-Heteroarylthiogruppe, substituierten $C_2$-$C_{60}$-Heteroarylalkylgruppe, substituierten monovalenten nichtaromatischen kondensierten polycyclischen Gruppe, substituierten monovalenten nichtaromatischen kondensierten heteropolycyclischen Gruppe, substituierten carbocyclischen $C_5$-$C_{30}$-Gruppe und substituierten heterocyclischen $C_2$-$C_{30}$-Gruppe ausgewählt sind aus:

Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe;
einer $C_1$-$C_{60}$-Alkylgruppe, einer $C_2$-$C_{60}$-Alkenylgruppe, einer $C_2$-$C_{60}$-Alkynylgruppe und einer $C_1$-$C_{60}$-Alkoxygruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe, einer monovalenten nichtaromatischen kondensierten heteropolycyclischen Gruppe, $-N(Q_{11})(Q_{12})$, $-Si(Q_{13})(Q_{14})(Q_{15})$, $-B(Q_{16})(Q_{17})$ und-$P(=O)(Q_{18})(Q_{19})$;
einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe und einer monovalenten nichtaromatischen kondensierten heteropolycyclischen Gruppe;
einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe und einer monovalenten nichtaromatischen kondensierten heteropolycyclischen Gruppe, jeweils substituiert mit zumindest einem ausgewählt aus Deuterium, -F, -Cl, -Br, -I, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgrupppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe, einer monovalenten nichtaromatischen kondensierten heteropolycyclischen Gruppe, $-N(Q_{21})(Q_{22})$, $-Si(Q_{23})(Q_{24})(Q_{25})$, $-B(Q_{26})(Q_{27})$ und-$P(=O)(Q_{28})(Q_{29})$; und
$-N(Q_{31})(Q_{32})$, $-Si(Q_{33})(Q_{34})(Q_{35})$, $-B(Q_{36})(Q_{37})$ und $-P(=O)(Q_{38})(Q_{39})$,
wobei $Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carboxylsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe substituiert mit zumindest einem ausgewählt aus einer $C_1$-$C_{60}$-Alkylgruppe und einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten nichtaromatischen kondensierten polycyclischen Gruppe und einer monovalenten nichtaromatischen kondensierten heteropolycyclischen Gruppe.

**11.** Zusammensetzung nach Anspruch 10, wobei
eine Deuterierungsrate dargestellt durch Gleichung 2 50 % oder mehr beträgt:

Gleichung 2

$$\text{Deuterierungsrate (\%)} = n_{D2}/(n_{H2} + n_{D2}) \text{ X } 100,$$

wobei in Gleichung 2

$n_{H2}$ die Summe einer Gesamtzahl an Wasserstoffen, die in Deuterium enthaltenden Substituenten in der ersten organometallischen Verbindung enthalten sind, und einer Gesamtzahl an Wasserstoffen darstellt, die in einem deuteriumfreien Substituenten der zweiten organometallischen Verbindung entsprechend dem Deuterium enthaltenden Substituenten in der ersten organometallischen Verbindung enthalten sind, und
$n_{D2}$ eine Gesamtzahl an Deuteriumatomen darstellt, die in den Deuterium enthaltenden Substituenten in der ersten organometallischen Verbindung enthalten sind.

**12.** Zusammensetzung nach Anspruch 10 oder 11, wobei
die Zusammensetzung ein Gemisch aus Verbindung 3 und einer unvollständig deuterierten Verbindung 3 oder ein Gemisch aus Verbindung 4 und einer unvollständig deuterierten Verbindung 4 umfasst:

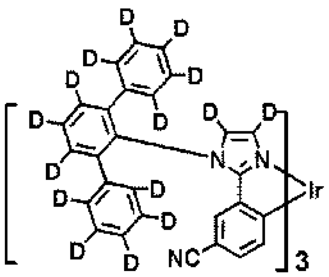
3

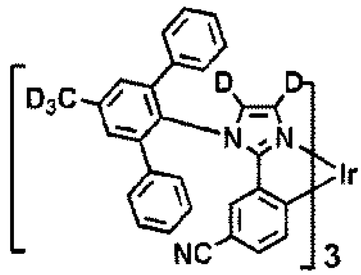
4

.

**13.** Organische lichtemittierende Vorrichtung, umfassend:

eine erste Elektrode;
eine zweite Elektrode; und
eine organische Schicht, die zwischen der ersten Elektrode und der zweiten Elektrode angeordnet ist,
wobei die organische Schicht eine Emissionsschicht umfasst, und
wobei die organische Schicht zumindest eine organometallische Verbindung nach einem der Ansprüche 1 bis 9 oder die Zusammensetzung nach einem der Ansprüche 10 bis 12 umfasst.

**14.** Organische lichtemittierende Vorrichtung nach Anspruch 13, wobei
die Emissionsschicht die organometallische Verbindung oder die Zusammensetzung umfasst, wobei bevorzugt die Emissionsschicht ferner einen Wirt umfasst.

## Revendications

**1.** Composé organométallique représenté par la Formule 1 :

Formule 1

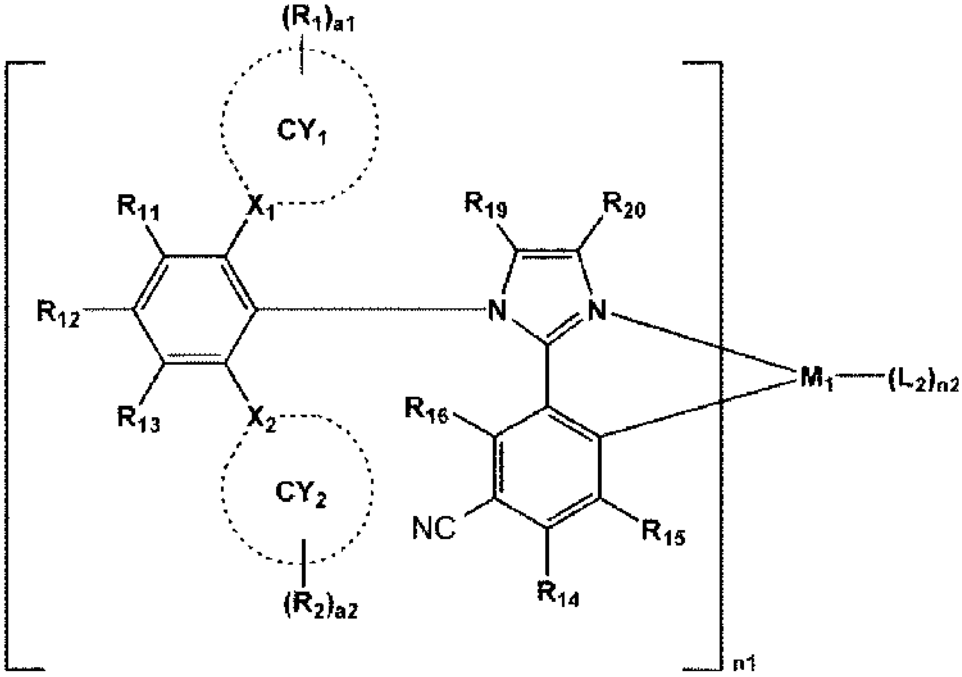

,

où, dans la Formule 1,

$M_1$ est sélectionné entre un métal de transition de la première ligne de la table périodique des éléments, un métal de transition de la deuxième ligne de la table périodique des éléments, et un métal de transition de la troisième ligne de la table périodique des éléments,
n1 est 1, 2, ou 3,
$L_2$ est sélectionné parmi des ligands représentés par les Formules 3A à 3C, 3E et 3F :

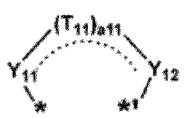

Formule 3A

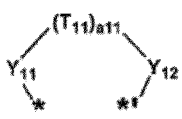

Formule 3B

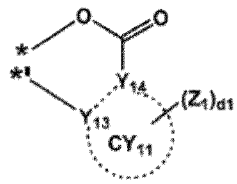

Formule 3C

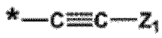

Formule 3E

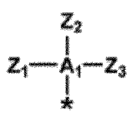

Formule 3F

,

n2 est 0, 1, 2, 3, ou 4, où, quand n2 est deux ou plus, deux groupes $L_2$ ou plus sont identiques ou différents l'un de l'autre,
$X_1$ et $X_2$ sont chacun indépendamment carbone ou azote,
$CY_1$ et $CY_2$ sont chacun indépendamment sélectionnés entre un groupe carbocyclique $C_5$-$C_{30}$ et un groupe hétérocyclique $C_2$-$C_{30}$,

$Y_{11}$ est sélectionné entre O, N, $N(Z_1)$, $P(Z_1)(Z_2)$, et $As(Z_1)(Z_2)$,

$Y_{12}$ est sélectionné entre O, N, $N(Z_3)$, $P(Z_3)(Z_4)$, et $As(Z_3)(Z_4)$,

$CY_{11}$ est un groupe hétérocyclique $C_2$-$C_{30}$,

$T_{11}$ est chacun indépendamment sélectionné entre une liaison simple, une liaison double, *-$C(Z_{11})(Z_{12})$-*', *-$C(Z_{11})=C(Z_{12})$-*', *=$C(Z_{11})$-*', *-$C(Z_{11})$=*', *=$C(Z_{11})$-$C(Z_{12})=C(Z_{13})$-*', *-$C(Z_{11})=C(Z_{12})$-$C(Z_{13})$=*', *-$N(Z_{11})$-*', et un groupe carbocyclique $C_5$-$C_{30}$ substitué ou non substitué,

a11 est un nombre entier de 1 à 10,

$Y_{13}$ et $Y_{14}$ sont chacun indépendamment carbone © ou azote (N), $Y_{13}$ et $Y_{14}$ sont reliés via une liaison simple ou une liaison double,

$A_1$ est P ou As,

$R_1$, $R_2$, $R_{11}$ à $R_{16}$, $Z_1$ à $Z_4$ et $Z_{11}$ à $Z_{13}$ sont chacun indépendamment sélectionnés entre hydrogène, deutérium, -F, -Cl, -Br, -I, $-SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe arylalkyle $C_7$-$C_{60}$ substitué ou non substitué, un groupe hétéroaryle $C_1$-$C_{60}$ substitué ou non substitué, un groupe hétéroaryloxy $C_1$-$C_{60}$ substitué ou non substitué, un groupe hétéroarylthio $C_1$-$C_{60}$ substitué ou non substitué, un groupe hétéroarylalkyle $C_2$-$C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-B(Q_6)(Q_7)$, et $-P(=O)(Q_8)(Q_9)$,

deux groupes voisins ou plus de $R_1$, $R_2$, $R_{11}$ à $R_{13}$, $CY_1$, et $CY_2$ sont optionnellement reliés pour former un groupe carbocyclique $C_5$-$C_{30}$ substitué ou non substitué ou un groupe hétérocyclique $C_2$-$C_{30}$ substitué ou non substitué,

a1 et a2 sont chacun indépendamment un nombre entier de 0 à 5,

d1 est un nombre entier de 0 à 10,

$R_{19}$ et $R_{20}$ sont chacun indépendamment sélectionnés entre hydrogène, deutérium, un groupe alkyle $C_1$-$C_{30}$, un groupe alkyle $C_1$-$C_{30}$ substitué avec au moins un deutérium, un groupe aryle $C_6$-$C_{60}$, et un groupe aryle $C_6$-$C_{60}$ substitué avec au moins un élément sélectionné entre un groupe alkyle $C_1$-$C_{30}$ et deutérium, et

où les substituants du groupe carbocyclique $C_5$-$C_{30}$ substitué, du groupe hétérocyclique $C_2$-$C_{30}$ substitué, du groupe alkyle $C_1$-$C_{60}$ substitué, du groupe alkényle $C_2$-$C_{60}$ substitué, du groupe alkynyle $C_2$-$C_{60}$ substitué, du groupe alkoxy $C_1$-$C_{60}$ substitué, du groupe cycloalkyle $C_3$-$C_{10}$ substitué, du groupe hétérocycloalkyle $C_1$-$C_{10}$ substitué, du groupe cycloalkényle $C_3$-$C_{10}$ substitué, du groupe hétérocycloalkényle $C_1$-$C_{10}$ substitué, du groupe aryle $C_6$-$C_{60}$ substitué, du groupe aryloxy $C_6$-$C_{60}$ substitué, du groupe arylthio $C_6$-$C_{60}$ substitué, du groupe arylalkyle $C_7$-$C_{60}$ substitué, du groupe hétéroaryle $C_1$-$C_{60}$ substitué, du groupe hétéroaryloxy $C_1$-$C_{60}$ substitué, du groupe hétéroarylthio $C_1$-$C_{60}$ substitué, du groupe hétéroarylalkyle $C_2$-$C_{60}$ substitué, du groupe polycyclique condensé non aromatique monovalent substitué, et du groupe hétéropolycyclique condensé non aromatique monovalent substitué sont sélectionnés entre :

deutérium, -F, -Cl, -Br, -I, $-CD_3$, $-CD_2H$, $-CDH_2$, $-CF_3$, $-CF_2H$, -CFH2, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$ ;

un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, chacun substitué avec au moins un élément sélectionné entre deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, et $-P(=O)(Q_{18})(Q_{19})$ ;

un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent ;

un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent, chacun substitué avec au moins un élément sélectionné entre deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle Ci-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-B(Q_{26})(Q_{27})$, et $-P(=O)(Q_{28})(Q_{29})$ ; et

$-N(Q_{31})(Q_{32})$, $-Si(Q_{33})(Q_{34})(Q_{35})$, $-B(Q_{36})(Q_{37})$, et $-P(=O)(Q_{38})(Q_{39})$,

où $Q_1$ à $Q_9$, $Q_{11}$ à $Q_{19}$, $Q_{21}$ à $Q_{29}$, et $Q_{31}$ à $Q_{39}$ sont chacun indépendamment sélectionnés entre : hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryle $C_6$-$C_{60}$ substitué avec au moins un élément sélectionné entre un groupe alkyle $C_1$-$C_{60}$ et un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent.

**2.** Composé organométallique selon la revendication 1, dans lequel
$M_1$ est Ir ou Os, et la somme de n1 et n2 est 3 ou 4 ; ou
$M_1$ est Pt, et la somme de n1 et n2 est 2.

**3.** Composé organométallique selon la revendication 1 ou 2, dans lequel
$CY_1$ et $CY_2$ sont chacun indépendamment sélectionnés entre un groupe cyclopentène, un groupe cyclohexène, un groupe benzène, un groupe pyridine, un groupe pyrimidine, un groupe pyridazine, un groupe pyrazine, un groupe triazine, un groupe pyrrole, un groupe pyrazole, un groupe imidazole, un groupe triazole, un groupe oxazole, un groupe isoxazole, un groupe oxadiazole, un groupe thiazole, un groupe isothiazole, et un groupe thiadiazole, et/ou dans lequel
$R_1$, $R_2$, et $R_{11}$ à $R_{16}$ sont chacun indépendamment sélectionnés entre :

hydrogène, deutérium, -F, un groupe cyano, un groupe nitro, $-SF_5$, un groupe méthyle, un groupe éthyle, un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, un groupe pyrimidinyle, un groupe dibenzofuranyle, et un groupe dibenzothiophényle ;

un groupe méthyle, un groupe éthyle, un groupe n-propyle, un groupe isopropyle, un groupe n-butyle, un groupe

isobutyle, un groupe sec-butyle, un groupe tert-butyle, un groupe n-pentyle, un groupe isopentyle, un groupe sec-pentyle, un groupe tert-pentyle, un groupe n-hexyle, un groupe isohexyle, un groupe sec-hexyle, un groupe tert-hexyle, un groupe n-heptyle, un groupe isoheptyle, un groupe sec-heptyle, un groupe tert-heptyle, un groupe n-octyle, un groupe isooctyle, un groupe sec-octyle, un groupe tert-octyle, un groupe n-nonyle, un groupe isononyle, un groupe sec-nonyle, un groupe tert-nonyle, un groupe n-décyle, un groupe isodécyle, un groupe sec-décyle, un groupe tert-décyle, un groupe méthoxy, un groupe éthoxy, un groupe propoxy, un groupe butoxy, un groupe pentoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, un groupe pyrimidinyle, un groupe dibenzofuranyle, et un groupe dibenzothiophényle, chacun substitué avec au moins un élément sélectionné entre deutérium, -F, $-CD_3$, $-CD_2H$, $-CDH_2$, $-CF_3$, $-CF_2H$, $-CFH_2$, un groupe cyano, un groupe nitro, un groupe alkyle $C_1$-$C_{10}$, un groupe alkoxy $C_1$-$C_{10}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe pyridinyle, un groupe pyrimidinyle, un groupe dibenzofuranyle, et un groupe dibenzothiophényle ; et
$-N(Q_1)(Q_2)$, $-Si(Q_3)(Q_4)(Q_5)$, $-B(Q_6)(Q_7)$, et $-P(=O)(Q_8)(Q_9)$,
où $Q_1$ à $Q_9$ sont chacun indépendamment sélectionnés entre :

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, et $-CD_2CDH_2$ ;

un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphthyle ; et
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphthyle, chacun substitué avec au moins un élément sélectionné entre deutérium, un groupe alkyle $C_1$-$C_{10}$, et un groupe phényle.

**4.** Composé organométallique selon l'une quelconque des revendications 1 à 3, dans lequel
$R_1$, $R_2$, $R_{11}$ to $R_{16}$, $R_{19}$ et $R_{20}$ sont chacun indépendamment sélectionnés entre :

hydrogène, deutérium, -CH3, $-CD_3$, $-CD_2H$, $-CDH_2$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, un groupe phényle, et des groupes représentés par les Formules 9-1 à 9-24; et
un groupe phényle substitué avec au moins un élément sélectionné entre deutérium, $-CD_3$, $-CD_2H$, $-CDH_2$, et un groupe alkyle $C_1$-$C_{10}$ :

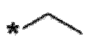
Formule 9-1

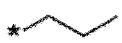
Formule 9-2

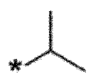
Formule 9-3

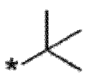
Formule 9-4

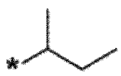
Formule 9-5

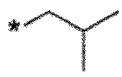
Formule 9-6

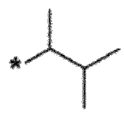
Formule 9-7

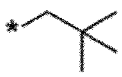
Formule 9-8

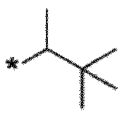
Formule 9-9

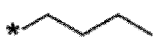
Formule 9-10

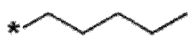
Formule 9-11

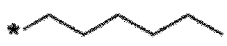
Formule 9-12

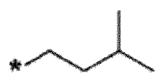
Formule 9-13

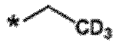
Formule 9-14

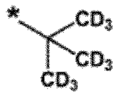
Formule 9-15

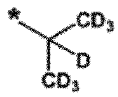
Formule 9-16

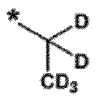
Formule 9-17

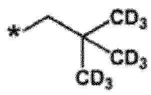
Formule 9-18

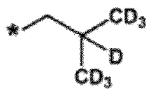
Formule 9-19

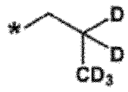
Formule 9-20

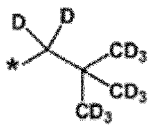
Formule 9-21

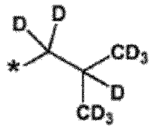
Formule 9-22

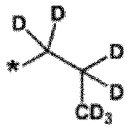
Formule 9-23

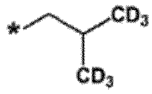
Formule 9-24,

où * dans les Formules 9-1 à 9-24 indique un site de liaison à un atome voisin.

**5.** Composé organométallique selon l'une quelconque des revendications 1 à 4, dans lequel au moins un de $R_1$, $R_2$, $R_{11}$ à $R_{16}$, $R_{19}$, et $R_{20}$ est un substituant contenant du deutérium, et le substituant contenant du deutérium est sélectionné entre :

deutérium ; et
un groupe alkyle $C_1$-$C_{20}$ et un groupe phényle, chacun substitué avec au moins un deutérium, de préférence dans lequel
le substituant contenant le deutérium est sélectionné entre :

deutérium ; et
un groupe méthyle, un groupe éthyle, un groupe n-propyle, un groupe isopropyle, un groupe n-butyle, un groupe sec-butyle, un groupe isobutyle, un groupe tert-butyle, un groupe n-pentyle, un groupe isopentyle, un groupe 1-méthylbutyle, un groupe 2-méthylbutyle, un groupe néo-pentyle, un groupe 1,2-diméthylpropyle, un groupe tert-pentyle, et un groupe phényle, chacun substitué avec au moins un deutérium.

**6.** Composé organométallique selon l'une quelconque des revendications 1 à 5, dans lequel au moins l'un de $R_{12}$, $R_{14}$, $R_{19}$, et $R_{20}$ est sélectionné entre :

deutérium ; et
un groupe méthyle, un groupe éthyle, un groupe n-propyle, un groupe isopropyle, un groupe n-butyle, un groupe sec-butyle, un groupe isobutyle, un groupe tert-butyle, un groupe n-pentyle, un groupe isopentyle, un groupe 1-méthylbutyle, un groupe 2-méthylbutyle, un groupe néo-pentyle, un groupe 1,2-diméthylpropyle, un groupe tert-pentyle, et un groupe phényle, chacun substitué avec au moins un deutérium, et/ou dans lequel
$R_{12}$ et $R_{14}$ sont chacun indépendamment sélectionnés entre :

hydrogène, deutérium, $-CH_3$, $-CD_3$, $-CD_2H$, $-CDH_2$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, un groupe phényle, et des groupes représentés par les Formules 9-1 à 9-24 ; et
un groupe phényle substitué avec au moins un élément sélectionné entre deutérium, $-CD_3$, $-CD_2H$, $-CDH_2$, et un groupe alkyle $C_1$-$C_{10}$, et
$R_{19}$ et $R_{20}$ sont chacun indépendamment hydrogène ou deutérium,

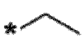
Formule 9-1

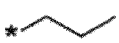
Formule 9-2

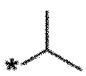
Formule 9-3

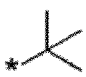
Formule 9-4

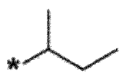
Formule 9-5

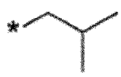
Formule 9-6

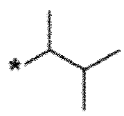
Formule 9-7

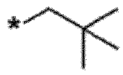

Formule 9-8

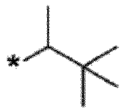

Formule 9-9

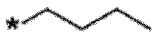

Formule 9-10

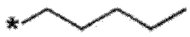

Formule 9-11

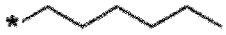

Formule 9-12

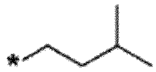

Formule 9-13

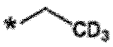

Formule 9-14

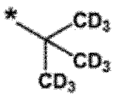

Formule 9-15

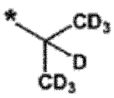

Formule 9-16

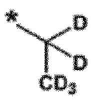

Formule 9-17

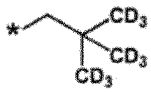

Formule 9-18

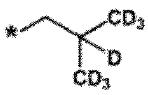

Formule 9-19

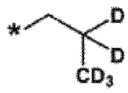

Formule 9-20

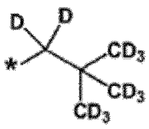

Formule 9-21

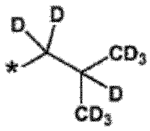

Formule 9-22

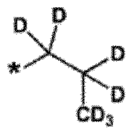

Formule 9-23

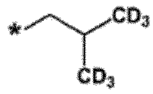

Formule 9-24,

où * dans les Formules 9-1 à 9-24 indique un site de liaison à un atome voisin.

**7.** Composé organométallique selon l'une quelconque des revendications 1 à 6, où le composé organométallique est représenté par la Formule 1-1 :

Formule 1-1

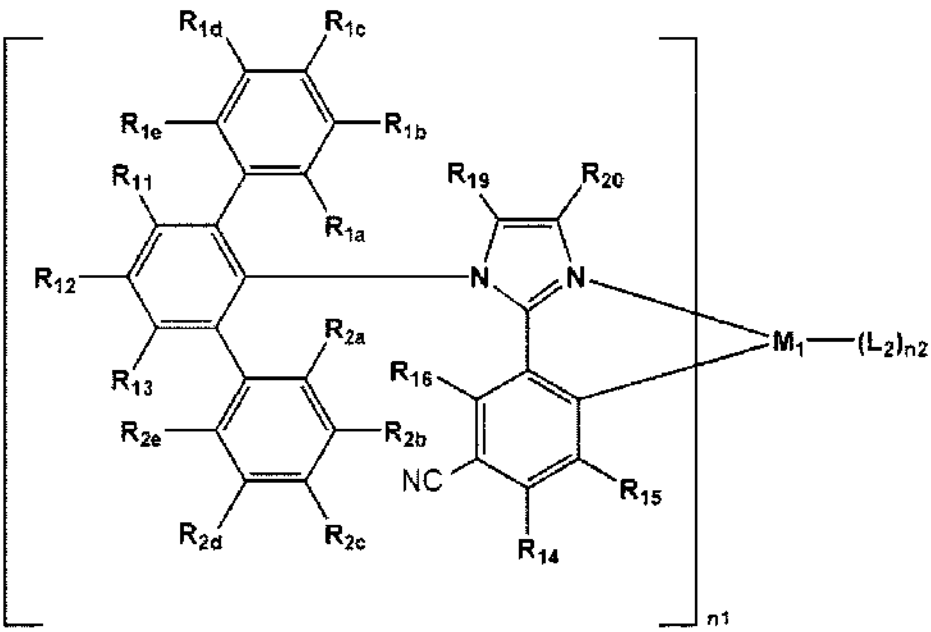

,

où, dans la Formule 1-1, $M_1$, n1, $L_2$, n2, $R_{11}$ à $R_{16}$, $R_{19}$, et $R_{20}$ sont identiques à la description de la revendication 1, $R_{1a}$ à $R_{1e}$ sont identiques à la description en rapport avec $R_1$ dans la revendication 1, et $R_{2a}$ à $R_{2e}$ sont identiques à la description en rapport avec $R_2$ dans la revendication 1, de préférence où
le composé organométallique est représenté par la Formule 1(1) :

Formule 1(1)

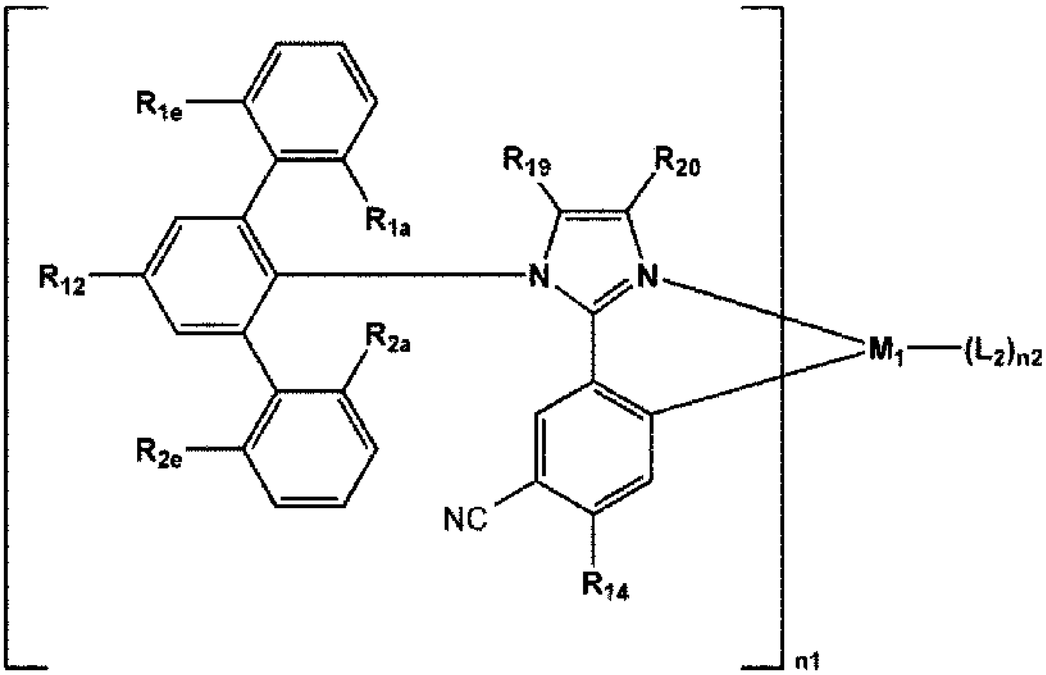

,

où, dans la Formule 1(1), $M_1$, n1, $L_2$, n2, $R_{12}$, $R_{14}$, $R_{19}$, et $R_{20}$ sont identiques à la description de la revendication 1, $R_{1a}$ et $R_{1e}$ sont identiques à la description en rapport avec R1 dans la revendication 1, et $R_{2a}$ et $R_{2e}$ sont identiques à la description en rapport avec $R_2$ dans la revendication 1.

**8.** Composé organométallique selon la revendication 1, où le composé organométallique est l'un des composés 1 à 9 :

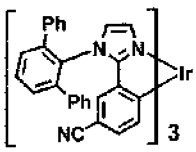

1

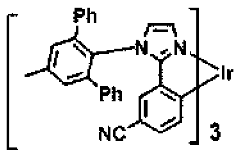

2

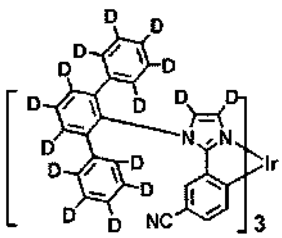

3

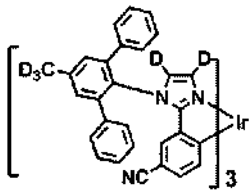

4

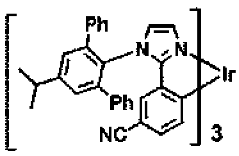

5

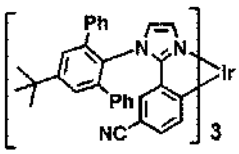

6

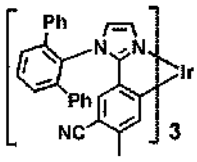

7

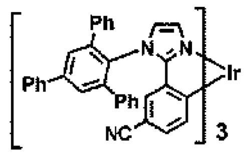

8

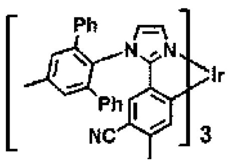

9

où « Ph » dans les composés 1 à 9 indique un groupe phényle.

**9.** Composé organométallique selon l'une quelconque des revendications 1 à 8, où le composé organométallique a une valeur de charge par analyse de population naturelle (NPA) de 0,48 ou moins, et la valeur de charge NPA est évaluée par une méthode employant la théorie de la fonctionnelle de la densité (DFT) utilisant un programme gaussien qui est optimisé par sa structure à un niveau de B3LYP/6-31G(d,p), et/ou où une valeur de fraction ouverte de l'atome A lié à $R_{19}$ de la Formule 1 est 0,5 ou moins, et la valeur de fraction ouverte est calculée au moyen de l'Equation 1 :

Equation 1

$$\text{valeurs de fraction ouverte} = \text{Area}_{\text{screened}} / \text{Area}_{\text{free}},$$

où, dans l'Equation 1,

$\text{Area}_{\text{free}}$ représente une surface d'une figure bidimensionnelle obtenue par projection de l'atome A sur un plan A et est calculée par $\pi$ x (rayon van der Waals de l'atome A)$^2$,
Areascreened représente une valeur moyenne d'une surface d'une figure bidimensionnelle obtenue par projection de l'atome A masqué par un autre atome B de Formule 1 sur un plan B,
supposant que l'atome A et l'atome B ont chacun une forme sphérique,
le plan B est les plans dans lesquels des vecteurs partant de 492 points d'une surface sphérique d'une tessellation de sphère vers une origine de la tessellation de sphère sont des vecteurs normaux, et
$\text{Area}_{\text{screened}}$ est calculée par une méthode employant la théorie de la fonctionnelle de la densité (DFT) utilisant un programme gaussien qui est optimisé par sa structure à un niveau de B3LYP/6-31G(d,p).

**10.** Composition contenant un composé organométallique, la composition comprenant :

un premier composé organométallique représenté par la Formule 1 ; et
un deuxième composé organométallique représenté par la Formule 2 :

Formule 1

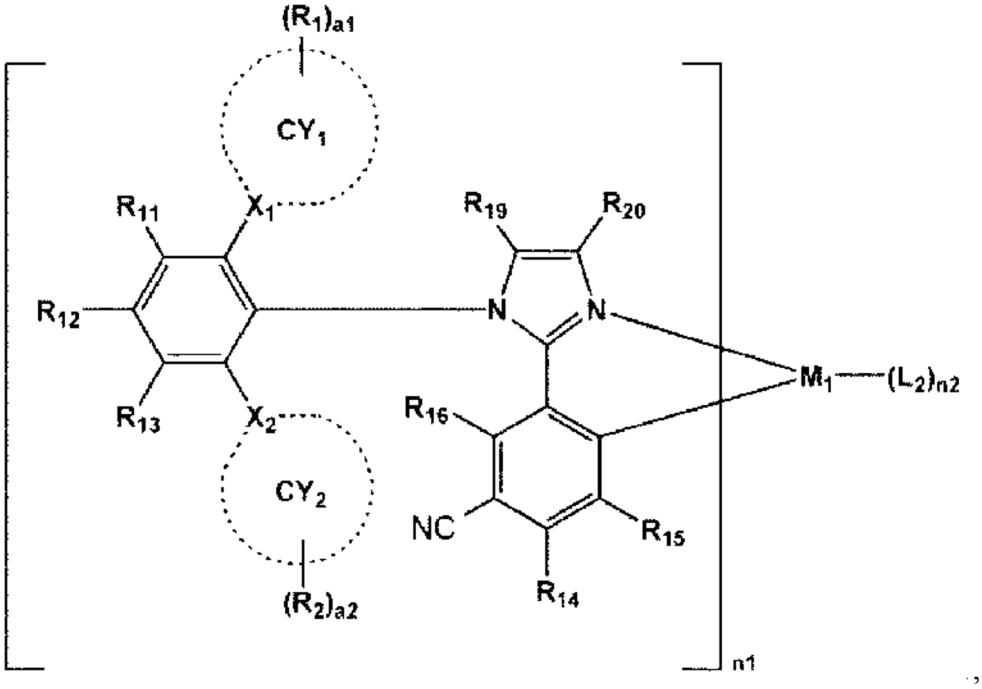

Formule 2

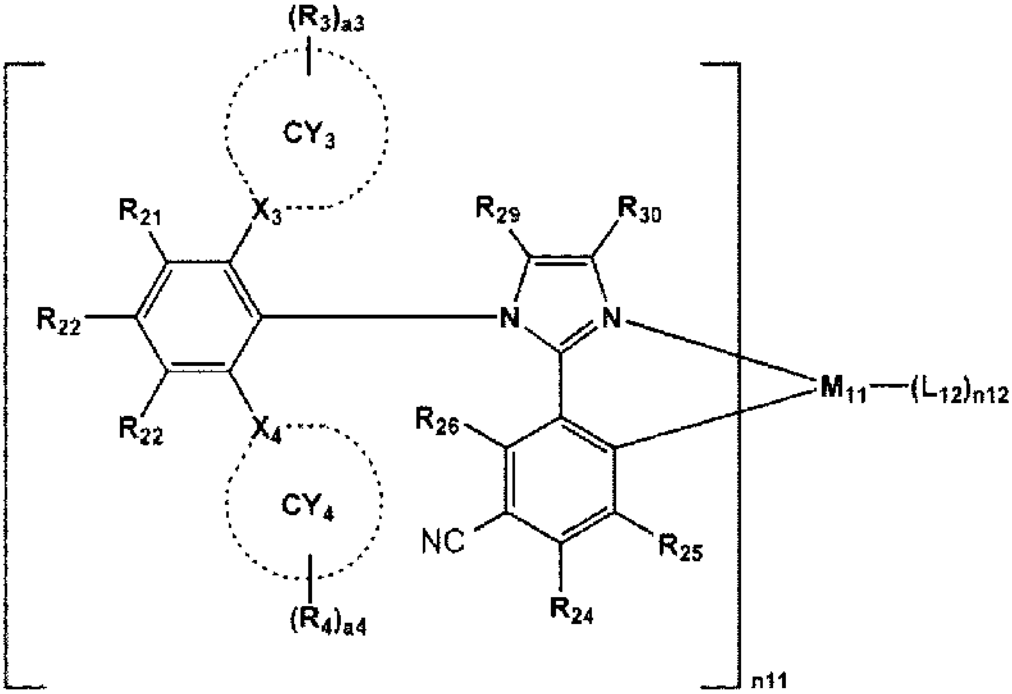

,

où, dans les Formules 1 et 2,

$M_1$ et $M_{11}$ sont chacun indépendamment sélectionnés entre un métal de transition de la première ligne de la table périodique des éléments, un métal de transition de la deuxième ligne de la table périodique des éléments, et un métal de transition de la troisième ligne de la table périodique des éléments,

n1 et n11 sont chacun indépendamment 1, 2 ou 3,

$L_2$ et $L_{12}$ sont chacun indépendamment sélectionnés parmi des ligands représentés par les Formules 3A à 3C, $3^E$ et 3F :

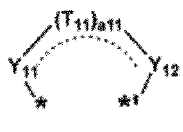

Formule 3A

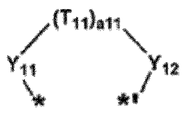

Formule 3B

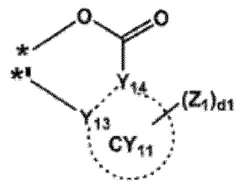

Formule 3C

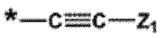

Formule $3^E$

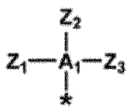

Formule 3F

,

n2 et n12 sont chacun indépendamment 0, 1, 2, 3 ou 4, où, lorsque n2 est deux ou plus, deux groupes $L_2$ ou plus sont identiques ou différents l'un de l'autre, et lorsque n12 est deux ou plus, deux groupes $L_{12}$ ou plus sont identiques ou différents l'un de l'autre,

$X_1$ à $X_4$ sont chacun indépendamment carbone ou azote,

$CY_1$ à $CY_4$ sont chacun indépendamment sélectionnés entre un groupe carbocyclique $C_5$-$C_{30}$ et un groupe hétérocyclique $C_2$-$C_{30}$,

$Y_{11}$ est sélectionné entre O, N, $N(Z_1)$, $P(Z_1)(Z_2)$, et $As(Z_1)(Z_2)$,
$Y_{12}$ est sélectionné entre O, N, $N(Z_3)$, $P(Z_3)(Z_4)$, et $As(Z_3)(Z_4)$,
$CY_{11}$ est un groupe hétérocyclique $C_2$-$C_{30}$,
Tu est chacun indépendamment sélectionné entre une liaison simple, une liaison double, *-$C(Z_{11})(Z_{12})$-*', *-$C(Z_{11})=C(Z_{12})$-*', *=$C(Z_{11})$-*', *-$C(Z_{11})$=*', *=$C(Z_{11})$-$C(Z_{12})=C(Z_{13})$-*', *-$C(Z_{11})=C(Z_{12})$-$C(Z_{13})$=*', *-$N(Z_{11})$-*', et un groupe carbocyclique $C_5$-$C_{30}$ substitué ou non substitué,
a11 est un nombre entier de 1 à 10,
$Y_{13}$ et $Y_{14}$ sont chacun indépendamment carbone (C) ou azote (N), $Y_{13}$ et $Y_{14}$ sont reliés par une liaison simple ou une liaison double,
$A_1$ est P ou As,
$R_1$, $R_2$, $R_{11}$ à $R_{16}$, $Z_1$ à $Z_4$ et $Z_{11}$ à $Z_{13}$ sont chacun indépendamment sélectionnés entre : hydrogène, deutérium, -F, -Cl, -Br, -I, -$SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe arylalkyle $C_7$-$C_{60}$ substitué ou non substitué, un groupe hétéroaryle $C_1$-$C_{60}$ substitué ou non substitué, un groupe hétéroaryloxy $C_1$-$C_{60}$ substitué ou non substitué, un groupe hétéroarylthio $C_1$-$C_{60}$ substitué ou non substitué, un groupe hétéroarylalkyle $C_2$-$C_{60}$ substitué ou non substitué, un groupe polycyclique condensé non aromatique monovalent substitué ou non substitué, un groupe hétéropolycyclique condensé non aromatique monovalent substitué ou non substitué, -$N(Q_1)(Q_2)$, -$Si(Q_3)(Q_4)(Q_5)$, -$B(Q_6)(Q_7)$, et -$P(=O)(Q_8)(Q_9)$,
deux groupes voisins ou plus de $R_1$, $R_2$, $R_{11}$ à $R_{13}$, $CY_1$, et $CY_2$ sont optionnellement reliés pour former un groupe carbocyclique $C_5$-$C_{30}$ substitué ou non substitué ou un groupe hétérocyclique $C_2$-$C_{30}$ substitué ou non substitué,
a1 et a2 sont chacun indépendamment un nombre entier de 0 à 5,
d1 est un nombre entier de 0 à 10,
$R_{19}$ et $R_{20}$ sont chacun indépendamment sélectionnés entre : hydrogène, deutérium, un groupe alkyle $C_1$-$C_{30}$, un groupe alkyle $C_1$-$C_{30}$ substitué avec au moins un deutérium, un groupe aryle $C_6$-$C_{60}$, et un groupe aryle $C_6$-$C_{60}$ substitué avec au moins un élément sélectionné entre un groupe alkyle $C_1$-$C_{30}$ et deutérium,
au moins l'un de $R_1$, $R_2$, $R_{11}$ à $R_{16}$, $R_{19}$, et $R_{20}$ est un substituant contenant du deutérium, $R_3$, $R_4$, et $R_{21}$ à $R_{26}$ sont chacun indépendamment sélectionnés entre : hydrogène, -F, -Cl, -Br, -I, -$SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$ substitué ou non substitué, un groupe alkényle $C_2$-$C_{60}$ substitué ou non substitué, un groupe alkynyle $C_2$-$C_{60}$ substitué ou non substitué, un groupe alkoxy $C_1$-$C_{60}$ substitué ou non substitué, un groupe cycloalkyle $C_3$-$C_{10}$ substitué ou non substitué, un groupe hétérocycloalkyle $C_1$-$C_{10}$ substitué ou non substitué, un groupe cycloalkényle $C_3$-$C_{10}$ substitué ou non substitué, un groupe hétérocycloalkényle $C_1$-$C_{10}$ substitué ou non substitué, un groupe aryle $C_6$-$C_{60}$ substitué ou non substitué, un groupe aryloxy $C_6$-$C_{60}$ substitué ou non substitué, un groupe arylthio $C_6$-$C_{60}$ substitué ou non substitué, un groupe arylalkyle $C_7$-$C_{60}$ substitué ou non substitué, un groupe hétéroaryle $C_1$-$C_{60}$ substitué ou non substitué, un groupe hétéroaryloxy $C_1$-$C_{60}$ substitué ou non substitué, un groupe hétéroarylthio $C_1$-$C_{60}$ substitué ou non substitué, un groupe hétéroarylalkyle $C_2$-$C_{60}$ substitué ou non substitué, un groupe polycyclique condensé non aromatique monovalent substitué ou non substitué, un groupe hétéropolycyclique condensé non aromatique monovalent substitué ou non substitué, -$N(Q_1)(Q_2)$, -$Si(Q_3)(Q_4)(Q_5)$, -$B(Q_6)(Q_7)$, et -$P(=O)(Q_8)(Q_9)$,
deux groupes voisins ou plus de $R_3$, $R_4$, $R_{21}$ à $R_{23}$, $CY_3$, et $CY_4$ sont optionnellement reliés pour former un groupe carbocyclique $C_5$-$C_{30}$ substitué ou non substitué ou un groupe hétérocyclique $C_2$-$C_{30}$ substitué ou non substitué,
a3 et a4 sont chacun indépendamment un nombre entier de 0 à 5,
$R_{29}$ et $R_{30}$ sont chacun indépendamment sélectionnés entre : hydrogène, un groupe alkyle $C_1$-$C_{30}$, un groupe aryle $C_6$-$C_{60}$, et un groupe aryle $C_6$-$C_{60}$ substitué avec au moins un groupe alkyle $C_1$-$C_{30}$, et
$R_3$, $R_4$, $R_{21}$ à $R_{26}$, $R_{29}$, et $R_{30}$ sont chacun un substituant sans deutérium ;
où les substituants du groupe alkyle $C_1$-$C_{60}$ substitué, du groupe alkényle $C_2$-$C_{60}$ substitué, du groupe alkynyle $C_2$-$C_{60}$ substitué, du groupe alkoxy $C_1$-$C_{60}$ substitué, du groupe cycloalkyle $C_3$-$C_{10}$ substitué, du groupe hétérocycloalkyle $C_1$-$C_{10}$ substitué, du groupe cycloalkényle $C_3$-$C_{10}$ substitué, du groupe hétérocycloalkényle $C_1$-$C_{10}$

substitué, du groupe aryle $C_6$-$C_{60}$ substitué, du groupe aryloxy $C_6$-$C_{60}$ substitué, du groupe arylthio $C_6$-$C_{60}$ substitué, du groupe arylalkyle $C_7$-$C_{60}$ substitué, du groupe hétéroaryle $C_1$-$C_{60}$ substitué, du groupe hétéroaryloxy $C_1$-$C_{60}$ substitué, du groupe hétéroarylthio $C_1$-$C_{60}$ substitué, du groupe hétéroarylalkyle $C_2$-$C_{60}$ substitué, du groupe polycyclique condensé non aromatique monovalent substitué, du groupe hétéropolycyclique condensé non aromatique monovalent substitué, du groupe carbocyclique $C_5$-$C_{30}$ substitué, et du groupe hétérocyclique $C_2$-$C_{30}$ substitué sont sélectionnés entre :

deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$ ;
un groupe alkyle $C_1$-$C_{60}$, un groupe alkényle $C_2$-$C_{60}$, un groupe alkynyle $C_2$-$C_{60}$, et un groupe alkoxy $C_1$-$C_{60}$, chacun substitué avec au moins un élément sélectionné entre : deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, et $-P(=O)(Q_{18})(Q_{19})$ ;
un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent ;
un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent, chacun substitué avec au moins un élément sélectionné entre : deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle Ci-$C_{10}$, un groupe cycloalkényle $C_3$-$C_{10}$, un groupe hétérocycloalkényle $C_1$-$C_{10}$, un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-B(Q_{26})(Q_{27})$, et $-P(=O)(Q_{28})(Q_{29})$ ; et
$-N(Q_{31})(Q_{32})$, $-Si(Q_{33})(Q_{34})(Q_{35})$, $-B(Q_{36})(Q_{37})$, et $-P(=O)(Q_{38})(Q_{39})$,
où $Q_1$ à $Q_9$, $Q_{11}$ à $Q_{19}$, $Q_{21}$ à $Q_{29}$, et $Q_{31}$ à $Q_{39}$ sont chacun indépendamment sélectionnés entre : hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle $C_1$-$C_{60}$, un groupe alkényle $C_2$-$C_{60}$, un groupe alkynyle $C_2$-$C_{60}$, un groupe alkoxy $C_1$-$C_{60}$, un groupe cycloalkyle $C_3$-$C_{10}$, un groupe hétérocycloalkyle $C_1$-$C_{10}$, un groupe cycloalkényle $C_3$-$C_{10}$, un groupe hétérocycloalkényle $C_1$-$C_{10}$, un groupe aryle $C_6$-$C_{60}$, un groupe aryle $C_6$-$C_{60}$ substitué avec au moins un élément sélectionné entre un groupe alkyle Ci- $C_{60}$ et un groupe aryle $C_6$-$C_{60}$, un groupe aryloxy $C_6$-$C_{60}$, un groupe arylthio $C_6$-$C_{60}$, un groupe arylalkyle $C_7$-$C_{60}$, un groupe hétéroaryle $C_1$-$C_{60}$, un groupe hétéroaryloxy $C_1$-$C_{60}$, un groupe hétéroarylthio $C_1$-$C_{60}$, un groupe hétéroarylalkyle $C_2$-$C_{60}$, un groupe polycyclique condensé non aromatique monovalent, et un groupe hétéropolycyclique condensé non aromatique monovalent.

**11.** Composition selon la revendication 10, dans laquelle un taux de deutération représenté par l'Equation 2 est de 50 % ou plus :

Equation 2

$$\text{taux de deutération (\%)} = n_{D2}/(n_{H2} + n_{D2}) \text{ X } 100,$$

où ; dans l'Equation 2,

$n_{H2}$ représente la somme d'un nombre total d'hydrogènes inclus dans les substituants contenant du deutérium dans le premier composé organométallique et d'un nombre total d'hydrogènes inclus dans un substituant sans deutérium du deuxième composé organométallique correspondant au substituant contenant du deutérium dans le premier composé organométallique, et
$n_{D2}$ représente un nombre total d'atomes de deutérium inclus dans les substituants contenant du deutérium dans le premier composé organométallique.

**12.** Composition selon la revendication 10 ou 11, où la composition comprend un mélange de Composé 3 et d'un Composé 3 incomplètement deutéré, ou un mélange de Composé 4 et d'un Composé 4 incomplètement deutéré :

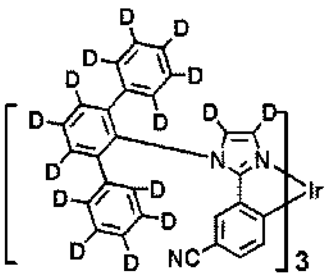

3

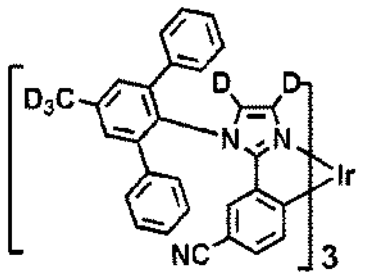

4

.

**13.** Dispositif photoémetteur organique comprenant :

une première électrode ;
une deuxième électrode ; et
une couche organique disposée entre la première électrode et la deuxième électrode,
dans lequel la couche organique comprend une couche d'émission, et
dans lequel la couche organique comprend au moins un composé organométallique selon l'une quelconque des revendications 1 à 9, ou la composition selon l'une quelconque des revendications 10 à 12.

**14.** Dispositif photoémetteur organique selon la revendication 13, dans lequel la couche d'émission comprend le composé organométallique ou la composition, de préférence dans lequel la couche d'émission comprend en outre un hôte.

FIG. 1

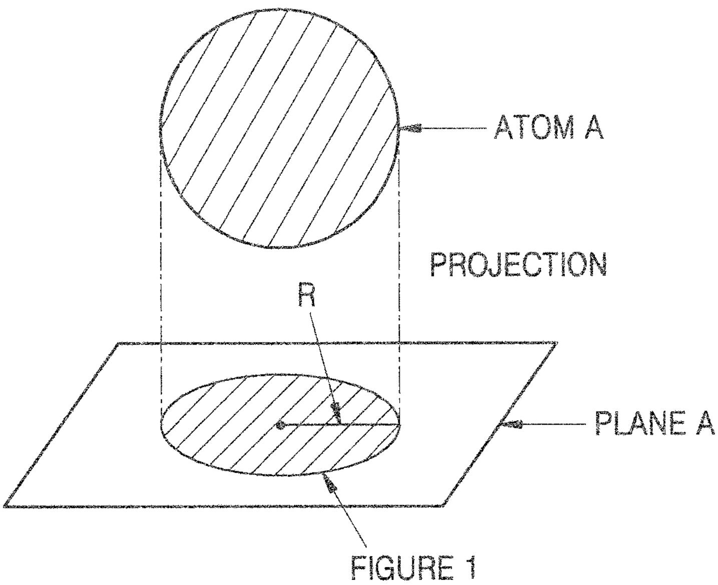
ATOM A
PROJECTION
R
PLANE A
FIGURE 1

FIG. 2

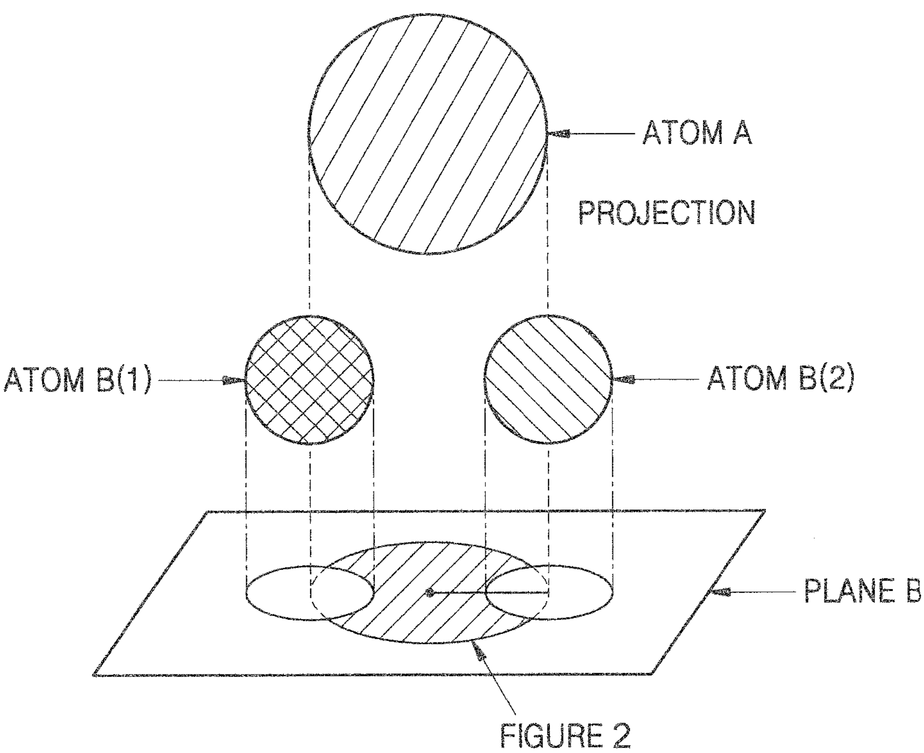
ATOM A
PROJECTION
ATOM B(1)
ATOM B(2)
PLANE B
FIGURE 2

FIG. 3

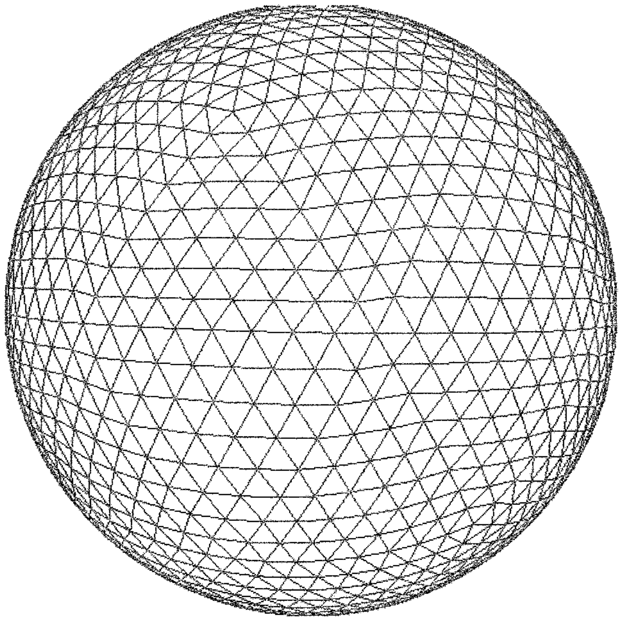

FIG. 4

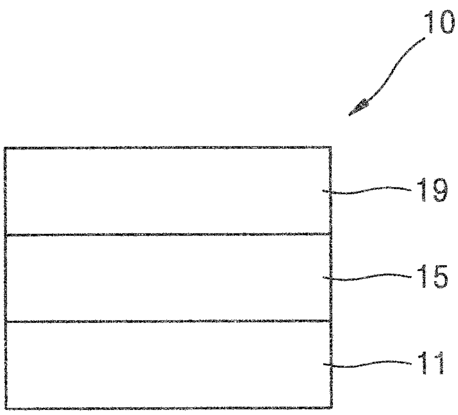

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014111549 A